# EUROPEAN PATENT APPLICATION

(11) **EP 3 618 131 A1**
(43) Date of publication of application: **04.03.2020**
(21) Application number: 18789968.7
(22) Date of filing: 20.04.2018
(51) Int. Cl.: H01L 51/50, C07D 307/91, C07D 333/76, C07D 403/10, C07D 409/14, C07F 15/00, C08G 61/12, C09K 11/06, H05B 33/12

(54) **LIGHT-EMITTING ELEMENT**

(30) Priority: 27.04.2017 JP 2017088010
(71) Applicant: Sumitomo Chemical Company Limited, Tokyo 104-8260 (JP)
(72) Inventor: USUI, Motoaki, Tsukuba-shi Ibaraki 300-3294 (JP); INAKAZU, Shinichi, Tsukuba-shi Ibaraki 300-3294 (JP)
(74) Representative: J A Kemp LLP
(86) International application number: PCT/JP2018/016309
(87) International publication number: WO 2018/198974

(57) **Abstract**

To provide a light emitting device excellent in luminance life.

A light emitting device having an anode and a cathode, and a first organic layer and a second organic layer disposed between the anode and the cathode, wherein
the first organic layer is a layer containing a compound represented by the formula (C-1), and
the second organic layer is
Layer A containing at least one of a polymer compound containing a constitutional unit having a group obtained by removing from a phosphorescent compound represented by the formula (1) (wherein, M is an iridium atom) one or more hydrogen atoms and a cross-linked body of the polymer compound, or
Layer B containing a phosphorescent compound represented by the formula (1) and a cross-linked body of a crosslinking material: 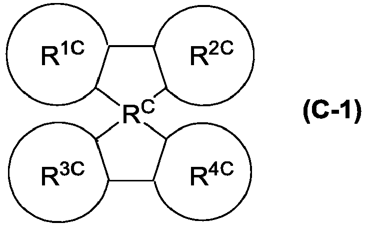 [wherein, Ring R^{1C} to Ring R^{4C} represent an aromatic hydrocarbon ring or the like. R^{C} represents a carbon atom or the like.] 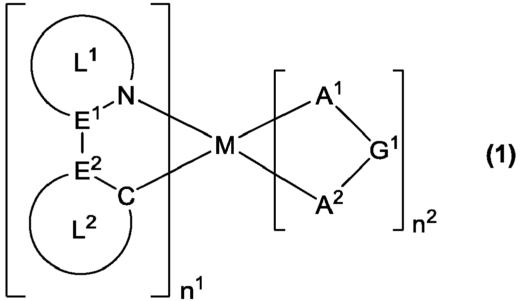 [wherein, M represents an iridium atom or the like. n¹ and n² represent an integer. E¹ and E² represent a carbon atom or the like. Ring L¹ represents an aromatic hetero ring. Ring L² represents an aromatic hydrocarbon ring or the like. A¹-G¹-A² represents an anionic bidentate ligand.].

## Description

### Technical Field

The present invention relates to a light emitting device.

### Background Art

Light emitting devices such as organic electroluminescent devices and the like can be suitably used for display and lighting applications. For example, Patent Document 1 describes a light emitting device having a first organic layer containing a compound (H0), a metal complex (B0) and a metal complex (G0) and a second organic layer containing a cross-linked body of a polymer compound containing a constitutional unit derived from a metal complex (RM0).

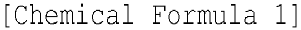

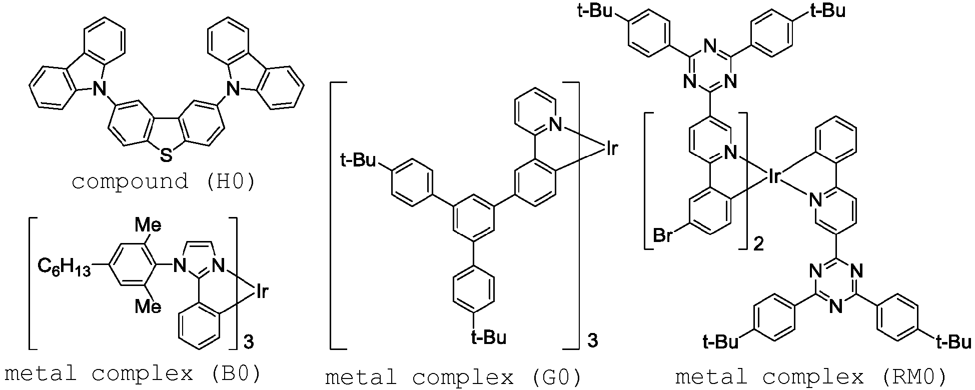

### Prior Art Document

### Patent Document

Patent Document 1: International Publication WO 2015/163174

### Summary of the Invention

### Problem to be Solved by the Invention

However, this light emitting device was not necessarily sufficient in luminance life. Then, the present invention has an object of providing a light emitting device excellent in luminance life.

### Means for Solving the Problem

The present invention provides the following [1] to [16] .
[1] A light emitting device having an anode, a cathode, a first organic layer disposed between the anode and the cathode and a second organic layer disposed between the anode and the cathode, wherein
   the first organic layer is a layer containing a compound represented by the formula (C-1), and
   the second organic layer is
   Layer A containing at least one of a polymer compound containing a constitutional unit having a group obtained by removing from a phosphorescent compound represented by the formula (1) (wherein, M is an iridium atom) one or more hydrogen atoms and a cross-linked body of the polymer compound, or
   Layer B containing a phosphorescent compound represented by the formula (1) and a cross-linked body of a crosslinking material: 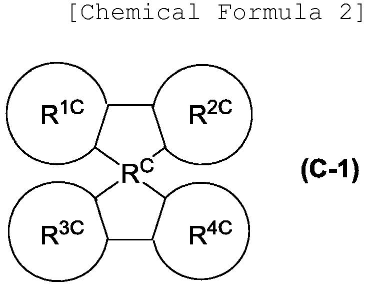 [wherein,
   Ring R^{1C}, Ring R^{2C}, Ring R^{3C} and Ring R^{4C} each independently represent an aromatic hydrocarbon ring or an aromatic hetero ring, and the foregoing rings optionally have a substituent. When a plurality of the substituents are present, they may be combined together to form a ring together with the atoms to which they are attached.
   R^{C} represents a carbon atom, a silicon atom, a germanium atom, a tin atom or a lead atom.] 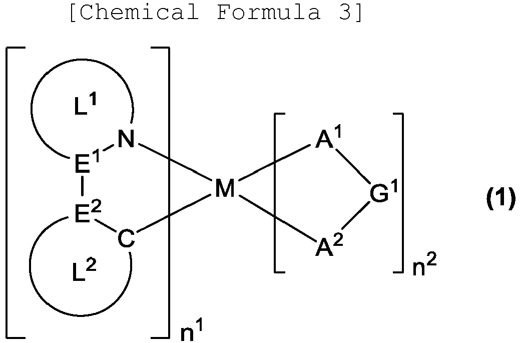
   [wherein,
   M represents a ruthenium atom, a rhodium atom, a palladium atom, an iridium atom or a platinum atom.
   n¹ represents an integer of 1 or more, and n² represents an integer of 0 or more. n¹+n² is 3 when M is a ruthenium atom, a rhodium atom or an iridium atom, while n¹+n² is 2 when M is a palladium atom or a platinum atom.
   E¹ and E² each independently represent a carbon atom or a nitrogen atom. At least one of E¹ and E² is a carbon atom. When a plurality of E¹ and E² are present, they may be the same or different at each occurrence.
   Ring L¹ represents an aromatic hetero ring, and the aromatic hetero ring optionally has a substituent. When a plurality of the substituents are present, they may be combined together to form a ring together with the atoms to which they are attached. When a plurality of Ring L¹ are present, they may be the same or different.
   Ring L² represents an aromatic hydrocarbon ring or an aromatic hetero ring, and the foregoing rings optionally have a substituent. When a plurality of the substituents are present, they may be combined together to form a ring together with the atoms to which they are attached. When a plurality of Ring L² are present, they may be the same or different.

   The substituent which Ring L¹ optionally has and the substituent which Ring L² optionally has may be combined together to form a ring together with the atoms to which they are attached.
   A¹-G¹-A² represents an anionic bidentate ligand. A¹ and A² each independently represent a carbon atom, an oxygen atom or a nitrogen atom, and these atoms may be a ring constituent atom. G¹ represents a single bond or an atomic group constituting a bidentate ligand together with A¹ and A². When a plurality of A¹-G¹-A² are present, they may be the same or different.].
[2] The light emitting device according to [1], wherein at least one of the above-described Ring R^{1C}, the above-described Ring R^{2C}, the above-described Ring R^{3C} and the above-described Ring R^{4C} has a group represented by the formula (D-1): 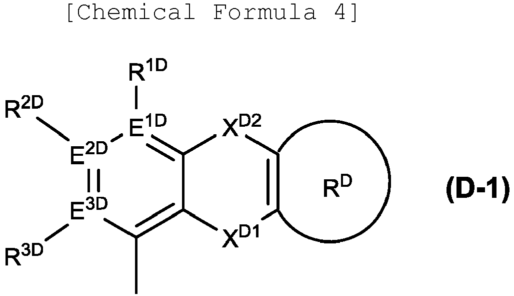 [wherein,
   Ring R^{D} represents an aromatic hydrocarbon ring or an aromatic hetero ring, and the foregoing rings optionally have a substituent. When a plurality of the substituents are present, they may be combined together to form a ring together with the atoms to which they are attached.
   X^{D1} and X^{D2} each independently represent a single bond, an oxygen atom, a sulfur atom, a group represented by -N(R^{XD1})- or a group represented by -C(R^{XD2})₂-. R^{XD1} and R^{XD2} each independently represent a hydrogen atom, an alkyl group, a cycloalkyl group, an alkoxy group, a cycloalkoxy group, an aryl group, an aryloxy group, a monovalent heterocyclic group, a substituted amino group or a halogen atom, and the foregoing groups optionally have a substituent. A plurality of R^{XD2} may be the same or different and may be combined together to form a ring together with the carbon atoms to which they are attached.
   E^{1D}, E^{2D} and E^{3D} each independently represent a nitrogen atom or a carbon atom.
   R^{1D}, R^{2D} and R^{3D} each independently represent a hydrogen atom, an alkyl group, a cycloalkyl group, an alkoxy group, a cycloalkoxy group, an aryl group, an aryloxy group, a monovalent heterocyclic group, a substituted amino group or a halogen atom, and the foregoing groups optionally have a substituent.
   When E^{1D} is a nitrogen atom, R^{1D} is absent. When E^{2D} is a nitrogen atom, R^{2D} is absent. When E^{3D} is a nitrogen atom, R^{3D} is absent.
   R^{1D} and R^{2D} may be combined together to form a ring together with the carbon atoms to which they are attached. R2D and R^{3D} may be combined together to form a ring together with the carbon atoms to which they are attached. R^{1D} and R^{XD1} may be combined together to form a ring together with the atoms to which they are attached. R^{1D} and R^{XD2} may be combined together to form a ring together with the carbon atoms to which they are attached. The substituent which Ring R^{D} optionally has and R^{XD1} may be combined together to form a ring together with the atoms to which they are attached. The substituent which Ring R^{D} optionally has and R^{XD2} may be combined together to form a ring together with the carbon atoms to which they are attached.].
[3] The light emitting device according to [1] or [2], wherein the above-described compound represented by the formula (C-1) is a compound represented by the formula (C-2) : 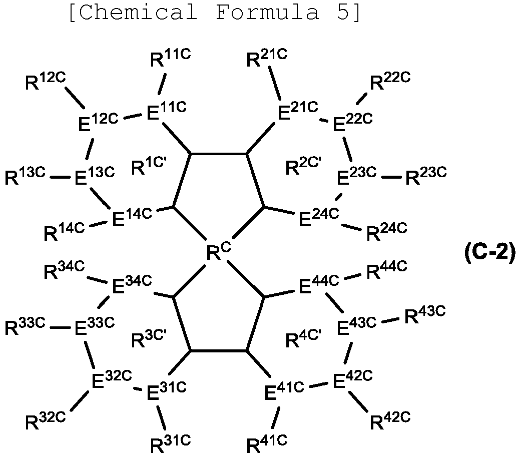 [wherein,
   R^{C} represents the same meaning as described above.
   E^{11C}, E^{12C}, E^{13C}, E^{14C}, E^{21C}, E^{22C}, E^{23C}, E^{24C}, E^{31C}, E^{32C}, E^{33C}, E^{34C}, E^{41C}, E^{42C}, E^{43C} and E^{44C} each independently represent a nitrogen atom or a carbon atom.
   Ring R^{1C'}, Ring R^{2C'}, Ring R^{3C'} and Ring R^{4C'} each independently represent a benzene ring, a pyridine ring or a diazabenzene ring.
   R^{11C}, R^{12C}, R^{13C}, R^{14C}, R^{21C}, R^{22C}, R^{23C}, R^{24C}, R^{31C}, R^{32C}, R^{33C}, R^{34C}, R^{41C}, R^{42C}, R^{43C} and R^{44C} each independently represent a hydrogen atom, an alkyl group, a cycloalkyl group, an alkoxy group, a cycloalkoxy group, an aryl group, an aryloxy group, an alkenyl group, a monovalent heterocyclic group, a substituted amino group or a halogen atom, and the foregoing groups optionally have a substituent.
   When E^{11C} is a nitrogen atom, R^{11C} is absent. When E^{12C} is a nitrogen atom, R^{12C} is absent. When E^{13C} is a nitrogen atom, R^{13C} is absent. When E^{14C} is a nitrogen atom, R^{14C} is absent. When E^{21C} is a nitrogen atom, R^{21C} is absent. When E^{22C} is a nitrogen atom, R^{22C} is absent. When E^{23C} is a nitrogen atom, R^{23C} is absent. When E^{24C} is a nitrogen atom, R^{24C} is absent. When E^{31C} is a nitrogen atom, R^{31C} is absent. When E^{32C} is a nitrogen atom, R^{32C} is absent. When E^{33C} is a nitrogen atom, R^{33C} is absent. When E^{34C} is a nitrogen atom, R^{34C} is absent. When E^{41C} is a nitrogen atom, R^{41C} is absent. When E^{42C} is a nitrogen atom, R^{42C} is absent. When E^{43C} is a nitrogen atom, R^{43C} is absent. When E^{44C} is a nitrogen atom, R^{44C} is absent.
   R^{11C} and R^{12C}, R^{12C} and R^{13C}, R^{13C} and R^{14C}, R^{14C} and R^{34C}, R^{34C} and R^{33C}, R^{33C} and R^{32C}, R^{32C} and R^{31C}, R^{31C}and R^{41C}, R^{41C} and R^{42C}, R^{42C} and R^{43C}, R^{43C} and R^{44C}, R^{44C} and R^{24C}, R^{24C} and R^{23C}, R^{23C} and R^{22C}, R^{22C} and R^{21C}, and R^{21C} and R^{11C} may each be combined together to form a ring together with the carbon atoms to which they are attached.].
[4] The light emitting device according to [3], wherein the above-described compound represented by the formula (C-2) is a compound represented by the formula (C-3) : 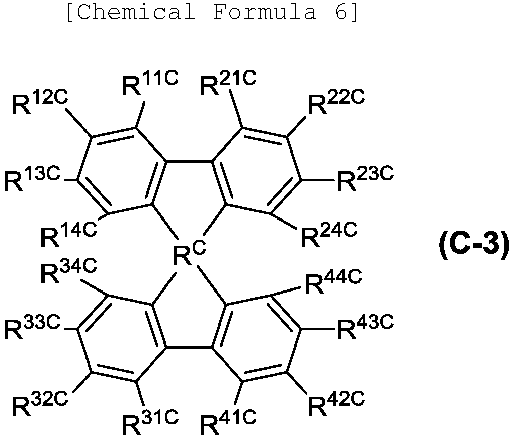 [wherein, R^{C}, R^{11C}, R^{12C}, R^{13C}, R^{14C}, R^{21C}, R^{22C}, R^{23C}, R^{24C}, R^{31C}, R^{32C}, R^{33C}, R^{34C}, R^{41C}, R^{42C}, R^{43C} and R^{44C} represent the same meaning as described above.].
[5] The light emitting device according to [3] or [4], wherein at least one of the above-described R^{11C}, the above-described R^{12C}, the above-described R^{14C}, the above-described R^{21C}, the above-described R^{22C}, the above-described R^{24C}, the above-described R^{31C}, the above-described R^{32C}, the above-described R^{34C}, the above-described R^{41C}, the above-described R^{42C} and the above-described R^{44C} is the above-described group represented by the formula (D-1).
[6] The light emitting device according to any one of [1] to [5], wherein the above-described second organic layer is the above-described Layer A, and the above-described polymer compound containing a constitutional unit having a group obtained by removing from a phosphorescent compound represented by the formula (1) (wherein, M is an iridium atom) one or more hydrogen atoms is a polymer compound containing a constitutional unit represented by the formula (1-1B), a constitutional unit represented by the formula (1-2B), a constitutional unit represented by the formula (1-3B) or a constitutional unit represented by the formula (1-4B): 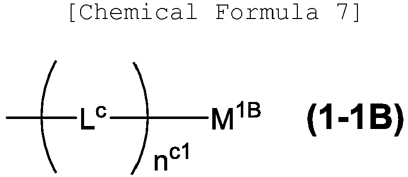 [wherein,
   M^{1B} represents a group obtained by removing from a phosphorescent compound represented by the formula (1) (wherein, M is an iridium atom) one hydrogen atom.
   L^{C} represents an oxygen atom, a sulfur atom, -N(R^{A})-, -C(R^{B})₂-, -C(R^{B}) = C(R^{B})-, -C≡C-, an arylene group or a divalent heterocyclic group, and the foregoing groups optionally have a substituent. R^{A} represents a hydrogen atom, an alkyl group, a cycloalkyl group, an aryl group or a monovalent heterocyclic group, and the foregoing groups optionally have a substituent. R^{B} represents a hydrogen atom, an alkyl group, a cycloalkyl group, an alkoxy group, a cycloalkoxy group, an aryl group or a monovalent heterocyclic group, and the foregoing groups optionally have a substituent. A plurality of R^{B} may be the same or different and may be combined together to form a ring together with the carbon atoms to which they are attached. When a plurality of L^{C} are present, they may be the same or different.
   n^{c1} represents an integer of 0 or more.] 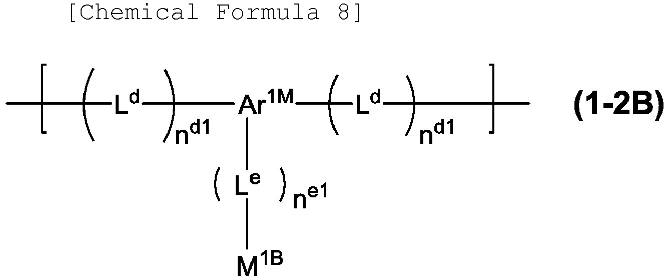
   [wherein,
   M^{1B} represents the same meaning as described above.
   L^{d} and L^{e} each independently represent an oxygen atom, a sulfur atom, -N(R^{A})-, -C(R^{B})₂-, -C(R^{B}) = C(R^{B})-, -C≡C-, an arylene group or a divalent heterocyclic group, and the foregoing groups optionally have a substituent. R^{A} and R^{B} represent the same meaning as described above. When a plurality of L^{d} and L^{e} are present, they may be the same or different at each occurrence.
   n^{d1} and n^{e1} each independently represent an integer of 0 or more. A plurality of n^{d1} may be the same or different.
   Ar^{1M} represents an aromatic hydrocarbon group or a heterocyclic group, and the foregoing groups optionally have a substituent.] 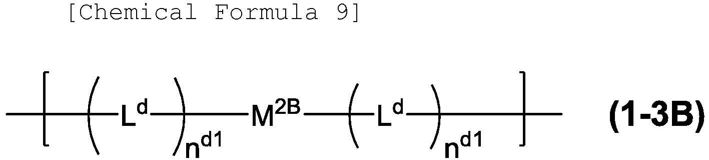
   [wherein,
   L^{d} and n^{d1} represent the same meaning as described above.
   M^{2B} represents a group obtained by removing from a phosphorescent compound represented by the formula (1) (wherein, M is an iridium atom) two hydrogen atoms.] 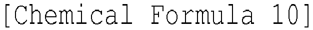 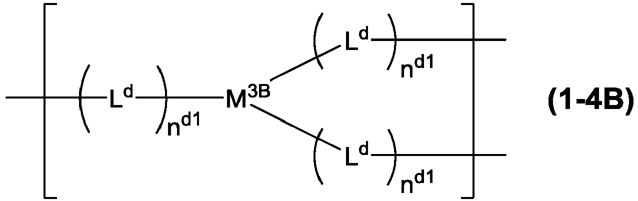
   [wherein,
   L^{d} and n^{d1} represent the same meaning as described above.
   M^{3B} represents a group obtained by removing from a phosphorescent compound represented by the formula (1) (wherein, M is an iridium atom) three hydrogen atoms.].
[7] The light emitting device according to any one of [1] to [6], wherein the above-described second organic layer is the above-described Layer A, and the above-described polymer compound containing a constitutional unit having a group obtained by removing from a phosphorescent compound represented by the formula (1) (wherein, M is an iridium atom) one or more hydrogen atoms further contains a constitutional unit having a crosslinking group.
[8] The light emitting device according to any one of [1] to [5], wherein the above-described second organic layer is the above-described Layer B, and the above-described crosslinking material is a polymer compound containing a constitutional unit having a crosslinking group.
[9] The light emitting device according to [7] or [8], wherein the above-described crosslinking group is a crosslinking group selected from Group A of crosslinking group:
   (Group A of crosslinking group) 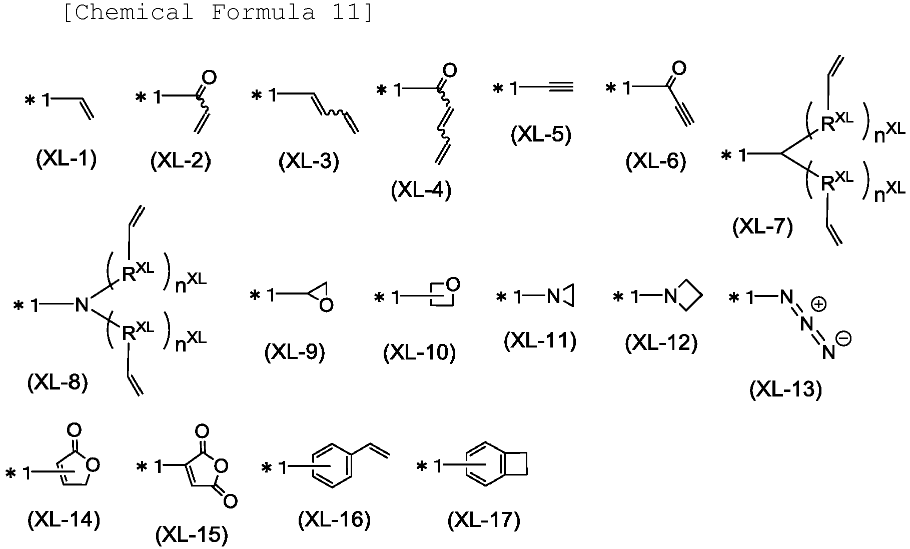 [wherein, R^{XL} represents a methylene group, an oxygen atom or a sulfur atom. n^{XL} represents an integer of 0 to 5. When a plurality of R^{XL} are present, they may be the same or different. A plurality of n^{XL} may be the same or different. *1 represents a binding position. The foregoing crosslinking groups optionally have a substituent.].
[10] The light emitting device according to [9], wherein the above-described constitutional unit having a crosslinking group is a constitutional unit represented by the formula (2) or a constitutional unit represented by the formula (2'): 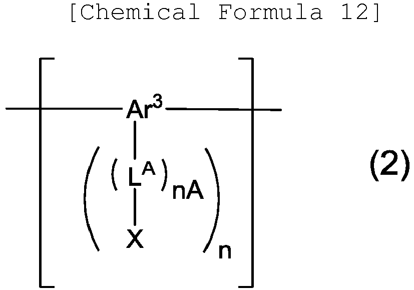 [wherein,
   nA represents an integer of 0 to 5, and n represents 1 or 2. When a plurality of nA are present, they may be the same or different.
   Ar³ represents an aromatic hydrocarbon group or a heterocyclic group, and the foregoing groups optionally have a substituent.
   L^{A} represents an alkylene group, a cycloalkylene group, an arylene group, a divalent heterocyclic group, a group represented by -NR'-, an oxygen atom or a sulfur atom, and the foregoing groups optionally have a substituent. R' represents a hydrogen atom, an alkyl group, a cycloalkyl group, an aryl group or a monovalent heterocyclic group, and the foregoing groups optionally have a substituent. When a plurality of L^{A} are present, they may be the same or different.
   X represents a crosslinking group selected from Group A of crosslinking group. When a plurality of X are present, they may be the same or different.] 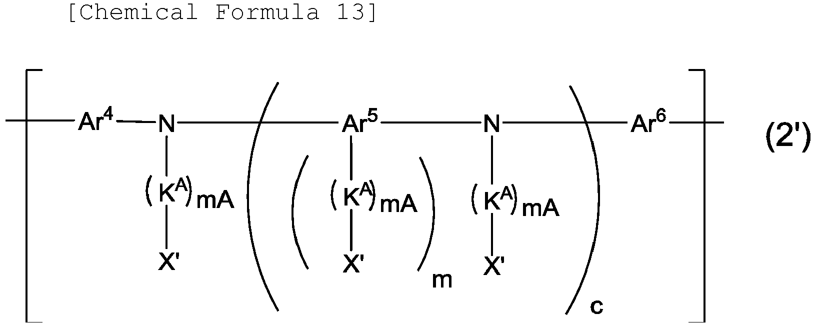
   [wherein,
   mA represents an integer of 0 to 5, m represents an integer of 1 to 4, and c represents 0 or 1. When a plurality of mA are present, they may be the same or different.
   Ar⁵ represents an aromatic hydrocarbon group, a heterocyclic group or a group in which at least one aromatic hydrocarbon group and at least one heterocyclic group are bonded directly, and the foregoing groups optionally have a substituent.
   Ar⁴ and Ar⁶ each independently represent an arylene group or a divalent heterocyclic group, and the foregoing groups optionally have a substituent.
   Ar⁴, Ar⁵ and Ar⁶ may each be bonded directly or via an oxygen atom or a sulfur atom to a group other than the group bonding to the nitrogen atom to which the group is attached, to form a ring.
   K^{A} represents an alkylene group, a cycloalkylene group, an arylene group, a divalent heterocyclic group, a group represented by -NR'-, an oxygen atom or a sulfur atom, and the foregoing groups optionally have a substituent. R' represents a hydrogen atom, an alkyl group, a cycloalkyl group, an aryl group or a monovalent heterocyclic group, and the foregoing groups optionally have a substituent. When a plurality of K^{A} are present, they may be the same or different.
   X' represents a crosslinking group selected from Group A of crosslinking group, a hydrogen atom, an alkyl group, a cycloalkyl group, an aryl group or a monovalent heterocyclic group, and the foregoing groups optionally have a substituent. When a plurality of X' are present, they may be the same or different. At least one X' is a crosslinking group selected from Group A of crosslinking group.] .
[11] The light emitting device according to any one of [1] to [10], wherein the above-described phosphorescent compound represented by the formula (1) is a phosphorescent compound represented by the formula (1-B): 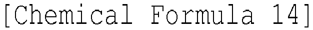 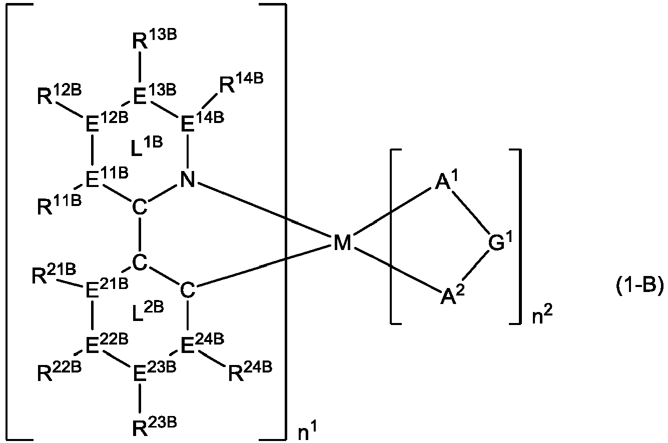 [wherein,
   M, n¹, n² and A¹-G¹-A² represent the same meaning as described above.
   E^{11B}, E^{12B}, E^{13B}, E^{14B}, E^{21B}, E^{22B}, E^{23B} and E^{24B} each independently represent a nitrogen atom or a carbon atom. When a plurality of E^{11B}, E^{12B}, E^{13B}, E^{14B}, E^{21B}, E^{22B}, E^{23B} and E^{24B} are present, they may be the same or different at each occurrence. When E^{11B} is a nitrogen atom, R^{11B} is absent. When E^{12B} is a nitrogen atom, R^{12B} is absent. When E^{13B} is a nitrogen atom, R^{13B} is absent. When E^{14B} is a nitrogen atom, R^{14B} is absent. When E^{21B} is a nitrogen atom, R^{21B} is absent. When E^{22B} is a nitrogen atom, R^{22B} is absent. When E^{23B} is a nitrogen atom, R^{23B} is absent. When E^{24B} is a nitrogen atom, R^{24B} is absent.
   R^{11B}, R^{12B}, R^{13B}, R^{14B}, R^{21B}, R^{22B}, R^{23B} and R^{24B} each independently represent a hydrogen atom, an alkyl group, a cycloalkyl group, an alkoxy group, a cycloalkoxy group, an aryl group, an aryloxy group, an alkenyl group, a monovalent heterocyclic group, a substituted amino group or a halogen atom, and the foregoing groups optionally have a substituent. When a plurality of R^{11B}, R^{12B}, R^{13B}, R^{14B}, R^{21B}, R^{22B}, R^{23B} and R^{24B} are present, they may be the same or different at each occurrence. R^{11B} and R^{12B}, R^{12B} and R^{13B}, R^{13B} and R^{14B}, R^{11B} and R^{21B}, R^{21B} and R^{22B}, R^{22B} and R^{23B}, and R^{23B} and R^{24B} may each be combined together to form a ring together with the carbon atoms to which they are attached.
   Ring L^{1B} represents a pyridine ring or a diazabenzene ring.
   Ring L^{2B} represents a benzene ring, a pyridine ring or a diazabenzene ring.].
[12] The light emitting device according to [11], wherein the above-described phosphorescent compound represented by the formula (1-B) is a phosphorescent compound represented by the formula (1-B1), a phosphorescent compound represented by the formula (1-B2), a phosphorescent compound represented by the formula (1-B3), a phosphorescent compound represented by the formula (1-B4) or a phosphorescent compound represented by the formula (1-B5): 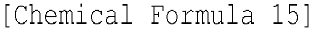 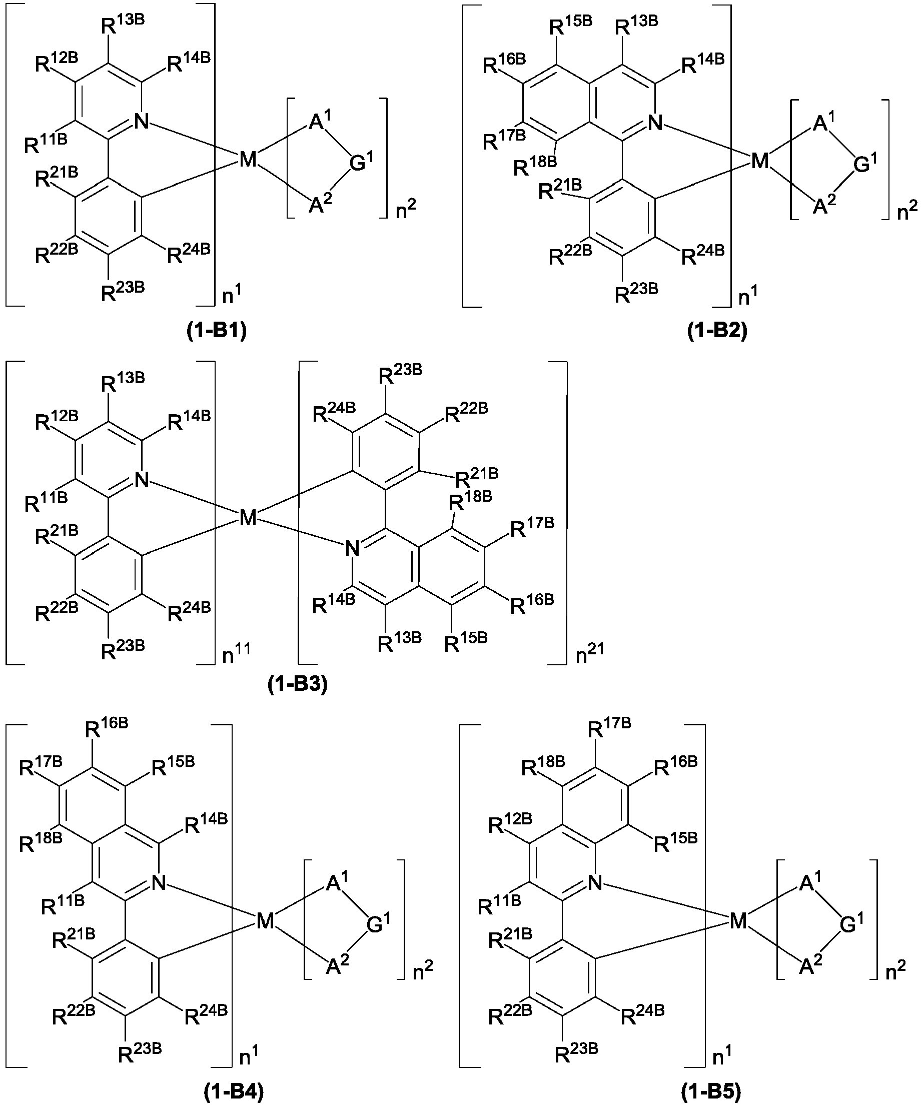 [wherein,
   M**,** n¹, n², A¹-G¹-A², R^{11B}, R^{12B}, R^{13B}, R^{14B}, R^{21B}, R^{22B}, R^{23B} and R^{24B} represent the same meaning as described above.
   n¹¹ and n²¹ each independently represent an integer of 1 or more. n¹¹+n²¹ is 3 when M is a ruthenium atom, a rhodium atom or an iridium atom, while n¹¹+n²¹ is 2 when M is a palladium atom or a platinum atom.
   R^{15B}, R^{16B}, R^{17B} and R^{18B} each independently represent a hydrogen atom, an alkyl group, a cycloalkyl group, an alkoxy group, a cycloalkoxy group, an aryl group, an aryloxy group, an alkenyl group, a monovalent heterocyclic group, a substituted amino group or a halogen atom, and the foregoing groups optionally have a substituent. When a plurality of R^{15B}, R^{16B}, R^{17B} and R^{18B} are present, they may be the same or different at each occurrence. R^{13B} and R^{15B}, R^{15B} and R^{16B}, R^{16B} and R^{17B}, R^{17B} and R^{18B}, and R^{18B} and R^{21B} may each be combined together to form a ring together with the atoms to which they are attached.].
[13] The light emitting device according to any one of [1] to [12], wherein the above-described first organic layer is a layer containing the above-described compound represented by the formula (C-1) and a phosphorescent compound.
[14] The light emitting device according to any one of [1] to [13], wherein the above-described first organic layer further contains at least one material selected from the group consisting of a hole transporting material, a hole injection material, an electron transporting material, an electron injection material and a light emitting material.
[15] The light emitting device according to any one of [1] to [14], wherein the above-described first organic layer and the above-described second organic layer are adjacent.
[16] The light emitting device according to any one of [1] to [15], wherein the above-described second organic layer is a layer disposed between the above-described anode and the above-described first organic layer.

### Effect of the Invention

According to the present invention, a light emitting device excellent in luminance life can be provided.

### Modes for Carrying Out the Invention

Suitable embodiments of the present invention will be illustrated in detail below.

### <Explanation of common terms>

Terms commonly used in the present specification have the following meanings unless otherwise stated.

Me represents a methyl group, Et represents an ethyl group, Bu represents a butyl group, i-Pr represents an isopropyl group, and t-Bu represents a tert-butyl group.

A hydrogen atom may be a heavy hydrogen atom or a light hydrogen atom.

In the formula representing a metal complex, the solid line representing the bond to the central metal means a covalent bond or a coordinate bond.

"The polymer compound" means a polymer having molecular weight distribution and having a polystyrene-equivalent number-average molecular weight of 1×10³ to 1×10⁸.

"The low molecular compound" means a compound having no molecular weight distribution and having a molecular weight of 1×10⁴ or less.

"The constitutional unit" means a unit which is present one or more times in the polymer compound.

"The alkyl group" may be any of linear or branched. The number of carbon atoms of the linear alkyl group is, not including the number of carbon atoms of the substituent, usually 1 to 50, preferably 3 to 30, more preferably 4 to 20. The number of carbon atoms of the branched alkyl group is, not including the number of carbon atoms of the substituent, usually 3 to 50, preferably 3 to 30, more preferably 4 to 20.

The alkyl group optionally has a substituent, and examples thereof include a methyl group, an ethyl group, a propyl group, an isopropyl group, a butyl group, a 2-butyl group, an isobutyl group, a tert-butyl group, a pentyl group, an isoamyl group, a 2-ethylbutyl group, a hexyl group, a heptyl group, an octyl group, a 2-ethylhexyl group, a 3-propylheptyl group, a decyl group, a 3,7-dimethyloctyl group, a 2-ethyloctyl group, a 2-hexyldecyl group and a dodecyl group, and these groups in which its hydrogen atom is substituted with a cycloalkyl group, an alkoxy group, a cycloalkoxy group, an aryl group, a fluorine atom or the like (for example, a trifluoromethyl group, a pentafluoroethyl group, a perfluorobutyl group, a perfluorohexyl group, a perfluorooctyl group, a 3-phenylpropyl group, a 3-(4-methylphenyl)propyl group, a 3-(3,5-di-hexylphenyl)propyl group and a 6-ethyloxyhexyl group).

The number of carbon atoms of the "cycloalkyl group" is, not including the number of carbon atoms of the substituent, usually 3 to 50, preferably 3 to 30, more preferably 4 to 20.

The cycloalkyl group optionally has a substituent, and examples thereof include a cyclohexyl group, a cyclohexylmethyl group and a cyclohexylethyl group.

"The aryl group" means an atomic group remaining after removing from an aromatic hydrocarbon one hydrogen atom directly bonding to a carbon atom constituting the ring. The number of carbon atoms of the aryl group is, not including the number of carbon atoms of the substituent, usually 6 to 60, preferably 6 to 20, more preferably 6 to 10.

The aryl group optionally has a substituent, and examples thereof include a phenyl group, a 1-naphthyl group, a 2-naphthyl group, a 1-anthracenyl group, a 2-anthracenyl group, a 9-anthracenyl group, a 1-pyrenyl group, a 2-pyrenyl group, a 4-pyrenyl group, a 2-fluorenyl group, a 3-fluorenyl group, a 4-fluorenyl group, a 2-phenylphenyl group, a 3-phenylphenyl group and a 4-phenylphenyl group, and these groups in which its hydrogen atom is substituted with an alkyl group, a cycloalkyl group, an alkoxy group, a cycloalkoxy group, an aryl group, a fluorine atom or the like.

"The alkoxy group" may be any of linear or branched. The number of carbon atoms of the linear alkoxy group is, not including the number of carbon atoms of the substituent, usually 1 to 40, preferably 4 to 10. The number of carbon atoms of the branched alkoxy group is, not including the number of carbon atoms of the substituent, usually 3 to 40, preferably 4 to 10.

The alkoxy group optionally has a substituent, and examples thereof include a methoxy group, an ethoxy group, a propyloxy group, an isopropyloxy group, a butyloxy group, an isobutyloxy group, a tert-butyloxy group, a pentyloxy group, a hexyloxy group, a heptyloxy group, an octyloxy group, a 2-ethylhexyloxy group, a nonyloxy group, a decyloxy group, a 3,7-dimethyloctyloxy group and a lauryloxy group, and these groups in which its hydrogen atom is substituted with a cycloalkyl group, an alkoxy group, a cycloalkoxy group, an aryl group, a fluorine atom or the like.

The number of carbon atoms of the "cycloalkoxy group" is, not including the number of carbon atoms of the substituent, usually 3 to 40, preferably 4 to 10.

The cycloalkoxy group optionally has a substituent, and examples thereof include a cyclohexyloxy group.

The number of carbon atoms of the "aryloxy group" is, not including the number of carbon atoms of the substituent, usually 6 to 60, preferably 6 to 48.

The aryloxy group optionally has a substituent, and examples thereof include a phenoxy group, a 1-naphthyloxy group, a 2-naphthyloxy group, a 1-anthracenyloxy group, a 9-anthracenyloxy group and a 1-pyrenyloxy group, and these groups in which its hydrogen atom is substituted with an alkyl group, a cycloalkyl group, an alkoxy group, a cycloalkoxy group, a fluorine atom or the like.

"The p-valent heterocyclic group" (p represents an integer of 1 or more.) means an atomic group remaining after removing from a heterocyclic compound p hydrogen atoms among hydrogen atoms directly bonding to carbon atoms or hetero atoms constituting the ring. Of the p-valent heterocyclic groups, preferable are "p-valent aromatic heterocyclic groups" which are atomic groups remaining after removing from an aromatic heterocyclic compound p hydrogen atoms among hydrogen atoms directly bonding to carbon atoms or hetero atoms constituting the ring.

"The aromatic heterocyclic compound" means a compound in which the hetero ring itself shows aromaticity such as oxadiazole, thiadiazole, thiazole, oxazole, thiophene, pyrrole, phosphole, furan, pyridine, pyrazine, pyrimidine, triazine, pyridazine, quinoline, isoquinoline, carbazole, dibenzophosphole and the like and a compound in which an aromatic ring is condensed to the hetero ring even if the hetero ring itself shows no aromaticity such as phenoxazine, phenothiazine, dibenzoborole, dibenzosilole, benzopyran and the like.

The number of carbon atoms of the monovalent heterocyclic group is, not including the number of carbon atoms of the substituent, usually 2 to 60, preferably 4 to 20.

The monovalent heterocyclic group optionally has a substituent, and examples thereof include a thienyl group, a pyrrolyl group, a furyl group, a pyridyl group, a piperidinyl group, a quinolinyl group, an isoquinolinyl group, a pyrimidinyl group and a triazinyl group, and these groups in which its hydrogen atom is substituted with an alkyl group, a cycloalkyl group, an alkoxy group, a cycloalkoxy group or the like.

"The halogen atom" denotes a fluorine atom, a chlorine atom, a bromine atom or an iodine atom.

"The amino group" optionally has a substituent, and a substituted amino group is preferable. The substituent which the amino group has is preferably an alkyl group, a cycloalkyl group, an aryl group or a monovalent heterocyclic group.

The substituted amino group includes, for example, a dialkylamino group, a dicycloalkylamino group and a diarylamino group.

The amino group includes, for example, a dimethylamino group, a diethylamino group, a diphenylamino group, a bis(4-methylphenyl)amino group, a bis(4-tert-butylphenyl)amino group and a bis(3,5-di-tert-butylphenyl)amino group.

"The alkenyl group" may be any of linear or branched. The number of carbon atoms of the linear alkenyl group is, not including the number of carbon atoms of the substituent, usually 2 to 30, preferably 3 to 20. The number of carbon atoms of the branched alkenyl group is, not including the number of carbon atoms of the substituent, usually 3 to 30, preferably 4 to 20.

The number of carbon atoms of "the cycloalkenyl group" is, not including the number of carbon atoms of the substituent, usually 3 to 30, preferably 4 to 20.

The alkenyl group and the cycloalkenyl group optionally have a substituent, and examples thereof include a vinyl group, a 1-propenyl group, a 2-propenyl group, a 2-butenyl group, a 3-butenyl group, a 3-pentenyl group, a 4-pentenyl group, a 1-hexenyl group, a 5-hexenyl group and a 7-octenyl group, and these groups having a substituent.

"The alkynyl group" may be any of linear or branched. The number of carbon atoms of the alkynyl group is, not including the number of carbon atoms of the substituent, usually 2 to 20, preferably 3 to 20. The number of carbon atoms of the branched alkynyl group is, not including the number of carbon atoms of the substituent, usually 4 to 30, preferably 4 to 20.

The number of carbon atoms of "the cycloalkynyl group" is, not including the number of carbon atoms of the substituent, usually 4 to 30, preferably 4 to 20.

The alkynyl group and the cycloalkynyl group optionally have a substituent, and examples thereof include an ethynyl group, a 1-propynyl group, a 2-propynyl group, a 2-butynyl group, a 3-butynyl group, a 3-pentynyl group, a 4-pentynyl group, a 1-hexynyl group and a 5-hexynyl group, and these groups having a substituent.

"The arylene group" means an atomic group remaining after removing from an aromatic hydrocarbon two hydrogen atoms directly bonding to carbon atoms constituting the ring. The number of carbon atoms of the arylene group is, not including the number of carbon atoms of the substituent, usually 6 to 60, preferably 6 to 30, more preferably 6 to 18.

The arylene group optionally has a substituent, and examples thereof include a phenylene group, a naphthalenediyl group, an anthracenediyl group, a phenanthrenediyl group, a dihydrophenanthrenediyl group, a naphthacenediyl group, a fluorenediyl group, a pyrenediyl group, a perylenediyl group and a chrysenediyl group, and these groups having a substituent, and preferable are groups represented by the formula (A-1) to the formula (A-20). The arylene group includes groups in which a plurality of these groups are connected. 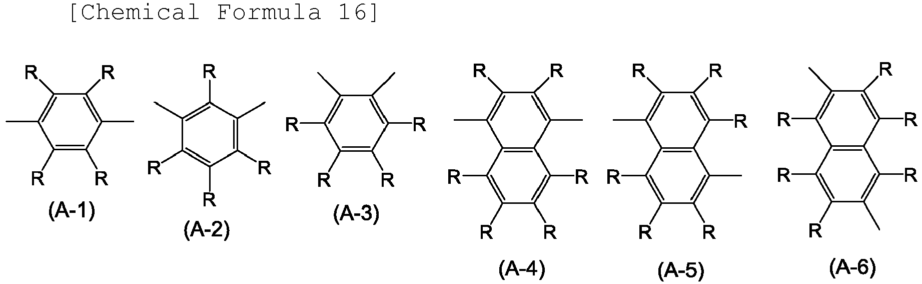 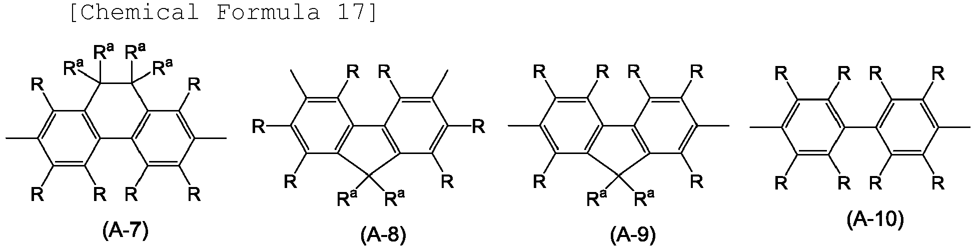 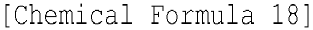 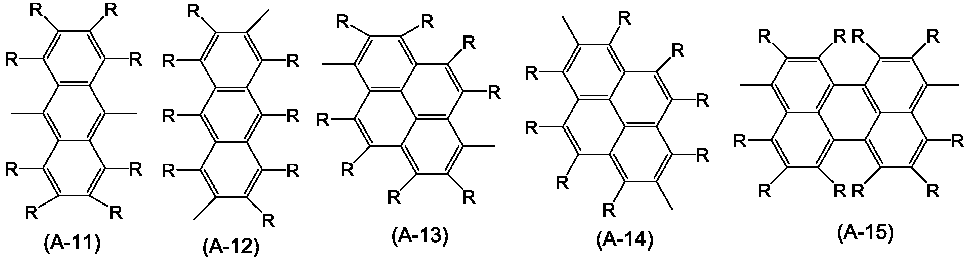 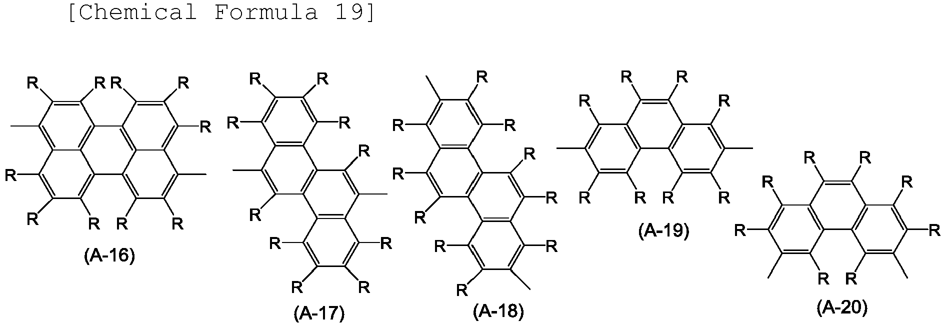 [wherein, R and R^{a} each independently represent a hydrogen atom, an alkyl group, a cycloalkyl group, an aryl group or a monovalent heterocyclic group. A plurality of R and R^{a} each may be the same or different and the groups R^{a} may be combined together to form a ring together with the atoms to which they are attached.]

The number of carbon atoms of the divalent heterocyclic group is, not including the number of carbon atoms of the substituent, usually 2 to 60, preferably 3 to 20, more preferably 4 to 15.

The divalent heterocyclic group optionally has a substituent, and examples thereof include divalent groups obtained by removing from pyridine, diazabenzene, triazine, azanaphthalene, diazanaphthalene, carbazole, dibenzofuran, dibenzothiophene, dibenzosilole, phenoxazine, phenothiazine, acridine, dihydroacridine, furan, thiophene, azole, diazole or triazole two hydrogen atoms among hydrogen atoms directly bonding to carbon atoms or hetero atoms constituting the ring, and preferable are groups represented by the formula (AA-1) to the formula (AA-34). The divalent heterocyclic group includes groups in which a plurality of these groups are connected. 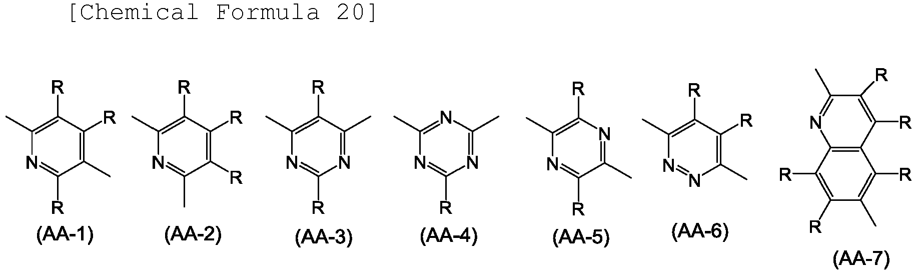 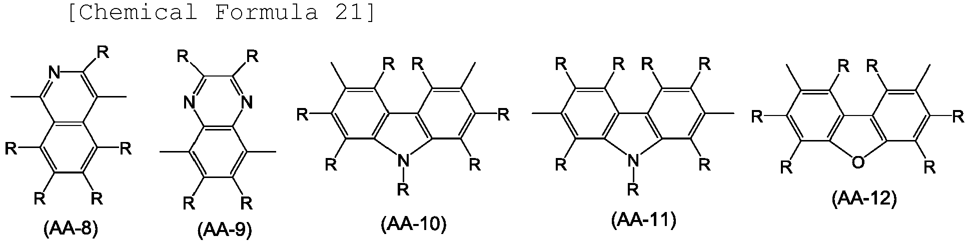 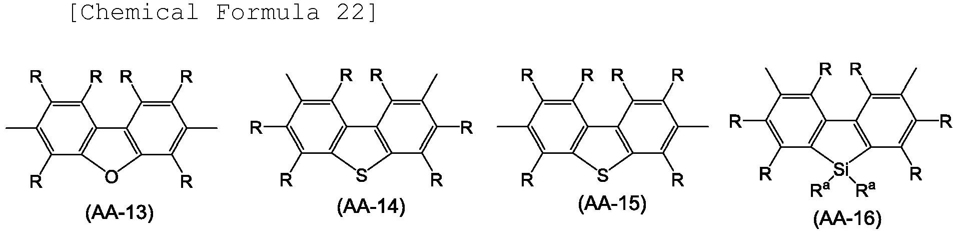 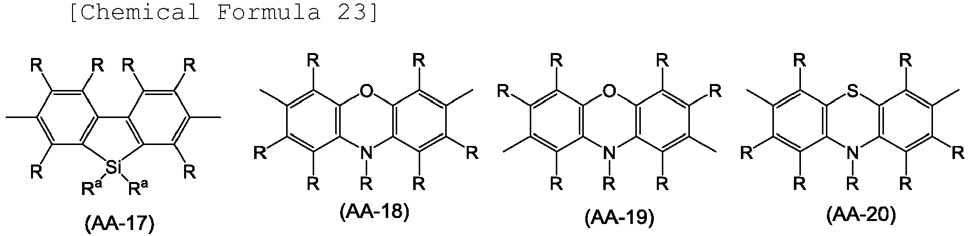 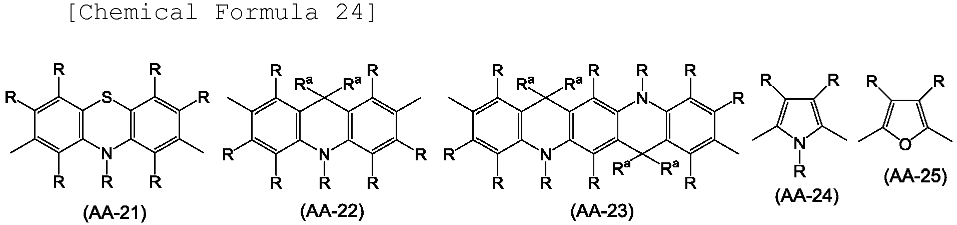 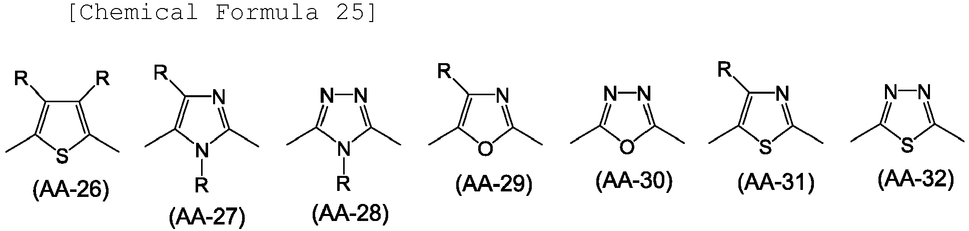 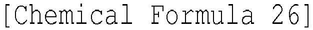 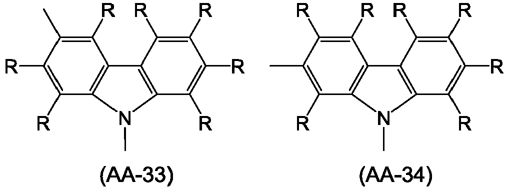 [wherein, R and R^{a} represent the same meaning as described above.]

"The crosslinking group" is a group capable of generating a new bond by being subjected to heating, ultraviolet irradiation, near ultraviolet irradiation, visible light irradiation, infrared irradiation, radical reaction and the like, and preferably is a crosslinking group represented by the formula (XL-1) to the formula (XL-17) in Group A of crosslinking group.

"The substituent" represents a halogen atom, a cyano group, an alkyl group, a cycloalkyl group, an aryl group, a monovalent heterocyclic group, an alkoxy group, a cycloalkoxy group, an aryloxy group, an amino group, a substituted amino group, an alkenyl group, a cycloalkenyl group, an alkynyl group or a cycloalkynyl group. The substituent may be a crosslinking group.

### <Light emitting device >

### [First organic layer]

The first organic layer which the light emitting device of the present invention has is a layer containing a compound represented by the formula (C-1).

### [Compound represented by the formula (C-1)]

The compound represented by the formula (C-1) has a molecular weight of preferably 2×10² to 5×10⁴, more preferably 2×10² to 5×10³, further preferably 3×10² to 3×10³, particularly preferably 4×10² to 1×10³.

The number of carbon atoms of the aromatic hydrocarbon ring represented by Ring R^{1C}, Ring R^{2C}, Ring R^{3C} and Ring R^{4C} is, not including the number of carbon atoms of the substituent, usually 6 to 60, preferably 6 to 30, more preferably 6 to 18.

The aromatic hydrocarbon ring represented by Ring R^{1C}, Ring R^{2C}, Ring R^{3C} and Ring R^{4C} includes, for example, a benzene ring, a naphthalene ring, an anthracene ring, an indene ring, a fluorene ring, a spirobifluorene ring, a phenanthrene ring, a dihydrophenanthrene ring, a pyrene ring, a chrysene ring and a triphenylene ring, and is preferably a benzene ring, a naphthalene ring, an anthracene ring, a fluorene ring, a spirobifluorene ring, a phenanthrene ring or a dihydrophenanthrene ring, more preferably a benzene ring, a naphthalene ring, a fluorene ring or a spirobifluorene ring, further preferably a benzene ring, and the foregoing rings optionally have a substituent.

The number of carbon atoms of the aromatic hetero ring represented by Ring R^{1C}, Ring R^{2C}, Ring R^{3C} and Ring R^{4C} is, not including the number of carbon atoms of the substituent, usually 2 to 60, preferably 3 to 30, more preferably 4 to 15.

The aromatic hetero ring represented by Ring R^{1C}, Ring R^{2C}, Ring R^{3C} and Ring R^{4C} includes, for example, a pyrrole ring, a diazole ring, a triazole ring, a furan ring, a thiophene ring, an oxadiazole ring, a thiadiazole ring, a pyridine ring, a diazabenzene ring, a triazine ring, an azanaphthalene ring, a diazanaphthalene ring, a triazanaphthalene ring, an azaanthracene ring, a diazaanthracene ring, a triazaanthracene ring, an azaphenanthrene ring, a diazaphenanthrene ring, a triazaphenanthrene ring, a dibenzofuran ring, a dibenzothiophene ring, a dibenzosilole ring, a dibenzophosphole ring, a carbazole ring, an azacarbazole ring, a diazacarbazole ring, a phenoxazine ring, a phenothiazine ring, a dihydroacridine ring and a dihydrophenazine ring, and is preferably a pyridine ring, a diazabenzene ring, an azanaphthalene ring, a diazanaphthalene ring, an azaanthracene ring, a diazaphenanthrene ring, a dibenzofuran ring, a dibenzothiophene ring, a carbazole ring, a phenoxazine ring, a phenothiazine ring, a dihydroacridine ring or a dihydrophenazine ring, more preferably a pyridine ring, a diazabenzene ring, an azanaphthalene ring, a diazanaphthalene ring, a dibenzofuran ring, a dibenzothiophene ring or a carbazole ring, further preferably a pyridine ring or a diazabenzene ring, and the foregoing rings optionally have a substituent.

It is preferable that at least one of Ring R^{1C}, Ring R^{2C}, Ring R^{3C} and Ring R^{4C} is an aromatic hydrocarbon ring, it is more preferable that at least two of Ring R^{1C}, Ring R^{2C}, Ring R^{3C} and Ring R^{4C} are aromatic hydrocarbon rings, it is further preferable that all Ring R^{1C}, Ring R^{2C}, Ring R^{3C} and Ring R^{4C} are aromatic hydrocarbon rings, it is particularly preferable that all Ring R^{1C}, Ring R^{2C}, Ring R^{3C} and Ring R^{4C} represent a benzene ring, and the foregoing rings optionally have a substituent, since the light emitting device of the present invention is more excellent in luminance life.

The substituent which Ring R^{1C}, Ring R^{2C}, Ring R^{3C} and Ring R^{4C} optionally have is preferably an alkyl group, a cycloalkyl group, an alkoxy group, a cycloalkoxy group, an aryl group, an aryloxy group, a monovalent heterocyclic group, a substituted amino group or a halogen atom, more preferably an alkyl group, a cycloalkyl group, an aryl group, a monovalent heterocyclic group or a substituted amino group, further preferably an aryl group or a monovalent heterocyclic group, particularly preferably a monovalent heterocyclic group, and the foregoing groups optionally further have a substituent.

The number of carbon atoms of the aryl group as the substituent which Ring R^{1C}, Ring R^{2C}, Ring R^{3C} and Ring R^{4C} optionally have is, not including the number of carbon atoms of the substituent, usually 6 to 60, preferably 6 to 40, more preferably 6 to 25.

The aryl group as the substituent which Ring R^{1C}, Ring R^{2C}, Ring R^{3C} and Ring R^{4C} optionally have includes, for example, groups obtained by removing from a benzene ring, a naphthalene ring, an anthracene ring, an indene ring, a fluorene ring, a spirobifluorene ring, a phenanthrene ring, a dihydrophenanthrene ring, a pyrene ring, a chrysene ring, a triphenylene ring or a ring obtained by condensing these rings one hydrogen atom directly bonding to a carbon atom constituting the ring, and is preferably a group obtained by removing from a benzene ring, a naphthalene ring, a fluorene ring, a spirobifluorene ring, a phenanthrene ring, a dihydrophenanthrene ring or a triphenylene ring one hydrogen atom directly bonding to a carbon atom constituting the ring, more preferably a group obtained by removing from a benzene ring, a fluorene ring or a spirobifluorene ring one hydrogen atom directly bonding to a carbon atom constituting the ring, further preferably a group obtained by removing from a fluorene ring or a spirobifluorene ring one hydrogen atom directly bonding to a carbon atom constituting the ring, and the foregoing groups optionally further have a substituent.

The number of carbon atoms of the monovalent heterocyclic group as the substituent which Ring R^{1C}, Ring R2C, Ring R^{3C} and Ring R^{4C} optionally have is, not including the number of carbon atoms of the substituent, usually 2 to 60, preferably 3 to 30, more preferably 3 to 15.

The monovalent heterocyclic group as the substituent which Ring R^{1C}, Ring R^{2C}, Ring R^{3C} and Ring R^{4C} optionally have includes, for example, groups obtained by removing from a pyrrole ring, a diazole ring, a triazole ring, a furan ring, a thiophene ring, an oxadiazole ring, a thiadiazole ring, a pyridine ring, a diazabenzene ring, a triazine ring, an azanaphthalene ring, a diazanaphthalene ring, a triazanaphthalene ring, an azaanthracene ring, a diazaanthracene ring, a triazaanthracene ring, an azaphenanthrene ring, a diazaphenanthrene ring, a triazaphenanthrene ring, a dibenzofuran ring, a dibenzothiophene ring, a dibenzosilole ring, a dibenzophosphole ring, a carbazole ring, an azacarbazole ring, a diazacarbazole ring, a phenoxazine ring, a phenothiazine ring, a dihydroacridine ring, a dihydrophenazine ring or a ring obtained by condensing an aromatic ring to these rings one hydrogen atom bonding directly to a carbon atom or a hetero atom constituting the ring, and is preferably a group obtained by removing from a pyridine ring, a diazabenzene ring, a triazine ring, an azanaphthalene ring, a diazanaphthalene ring, a dibenzofuran ring, a dibenzothiophene ring, a carbazole ring, an azacarbazole ring, a diazacarbazole ring, a phenoxazine ring, a phenothiazine ring, a dihydroacridine ring or a dihydrophenazine ring one hydrogen atom directly bonding to a carbon atom or a hetero atom constituting the ring, more preferably a group obtained by removing from a pyridine ring, a diazabenzene ring, a triazine ring, a dibenzofuran ring, a dibenzothiophene ring, a carbazole ring, an azacarbazole ring, a diazacarbazole ring, a phenoxazine ring, a phenothiazine ring, a dihydroacridine ring or a dihydrophenazine ring one hydrogen atom directly bonding to a carbon atom or a hetero atom constituting the ring, further preferably a group obtained by removing from a dibenzofuran ring, a dibenzothiophene ring, a carbazole ring, a phenoxazine ring, a phenothiazine ring, a dihydroacridine ring or a dihydrophenazine ring one hydrogen atom directly bonding to a carbon atom or a hetero atom constituting the ring, particularly preferably a group obtained by removing from a dibenzofuran ring, a dibenzothiophene ring, a carbazole ring or a dihydroacridine ring one hydrogen atom directly bonding to a carbon atom or a hetero atom constituting the ring, especially preferably a group obtained by removing from a dibenzofuran ring or a dibenzothiophene ring one hydrogen atom directly bonding to a carbon atom constituting the ring, and the foregoing rings optionally have a substituent.

In the substituted amino group as the substituent which Ring R^{1C}, Ring R^{2C}, Ring R^{3C} and Ring R^{4C} optionally have, the substituent which the amino group has is preferably an aryl group or a monovalent heterocyclic group, more preferably an aryl group, and the foregoing groups optionally further have a substituent. The examples and preferable ranges of the aryl group as the substituent which the amino group has are the same as the examples and preferable ranges of the aryl group as the substituent which Ring R^{1C}, Ring R^{2C}, Ring R^{3C} and Ring R^{4C} optionally have. The examples and preferable ranges of the monovalent heterocyclic group as the substituent which the amino group has are the same as the examples and preferable ranges of the monovalent heterocyclic group as the substituent which Ring R^{1C}, Ring R^{2C}, Ring R^{3C} and Ring R^{4C} optionally have.

The substituent which the substituent which Ring R^{1C}, Ring R^{2C}, Ring R^{3C} and Ring R^{4C} optionally have optionally further has is preferably an alkyl group, a cycloalkyl group, an alkoxy group, a cycloalkoxy group, an aryl group, an aryloxy group, a monovalent heterocyclic group, a substituted amino group or a halogen atom, more preferably an alkyl group, a cycloalkyl group, an aryl group or a monovalent heterocyclic group, further preferably an alkyl group or an aryl group, and the foregoing groups optionally further have a substituent.

The examples and preferable ranges of the aryl group, the monovalent heterocyclic group and the substituted amino group as the substituent which the substituent which Ring R^{1C}, Ring R^{2C}, Ring R^{3C} and Ring R^{4C} optionally have optionally further has are the same as the examples and preferable ranges of the aryl group, the monovalent heterocyclic group and the substituted amino group as the substituent which Ring R^{1C}, Ring R^{2C}, Ring R^{3C} and Ring R^{4C} optionally have, respectively.

R^{C} is preferably a carbon atom, a silicon atom or a germanium atom, more preferably a carbon atom or a silicon atom, further preferably a carbon atom, since the light emitting device of the present invention is more excellent in luminance life.

Since the light emitting device of the present invention is more excellent in luminance life, it is preferable that at least one of Ring R^{1C}, Ring R^{2C}, Ring R^{3C} and Ring R^{4C} has an aryl group or a monovalent heterocyclic group, it is more preferable that at least one of Ring R^{1C}, Ring R^{2C}, Ring R^{3C} and Ring R^{4C} has a group represented by the formula (D-1), and the foregoing groups optionally have a substituent.

When at least one of Ring R^{1C}, Ring R^{2C}, Ring R^{3C} and Ring R^{4C} has an aryl group or a monovalent heterocyclic group, the total number of the aryl group and the monovalent heterocyclic group which Ring R^{1C}, Ring R^{2C}, Ring R^{3C} and Ring R^{4C} have is preferably 1 to 5, more preferably 1 to 3, further preferably 1 or 2, particularly preferably 1.

When at least one of Ring R^{1C}, Ring R^{2C}, Ring R^{3C} and Ring R^{4C} has a group represented by the formula (D-1), the total number of the group represented by the formula (D-1) which Ring R^{1C}, Ring R^{2C}, Ring R^{3C} and Ring R^{4C} have is preferably 1 to 5, more preferably 1 to 3, further preferably 1 or 2, particularly preferably 1.

### Group represented by the formula (D-1)

The examples and preferable ranges of the aromatic hydrocarbon ring and the aromatic hetero ring represented by Ring R^{D} are the same as the examples and preferable ranges of the aromatic hydrocarbon ring and the aromatic hetero ring represented by Ring R^{1C}, Ring R^{2C}, Ring R^{3C} and Ring R^{4C}, respectively.

The examples and preferable ranges of the substituent which Ring R^{D} optionally has are the same as the examples and preferable ranges of the substituent which the substituent which Ring R^{1C}, Ring R^{2C}, Ring R^{3C} and Ring R^{4C} optionally have optionally further has.

Ring R^{D} is preferably an aromatic hydrocarbon ring, more preferably a benzene ring, since the light emitting device of the present invention is more excellent in luminance life.

X^{D1} and X^{D2} are each preferably a single bond, an oxygen atom, a sulfur atom or a group represented by -C(R^{XD2})₂-, more preferably a single bond, an oxygen atom or a sulfur atom, further preferably a single bond or a sulfur atom, and particularly preferably one of X^{D1} and X^{D2} is a single bond and the other is a sulfur atom, since the light emitting device of the present invention is more excellent in luminance life.

It is preferable that at least one of X^{D1} and X^{D2} is a single bond, and it is more preferable that X^{D2} is a single bond.

R^{XD1} is preferably an alkyl group, a cycloalkyl group, an aryl group or a monovalent heterocyclic group, more preferably an aryl group or a monovalent heterocyclic group, further preferably an aryl group, and the foregoing groups optionally have a substituent.

R^{XD2} is preferably an alkyl group, a cycloalkyl group, an aryl group or a monovalent heterocyclic group, more preferably an alkyl group or an aryl group, and the foregoing groups optionally have a substituent.

The examples and preferable ranges of the aryl group, the monovalent heterocyclic group and the substituted amino group represented by R^{XD1} and R^{XD2} are the same as the examples and preferable ranges of the aryl group, the monovalent heterocyclic group and the substituted amino group as the substituent which Ring R^{1C}, Ring R^{2C}, Ring R^{3C} and Ring R^{4C} optionally have, respectively.

Regarding the combination of two groups R^{XD2} in the group represented by -C(R^{XD2})₂- represented by X^{D1} and X^{D2}, it is preferable that both are alkyl groups or cycloalkyl groups, both are aryl groups, both are monovalent heterocyclic groups, or one is an alkyl group or a cycloalkyl group and the other is an aryl group or a monovalent heterocyclic group, it is more preferable that both are aryl groups, or one is an alkyl group or a cycloalkyl group and the other is an aryl group, it is further preferable that both are aryl groups, and the foregoing groups optionally have a substituent. It is preferable that two groups R^{XD2} are combined together to form a ring together with a carbon atom to which they are attached. When R^{XD2} forms a ring, the group represented by -C(R^{XD2})₂- is preferably a group represented by the formula (Y-A1) to the formula (Y-A5), more preferably a group represented by the formula (Y-A4), and the foregoing groups optionally have a substituent.

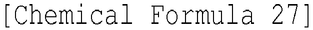

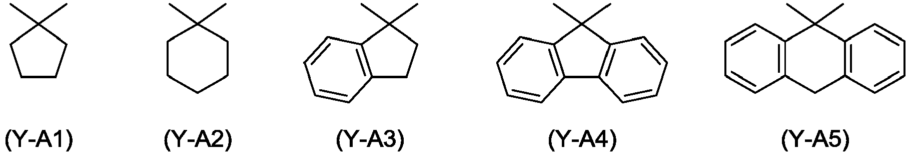

The examples and preferable ranges of the substituent which R^{XD1} and R^{XD2} optionally have are the same as the examples and preferable ranges of the substituent which the substituent which Ring R^{1C}, Ring R^{2C}, Ring R^{3C} and Ring R^{4C} optionally have optionally further has.

E^{1D}, E^{2D} and E^{3D} are each preferably a carbon atom.

R^{1D}, R^{2D} and R^{3D} are each preferably a hydrogen atom, an alkyl group, a cycloalkyl group, an aryl group, a monovalent heterocyclic group or a substituted amino group, more preferably a hydrogen atom, an alkyl group or an aryl group, further preferably a hydrogen atom, and the foregoing groups optionally further have a substituent.

The examples and preferable ranges of the aryl group, the monovalent heterocyclic group and the substituted amino group represented by R^{1D}, R^{2D} and R^{3D} are the same as the examples and preferable ranges of the aryl group, the monovalent heterocyclic group and the substituted amino group as the substituent which Ring R^{1C}, Ring R^{2C}, Ring R^{3C} and Ring R^{4C} optionally have, respectively.

The examples and preferable ranges of the substituent which R^{1D}, R^{2D} and R^{3D} optionally have are the same as the examples and preferable ranges of the substituent which R^{XD1} and R^{XD2} optionally have.

R^{1D} and R^{2D}, R^{2D} and R^{3D}, R^{1D} and RXD1, R^{1D} and R^{XD2}, R^{XD1} and a substituent which Ring R^{D} optionally has, and R^{XD2} and a substituent which Ring R^{D} optionally has each may be combined together to form a ring together with the carbon atoms to which they are attached, but it is preferable that they do not form a ring.

The group represented by the formula (D-1) is preferably a group represented by the formula (D-2), since the light emitting device of the present invention is more excellent in luminance life. 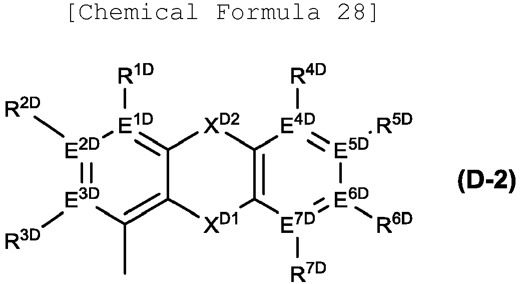 [wherein,
X^{D1}, X^{D2}, E^{1D}, E^{2D}, E^{3D}, R^{1D}, R^{2D} and R^{3D} represent the same meaning as described above.
E^{4D}, E^{5D}, E^{6D} and E^{7D} each independently represent a nitrogen atom or a carbon atom.
R^{4D}, R^{5D}, R^{6D} and R^{7D} each independently represent a hydrogen atom, an alkyl group, a cycloalkyl group, an alkoxy group, a cycloalkoxy group, an aryl group, an aryloxy group, a monovalent heterocyclic group, a substituted amino group or a halogen atom, and the foregoing groups optionally have a substituent.
When E^{4D} is a nitrogen atom, R^{4D} is absent. When E^{5D} is a nitrogen atom, R^{5D} is absent. When E^{6D} is a nitrogen atom, R^{6D} is absent. When E^{7D} is a nitrogen atom, R^{7D} is absent.
R^{4D} and R^{5D}, R^{5D} and R^{6D}, R^{6D} and R^{7D}, R^{4D} and R^{XD1}, R^{4D} and R^{XD2}, R^{7D} and R^{XD1}, and R^{7D} and R^{XD2} may each be combined together to form a ring together with the atoms to which they are attached.]

E^{4D}, E^{5D}, E^{6D} and E^{7D} are each preferably a carbon atom.

The examples and preferable ranges of R^{4D}, R^{5D}, R^{6D} and R^{7D} are the same as the examples and preferable ranges of R^{1D}, R^{2D} and R^{3D}.

The examples and preferable ranges of the substituent which R^{4D}, R^{5D}, R^{6D} and R^{7D} optionally have are the same as the examples and preferable ranges of the substituent which R^{1D}, R^{2D} and R^{3D} optionally have.

R^{4D} and R^{5D}, R^{5D} and R^{6D}, and R^{6D} and R^{7D} each may be combined together to form a ring together with the carbon atoms to which they are attached, but it is preferable that they do not form a ring.

### [Compound represented by the formula (C-2)]

The compound represented by the formula (C-1) is preferably a compound represented by the formula (C-2), since the light emitting device of the present invention is more excellent in luminance life.

E^{11C}, E^{12C}, E^{13C}, E^{14C}, E^{21C}, E^{22C}, E^{23C}, E^{24C}, E^{31C}, E^{32C}, E^{33C}, E^{34C}, E^{41C}, E^{42C}, E^{43C} and E^{44C} are each preferably a carbon atom.

Ring R^{1C}', Ring R^{2C'}, Ring R^{3C'} and Ring R^{4C'} are each preferably a benzene ring.

R^{11C}, R^{12C}, R^{13C}, R^{14C}, R^{21C}, R^{22C}, R^{23C}, R^{24C}, R^{31C}, R^{32C}, R^{33C}, R^{34C}, R^{41C}, R^{42C}, R^{43C} and R^{44C} are each preferably a hydrogen atom, an alkyl group, a cycloalkyl group, an aryl group, a monovalent heterocyclic group or a substituted amino group, more preferably a hydrogen atom, an aryl group or a monovalent heterocyclic group, further preferably a hydrogen atom or a group represented by the formula (D-1), and the foregoing groups optionally further have a substituent.

At least one of R^{11C}, R^{12C}, R^{13C}, R^{14C}, R^{21C}, R^{22C}, R^{23C}, R^{24C}, R^{31C}, R^{32C}, R^{33C}, R^{34C}, R^{41C}, R^{42C}, R^{43C} and R^{44C} is preferably an aryl group or a monovalent heterocyclic group, more preferably a group represented by the formula (D-1), and the foregoing groups optionally further have a substituent.

The examples and preferable ranges of the aryl group, the monovalent heterocyclic group and the substituted amino group represented by R^{11C}, R^{12C}, R^{13C}, R^{14C}, R^{21C}, R^{22C}, R^{23C}, R^{24C}, R^{31C}, R^{32C}, R^{33C}, R^{34C}, R^{41C}, R^{42C}, R^{43C} and R^{44C} are the same as the examples and preferable ranges of the aryl group, the monovalent heterocyclic group and the substituted amino group as the substituent which Ring R^{1C}, Ring R^{2C}, Ring R^{3C} and Ring R^{4C} optionally have, respectively.

The examples and preferable ranges of the substituent R^{11C}, R^{12C}, R^{13C}, R^{14C}, R^{21C}, R^{22C}, R^{23C}, R^{24C}, R^{31C}, R^{32C}, R^{33C}, R^{34C}, R^{41C}, R^{42C}, R^{43C} and R^{44C} optionally have are the same as the examples and preferable ranges of the substituent which the substituent which Ring R^{1C}, Ring R^{2C}, Ring R^{3C} and Ring R^{4C} optionally have optionally further has.

When at least one of R^{11C}, R^{12C}, R^{13C}, R^{14C}, R^{21C}, R^{22C}, R^{23C}, R^{24C}, R^{31C}, R^{32C}, R^{33C}, R^{34C}, R^{41C}, R^{42C}, R^{43C} and R^{44C} is an aryl group or a monovalent heterocyclic group, the total number of the aryl group or the monovalent heterocyclic group represented by R^{11C}, R^{12C}, R^{13C}, R^{14C}, R^{21C}, R^{22C}, R^{23C}, R^{24C}, R^{31C}, R^{32C}, R^{33C}, R^{34C}, R^{41C}, R^{42C}, R^{43C} and R^{44C} is preferably 1 to 5, more preferably 1 to 3, further preferably 1 or 2, particularly preferably 1.

When at least one of R^{11C}, R^{12C}, R^{13C}, R^{14C}, R^{21C}, R^{22C}, R^{23C}, R^{24C}, R^{31C}, R^{32C}, R^{33C}, R^{34C}, R^{41C}, R^{42C}, R^{43C} and R^{44C} is a group represented by the formula (D-1), the total number of the group represented by the formula (D-1) represented by R^{11C}, R^{12C}, R^{13C}, R^{14C}, R^{21C}, R^{22C}, R^{23C}, R^{24C}, R^{31C}, R^{32C}, R^{33C}, R^{34C}, R^{41C}, R^{42C}, R^{43C} and R^{44C} is preferably 1 to 5, more preferably 1 to 3, further preferably 1 or 2, particularly preferably 1.

When at least one of R^{11C}, R^{12C}, R^{13C}, R^{14C}, R^{21C}, R^{22C}, R^{23C}, R^{24C}, R^{31C}, R^{32C}, R^{33C}, R^{34C}, R^{41C}, R^{42C}, R^{43C} and R^{44C} is an aryl group or a monovalent heterocyclic group, it is preferable that at least one of R^{11C}, R^{12C}, R^{14C}, R^{21C}, R^{22C}, R^{24C}, R^{31C}, R^{32C}, R^{34C}, R^{41C}, R^{42C} and R^{44C} is an aryl group or a monovalent heterocyclic group, it is more preferable that at least one of R^{11C}, R^{12C}, R^{21C}, R^{22C}, R^{31C}, R^{32C}, R^{41C} and R^{42C} is an aryl group or a monovalent heterocyclic group, it is further preferable that at least one of R^{11C}, R^{12C}, R^{21C} and R^{22C} is an aryl group or a monovalent heterocyclic group, it is particularly preferable that at least one of R^{12C} and R^{22C} is an aryl group or a monovalent heterocyclic group, and the foregoing groups optionally have a substituent.

When at least one of R^{11C}, R^{12C}, R^{13C}, R^{14C}, R^{21C}, R^{22C}, R^{23C}, R^{24C}, R^{31C}, R^{32C}, R^{33C}, R^{34C}, R^{41C}, R^{42C}, R^{43C} and R^{44C} is a group represented by the formula (D-1), it is preferable that at least one of R^{11C}, R^{12C}, R^{14C}, R^{21C}, R^{22C}, R^{24C}, R^{31C}, R^{32C}, R^{34C}, R^{41C}, R^{42C} and R^{44C} is a group represented by the formula (D-1), it is more preferable that at least one of R^{11C}, R^{12C}, R^{21C}, R^{22C}, R^{31C}, R^{32C}, R^{41C} and R^{42C} is a group represented by the formula (D-1), it is further preferable that at least one of R^{11C}, R^{12C}, R^{21C} and R^{22C} is a group represented by the formula (D-1), it is particularly preferable that at least one of R^{11C} and R^{12C} is a group represented by the formula (D-1), it is especially preferable that R^{12C} is a group represented by the formula (D-1).

R^{11C} and R^{12C}, R^{12C} and R^{13C}, R^{13C} and R^{14C}, R^{14C} and R^{34C}, R^{34C} and R^{33C}, R^{33C} and R^{32C}, R^{32C} and R^{31C}, R^{31C} and R^{41C}, R^{41C} and R^{42C}, R^{42C} and R^{43C}, R^{43C} and R^{44C}, R^{44C} and R^{24C}, R^{24C} and R^{23C}, R^{23C} and R^{22C}, R^{22C} and R^{21C}, and R^{21C} and R^{11C} each may be combined together to form a ring together with the carbon atoms to which they are attached, but it is preferable that they do not form a ring.

### [Compound represented by the formula (C-3)]

The compound represented by the formula (C-2) is preferably a compound represented by the formula (C-3), since the light emitting device of the present invention is more excellent in luminance life.

The compound represented by the formula (C-1) includes, for example, compounds represented by the formula (C-101) to the formula (C-137). 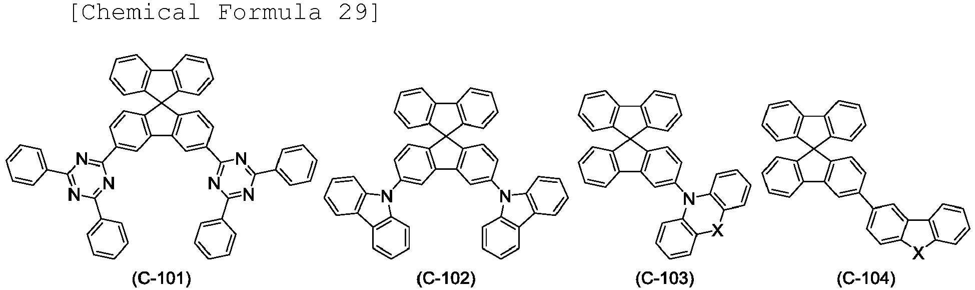 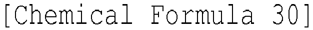 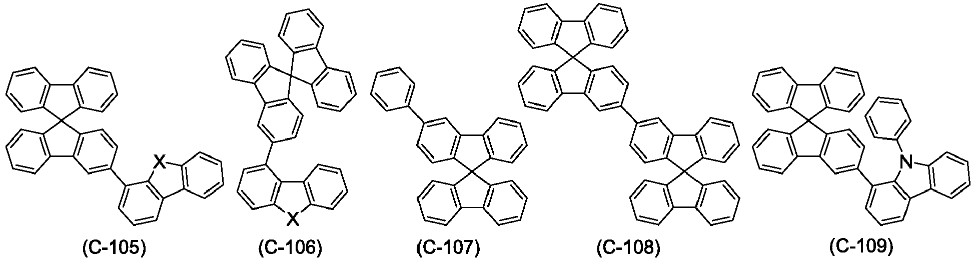 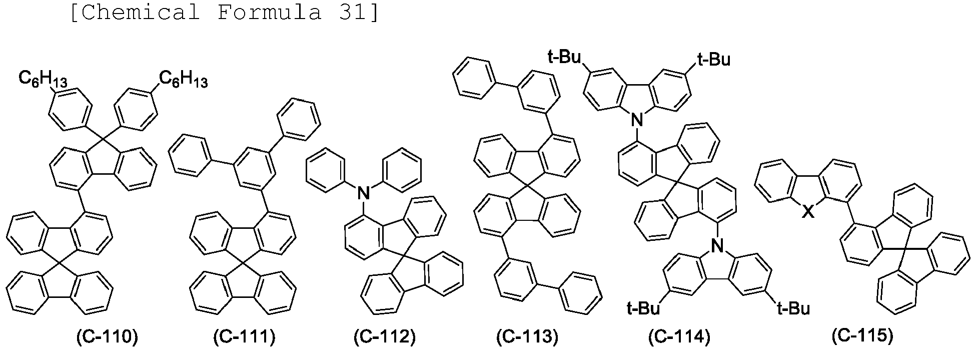 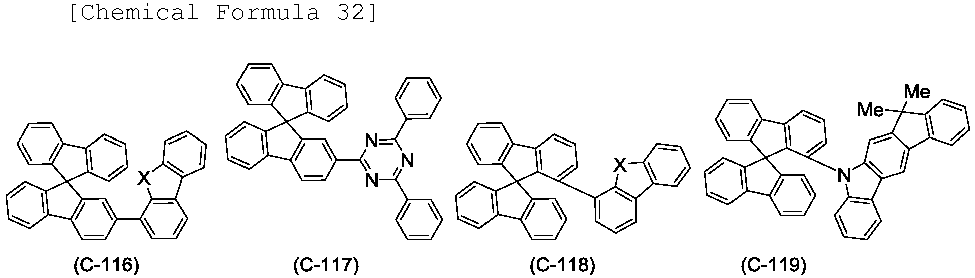 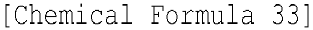 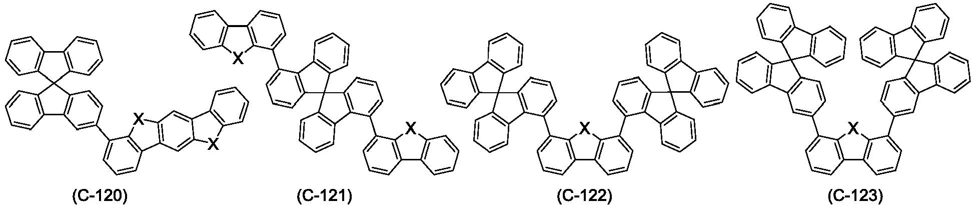 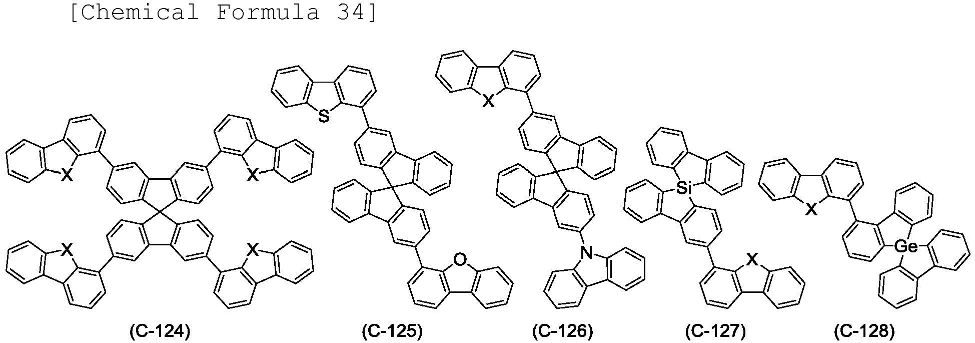 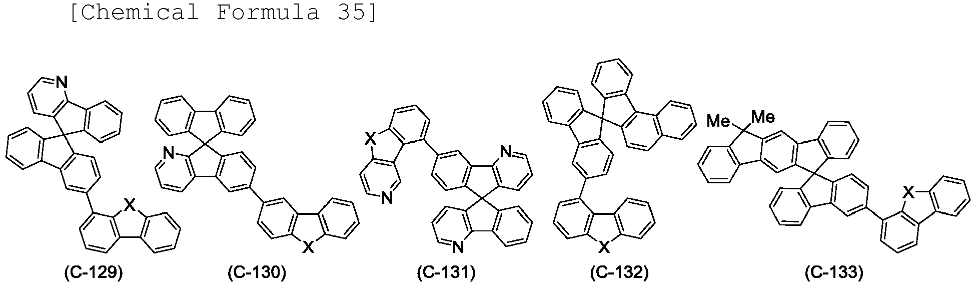 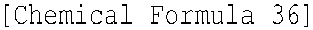 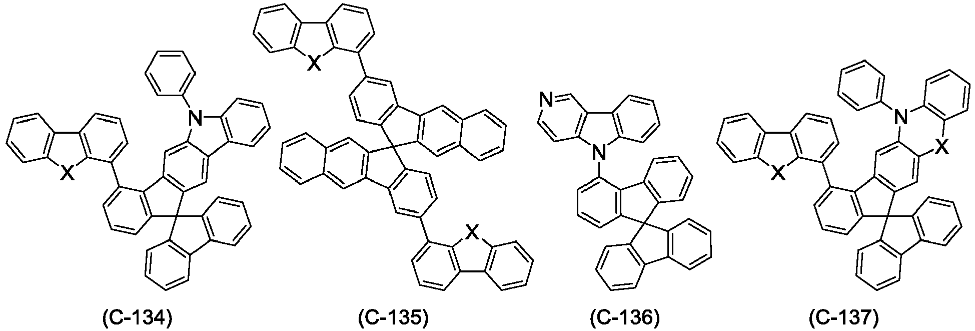 [wherein, X represents an oxygen atom or a sulfur atom. When a plurality of X are present, they may be the same or different.]

X is preferably a sulfur atom.

The compound represented by the formula (C-1) is available from, for example, Aldrich, Luminescence Technology Corp. The compound represented by the formula (C-1) can be synthesized according to methods described in, for example, International Publication WO 2014/023388, International Publication WO 2013/045408, International Publication WO 2013/045410, International Publication WO 2013/045411, International Publication WO 2012/048820, International Publication WO 2012/048819, International Publication WO 2011/006574 and "Organic Electronics vol. 14, 902-908 (2013)", as other means.

### Others

The first organic layer is preferably a layer containing a compound represented by the formula (C-1) and a phosphorescent compound, since the light emitting device of the present invention is more excellent in luminance life.

In the first organic layer, the compound represented by the formula (C-1) may be contained singly or in combination of two or more. When the first organic layer is a layer containing a compound represented by the formula (C-1) and a phosphorescent compound, the phosphorescent compound may be contained singly or in combination of two or more.

When the first organic layer is a layer containing a compound represented by the formula (C-1) and a phosphorescent compound, the content of the phosphorescent compound is usually 0.01 to 95 parts by mass, preferably 0.1 to 70 parts by mass, more preferably 1 to 50 parts by mass, further preferably 10 to 40 parts by mass, when the sum of the phosphorescent compound and the compound represented by the formula (C-1) is taken as 100 parts by mass.

When the first organic layer is a layer containing a compound represented by the formula (C-1) and a phosphorescent compound, the compound represented by the formula (C-1) is preferably a host material having at least one function selected from the group consisting of hole injectability, hole transportability, electron injectability and electron transportability, since the light emitting device of the present invention is more excellent in luminance life.

When the first organic layer is a layer containing a compound represented by the formula (C-1) and a phosphorescent compound, the lowest excited triplet state (T₁) of the compound represented by the formula (C-1) is preferably at energy level corresponding to that of the phosphorescent compound contained in the first organic layer or higher energy level than it, more preferably at higher energy level than it, since the light emitting device of the present invention is more excellent in luminance life.

The phosphorescent compound is preferably one that shows solubility in a solvent which is capable of dissolving a compound represented by the formula (C-1) contained in the first organic layer, since the light emitting device of the present invention can be fabricated by a solution application process.

"The phosphorescent compound" means usually a compound showing phosphorescence at room temperature (25°C), preferably a metal complex showing light emission from triplet excited state at room temperature. This metal complex showing light emission from triplet excited state has a central metal atom and a ligand.

The central metal atom includes, for example, metal atoms having an atomic number of 40 or more, having the spin-orbital interaction to the complex and capable of causing intersystem crossing between singlet state and triplet state. The metal atom includes, for example, a ruthenium atom, a rhodium atom, a palladium atom, an iridium atom and a platinum atom, and is preferably an iridium atom or a platinum atom, since the light emitting device of the present invention is more excellent in luminance life.

The ligand includes neutral or anionic monodentate ligands or neutral or anionic polydentate ligands forming at least one bond selected from the group consisting of a coordination bond and a covalent bond with a central metal atom. The bond between a central metal atom and a ligand includes, for example, a metal-nitrogen bond, a metal-carbon bond, a metal-oxygen bond, a metal-phosphorus bond, a metal-sulfur bond and a metal-halogen bond. The polydentate ligand means usually a bidentate or more and hexadentate or less ligand.

### Phosphorescent compound represented by the formula (1)

The phosphorescent compound is preferably a phosphorescent compound represented by the above-described formula (1).

M is preferably an iridium atom or a platinum atom, more preferably an iridium atom, since the light emitting device of the present invention is more excellent in luminance life.

When M is a ruthenium atom, a rhodium atom or an iridium atom, n¹ is preferably 2 or 3, more preferably 3.

When M is a palladium atom or a platinum atom, n¹ is preferably 2.

E¹ and E² are each preferably a carbon atom.

Ring L¹ is preferably a 5-membered aromatic hetero ring or a 6-membered aromatic hetero ring, more preferably a 5-membered aromatic hetero ring having two or more and four or less nitrogen atoms as a constituent atom or a 6-membered aromatic hetero ring having one or more and four or less nitrogen atoms as a constituent atom, further preferably a 5-membered aromatic hetero ring having two or more and three or less nitrogen atoms as a constituent atom or a 6-membered aromatic hetero ring having one or more and two or less nitrogen atoms as a constituent atom, and the foregoing rings optionally have a substituent. When Ring L¹ is a 6-membered aromatic hetero ring, E¹ is preferably a carbon atom.

Ring L¹ includes, for example, a diazole ring, a triazole ring, a pyridine ring, a diazabenzene ring, a triazine ring, an azanaphthalene ring and a diazanaphthalene ring, and is preferably a diazole ring, a triazole ring, a pyridine ring, a diazabenzene ring, a quinoline ring or an isoquinoline ring, more preferably a diazole ring, a triazole ring, a pyridine ring, a quinoline ring or an isoquinoline ring, further preferably a diazole ring, a triazole ring or a pyridine ring, particularly preferably a diazole ring or a pyridine ring, and the foregoing rings optionally have a substituent.

Ring L² is preferably a 5-membered or 6-membered aromatic hydrocarbon ring or a 5-membered or 6-membered aromatic hetero ring, more preferably a 6-membered aromatic hydrocarbon ring or a 6-membered aromatic hetero ring, further preferably a 6-membered aromatic hydrocarbon ring, and the foregoing rings optionally have a substituent. When Ring R² is a 6-membered aromatic hetero ring, E² is preferably a carbon atom.

Ring L² includes, for example, a benzene ring, a naphthalene ring, a fluorene ring, a phenanthrene ring, an indene ring, a pyridine ring, a diazabenzene ring and a triazine ring, and is preferably a benzene ring, a naphthalene ring, a fluorene ring, a pyridine ring or a diazabenzene ring, more preferably a benzene ring, a pyridine ring or a diazabenzene ring, further preferably a benzene ring, and the foregoing rings optionally have a substituent.

The substituent which Ring L¹ and Ring L² optionally have is preferably an alkyl group, a cycloalkyl group, an alkoxy group, a cycloalkoxy group, an aryl group, an aryloxy group, a monovalent heterocyclic group, a substituted amino group or a halogen atom, more preferably an alkyl group, a cycloalkyl group, an alkoxy group, a cycloalkoxy group, an aryl group, a monovalent heterocyclic group, a substituted amino group or a fluorine atom, further preferably an alkyl group, a cycloalkyl group, an aryl group, a monovalent heterocyclic group or a substituted amino group, particularly preferably an aryl group or a monovalent heterocyclic group, and the foregoing groups optionally further have a substituent.

The aryl group as the substituent which Ring L¹ and Ring L² optionally have is preferably a phenyl group, a naphthyl group, an anthracenyl group, a phenanthrenyl group, a dihydrophenanthrenyl group, a fluorenyl group or a pyrenyl group, more preferably a phenyl group, a naphthyl group or a fluorenyl group, further preferably a phenyl group, and the foregoing groups optionally further have a substituent.

The monovalent heterocyclic group as the substituent which Ring L¹ and Ring L² optionally have is preferably a pyridyl group, a pyrimidinyl group, a triazinyl group, a quinolinyl group, an isoquinolinyl group, a dibenzofuranyl group, a dibenzothienyl group, a carbazolyl group, an azacarbazolyl group, a diazacarbazolyl group, a phenoxazinyl group or a phenothiazinyl group, more preferably a pyridyl group, a pyrimidinyl group, a triazinyl group, a dibenzofuranyl group, a carbazolyl group, an azacarbazolyl group or a diazacarbazolyl group, further preferably a pyridyl group, a pyrimidinyl group or a triazinyl group, particularly preferably a triazinyl group, and the foregoing groups optionally further have a substituent.

In the substituted amino group as the substituent which Ring L¹ and Ring L² optionally have, the substituent which the amino group has is preferably an aryl group or a monovalent heterocyclic group, more preferably an aryl group, and the foregoing groups optionally further have a substituent. The examples and preferable range of the aryl group as the substituent which the amino group has are the same as the examples and preferable range of the aryl group as the substituent which Ring L¹ and Ring L² optionally have. The examples and preferable range of the monovalent heterocyclic group as the substituent which the amino group has are the same as the examples and preferable range of the monovalent heterocyclic group as the substituent which Ring L¹ and Ring L² optionally have.

The substituent which the substituent which Ring L¹ and Ring L² optionally have optionally further has is preferably an alkyl group, a cycloalkyl group, an aryl group, a monovalent heterocyclic group, an alkoxy group, a cycloalkoxy group or a substituted amino group, more preferably an alkyl group, a cycloalkyl group, an aryl group, a monovalent heterocyclic group or a substituted amino group, further preferably an alkyl group, a cycloalkyl group or an aryl group, particularly preferably an alkyl group or a cycloalkyl group, and the foregoing groups optionally further have a substituent, but it is preferable that these groups do not further have a substituent.

The examples and preferable range of the aryl group, the monovalent heterocyclic group and the substituted amino group as the substituent which the substituent which Ring L¹ and Ring L² optionally have optionally further has are the same as the examples and preferable range of the aryl group, the monovalent heterocyclic group and the substituted amino group as the substituent which Ring L¹ and Ring L² optionally have, respectively.

The aryl group, the monovalent heterocyclic group or the substituted amino group as the substituent which Ring L¹ and Ring L² optionally have is preferably a group represented by the formula (D-A), the formula (D-B) or the formula (D-C), more preferably a group represented by the formula (D-A) or the formula (D-C), since the light emitting device of the present invention is more excellent in luminance life. 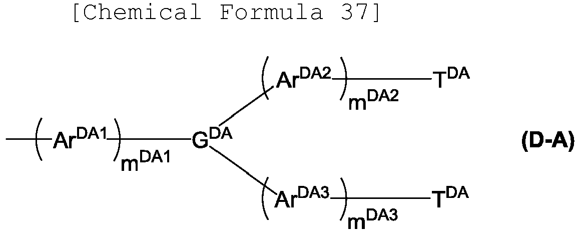 [wherein,
m^{DA1}, m^{DA2} and m^{DA3} each independently represent an integer of 0 or more.
G^{DA} represents a nitrogen atom, an aromatic hydrocarbon group or a heterocyclic group, and the foregoing groups optionally have a substituent.
Ar^{DA1}, Ar^{DA2} and Ar^{DA3} each independently represent an arylene group or a divalent heterocyclic group, and the foregoing groups optionally have a substituent. When a plurality of Ar^{DA1}, Ar^{DA2} and Ar^{DA3} are present, they may be the same or different at each occurrence.
T^{DA} represents an aryl group or a monovalent heterocyclic group, and the foregoing groups optionally have a substituent. A plurality of T^{DA} may be the same or different.] 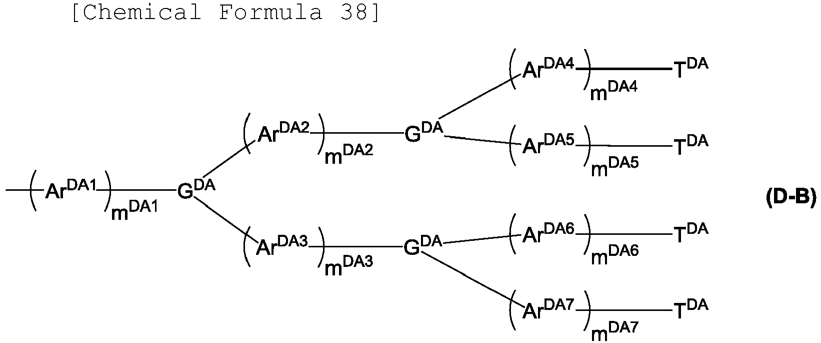
[wherein,
m^{DA1}, m^{DA2}, m^{DA3}, m^{DA4}, m^{DA5}, m^{DA6} and m^{DA7} each independently represent an integer of 0 or more.
G^{DA} represents a nitrogen atom, an aromatic hydrocarbon group or a heterocyclic group, and the foregoing groups optionally have a substituent. A plurality of G^{DA} may be the same or different.
Ar^{DA1}, Ar^{DA2}, Ar^{DA3}, Ar^{DA4}, Ar^{DA5}, Ar^{DA6} and Ar^{DA7} each independently represent an arylene group or a divalent heterocyclic group, and the foregoing groups optionally have a substituent. When a plurality of Ar^{DA1}, Ar^{DA2}, Ar^{DA3}, Ar^{DA4}, Ar^{DA5}, Ar^{DA6} and Ar^{DA7} are present, they may be the same or different at each occurrence.
T^{DA} represents an aryl group or a monovalent heterocyclic group, and the foregoing groups optionally have a substituent. A plurality of T^{DA} may be the same or different.] 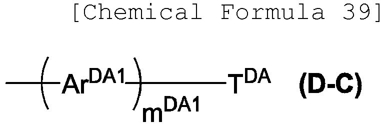
[wherein,
m^{DA1} represents an integer of 0 or more.
Ar^{DA1} represents an arylene group or a divalent heterocyclic group, and the foregoing groups optionally have a substituent. When a plurality of Ar^{DA1} are present, they may be the same or different.
T^{DA} represents an aryl group or a monovalent heterocyclic group, and the foregoing groups optionally have a substituent.]

m^{DA1}, m^{DA2}, m^{DA3}, m^{DA4}, m^{DA5}, m^{DA6} and m^{DA7} are each usually an integer of 10 or less, preferably an integer of 5 or less, more preferably an integer of 2 or less, further preferably 0 or 1. It is preferable that m^{DA2}, m^{DA3}, m^{DA4}, m^{DA5}, m^{DA6} and m^{DA7} are the same integer, and it is more preferable that m^{DA1}, m^{DA2}, m^{DA3}, m^{DA4}, m^{DA5}, m^{DA6} and m^{DA7} are the same integer.

G^{DA} is preferably an aromatic hydrocarbon group or a heterocyclic group, more preferably a group obtained by removing from a benzene ring, a pyridine ring, a pyrimidine ring, a triazine ring or a carbazole ring three hydrogen atoms directly bonding to carbon atoms or nitrogen atoms constituting the ring, and the foregoing groups optionally have a substituent.

The substituent which G^{DA} optionally has is preferably an alkyl group, a cycloalkyl group, an alkoxy group, a cycloalkoxy group, an aryl group or a monovalent heterocyclic group, more preferably an alkyl group, a cycloalkyl group, an alkoxy group or a cycloalkoxy group, further preferably an alkyl group or a cycloalkyl group, and the foregoing groups optionally further have a substituent, but it is preferable that these groups do not further have a substituent.

G^{DA} is preferably a group represented by the formula (GDA-11) to the formula (GDA-15), more preferably a group represented by the formula (GDA-11) to the formula (GDA-14), further preferably a group represented by the formula (GDA-11) or the formula (GDA-14). 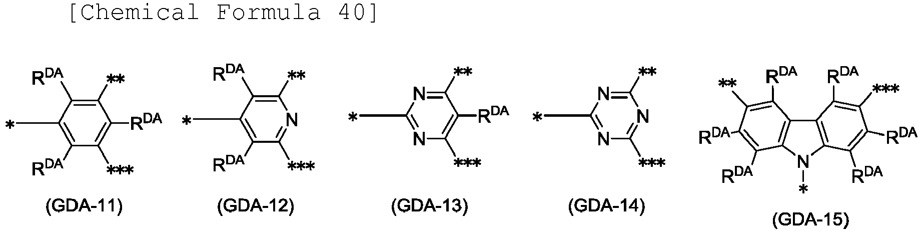 [wherein,
* represents a bond to Ar^{DA1} in the formula (D-A), to Ar^{DA1} in the formula (D-B), to Ar^{DA2} in the formula (D-B) or to Ar^{DA3} in the formula (D-B).
** represents a bond to Ar^{DA2} in the formula (D-A), to Ar^{DA2} in the formula (D-B), to Ar^{DA4} in the formula (D-B) or to Ar^{DA6} in the formula (D-B).
*** represents a bond to Ar^{DA3} in the formula (D-A), to Ar^{DA3} in the formula (D-B), to Ar^{DA5} in the formula (D-B) or to Ar^{DA7} in the formula (D-B).
R^{DA} represents a hydrogen atom, an alkyl group, a cycloalkyl group, an alkoxy group, a cycloalkoxy group, an aryl group or a monovalent heterocyclic group, and the foregoing groups optionally further have a substituent. When a plurality of R^{DA} are present, they may be the same or different.]

R^{DA} is preferably a hydrogen atom, an alkyl group, a cycloalkyl group, an alkoxy group or a cycloalkoxy group, more preferably a hydrogen atom, an alkyl group or a cycloalkyl group, and the foregoing groups optionally have a substituent.

Ar^{DA1}, Ar^{DA2}, Ar^{DA3}, Ar^{DA4}, Ar^{DA5}, Ar^{DA6} and Ar^{DA7} are each preferably a phenylene group, a fluorenediyl group or a carbazolediyl group, more preferably a group represented by the formula (ArDA-1) to the formula (ArDA-5), further preferably a group represented by the formula (ArDA-1) to the formula (ArDA-3), particularly preferably a group represented by the formula (ArDA-1) or the formula (ArDA-2), especially preferably a group represented by the formula (ArDA-1), and the foregoing groups optionally have a substituent. 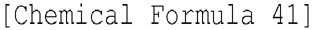 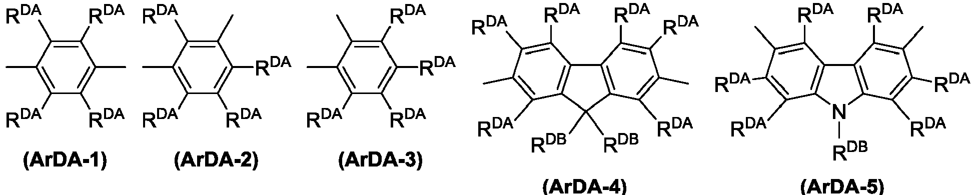 [wherein,
R^{DA} represents the same meaning as described above.
R^{DB} represents a hydrogen atom, an alkyl group, a cycloalkyl group, an aryl group or a monovalent heterocyclic group, and the foregoing groups optionally have a substituent. When a plurality of R^{DB} are present, they may be the same or different.]

R^{DB} is preferably an alkyl group, a cycloalkyl group, an aryl group or a monovalent heterocyclic group, more preferably an aryl group or a monovalent heterocyclic group, further preferably an aryl group, and the foregoing groups optionally have a substituent.

The examples and preferable ranges of the substituent which Ar^{DA1}, Ar^{DA2}, Ar^{DA3}, Ar^{DA4}, Ar^{DA3}, Ar^{DA6}, Ar^{DA7} and R^{DB} optionally have are the same as the examples and preferable ranges of the substituent which G^{DA} optionally has.

T^{DA} is preferably a group represented by the formula (TDA-1) to the formula (TDA-3), more preferably a group represented by the formula (TDA-1). 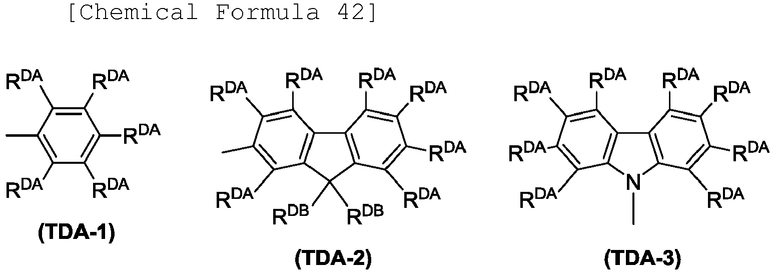 [wherein, R^{DA} and R^{DB} represent the same meaning as described above.]

The group represented by the formula (D-A) is preferably a group represented by the formula (D-A1) to the formula (D-A5), more preferably a group represented by the formula (D-A1) or the formula (D-A3) to the formula (D-A5), further preferably a group represented by the formula (D-A1) or the formula (D-A3). 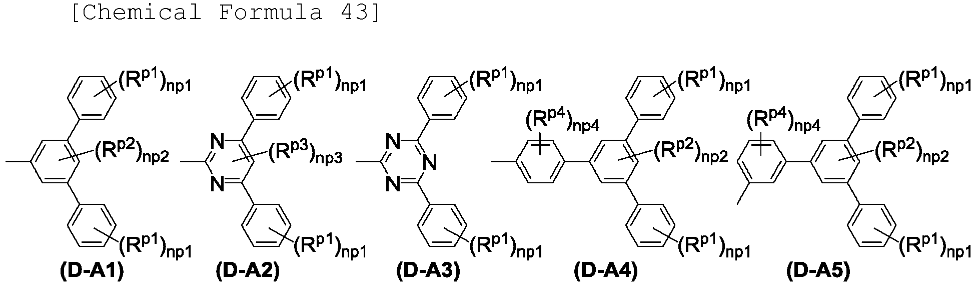 [wherein,
R^{p1}, R^{p2}, R^{p3} and R^{p4} each independently represent an alkyl group, a cycloalkyl group, an alkoxy group, a cycloalkoxy group or a halogen atom. When a plurality of R^{p1}, R^{p2} and R^{p4} are present, they may be the same or different at each occurrence.
np1 represents an integer of 0 to 5, np2 represents an integer of 0 to 3, np3 represents 0 or 1, and np4 represents an integer of 0 to 4. A plurality of np1 may be the same or different.]

The group represented by the formula (D-B) is preferably a group represented by the formula (D-B1) to the formula (D-B6), more preferably a group represented by the formula (D-B1) to the formula (D-B3) or the formula (D-B5), further preferably a group represented by the formula (D-B1) or the formula (D-B5). 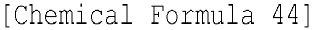 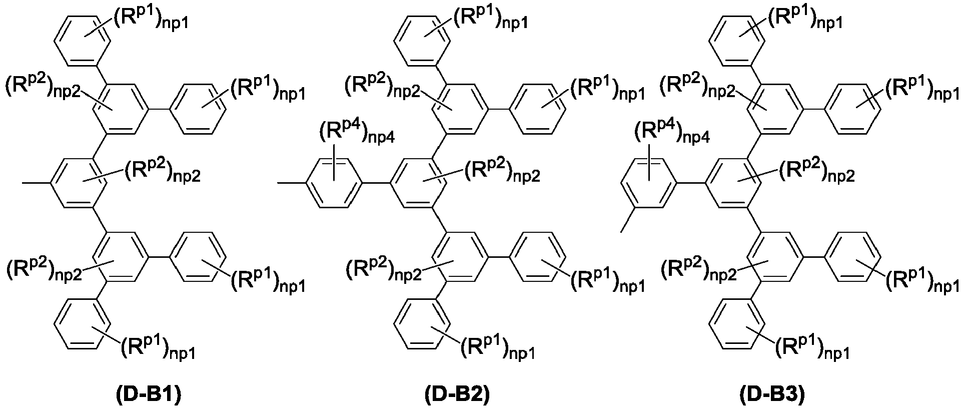 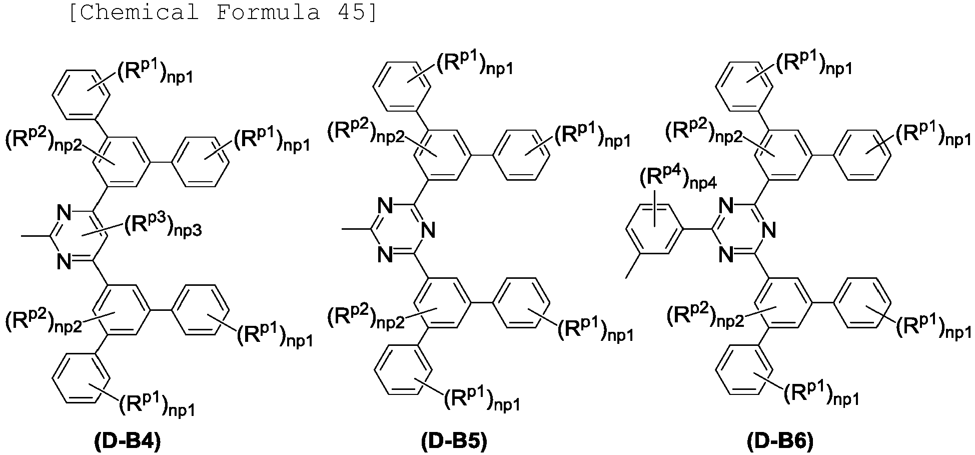 [wherein,
R^{p1}, R^{p2}, R^{p3} and R^{p4} each independently represent an alkyl group, a cycloalkyl group, an alkoxy group, a cycloalkoxy group or a halogen atom. When a plurality of R^{p1}, R^{p2} and R^{p4} are present, they may be the same or different at each occurrence.
np1 represents an integer of 0 to 5, np2 represents an integer of 0 to 3, np3 represents 0 or 1, and np4 represents an integer of 0 to 4. A plurality of np1 may be the same or different. A plurality of np2 may be the same or different.]

The group represented by the formula (D-C) is preferably a group represented by the formula (D-C1) to the formula (D-C4), more preferably a group represented by the formula (D-C1) or the formula (D-C2), further preferably a group represented by the formula (D-C2). 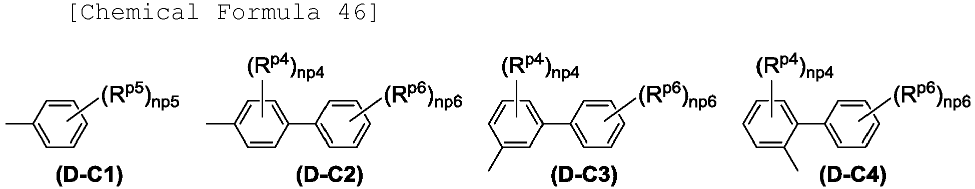 [wherein,
R^{p4}, R^{p5} and R^{p6} each independently represent an alkyl group, a cycloalkyl group, an alkoxy group, a cycloalkoxy group or a halogen atom. When a plurality of RP4, R^{p5} and R^{p6} are present, they may be the same or different at each occurrence.
np4 represents an integer of 0 to 4, np5 represents an integer of 0 to 5, and np6 represents an integer of 0 to 5.]

np1 is preferably an integer of 0 to 2, more preferably 0 or 1. np2 is preferably 0 or 1, more preferably 0. np3 is preferably 0. np4 is preferably an integer of 0 to 2, more preferably 0. np5 is preferably an integer of 0 to 3, more preferably 0 or 1. np6 is preferably an integer of 0 to 2, more preferably 0 or 1.

The alkyl group or the cycloalkyl group represented by R^{p1}, R^{p2}, R^{p3}, R^{p4}, R^{p5} and R^{p6} is preferably a methyl group, an ethyl group, an isopropyl group, a tert-butyl group, a hexyl group, a 2-ethylhexyl group, a cyclohexyl group or a tert-octyl group.

The alkoxy group or the cycloalkoxy group represented by R^{p1}, R^{p2}, R^{p3}, R^{p4}, R^{p5} and R^{p6} is preferably a methoxy group, a 2-ethylhexyloxy group or a cyclohexyloxy group.

R^{p1}, R^{p2}, R^{p3}, R^{p4}, R^{p5} and R^{p6} are each preferably an alkyl group optionally having a substituent or a cycloalkyl group optionally having a substituent, more preferably an alkyl group optionally having a substituent, further preferably a methyl group, an ethyl group, an isopropyl group, a tert-butyl group, a hexyl group, a 2-ethylhexyl group or a tert-octyl group.

When a plurality of the substituents which Ring L¹ optionally has are present, it is preferable that they are not combined together to form a ring together with the atoms to which they are attached.

When a plurality of the substituents which Ring L² optionally has are present, it is preferable that they are not combined together to form a ring together with the atoms to which they are attached.

It is preferable that the substituent which Ring L¹ optionally has and the substituent which Ring L² optionally has are not combined together to form a ring together with the atoms to which they are attached.

### [Anionic bidentate ligand]

The anionic bidentate ligand represented by A¹-G¹-A² includes, for example, ligands represented by the following formulae. However, the anionic bidentate ligand represented by A¹-G¹-A² is different from a ligand of which number is defined by subscript n¹. 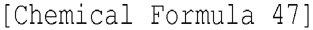 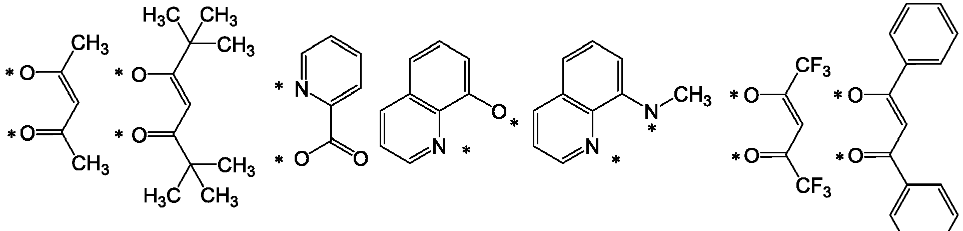 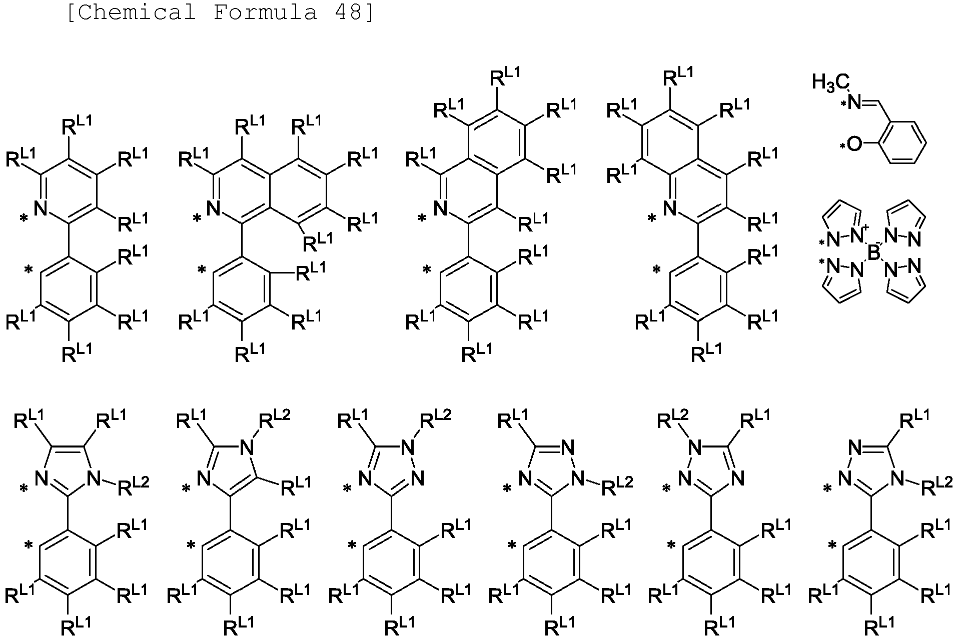 [wherein,
* represents a site binding to M.
R^{L1} represents a hydrogen atom, an alkyl group, a cycloalkyl group, an aryl group, a monovalent heterocyclic group or a halogen atom, and the foregoing groups optionally have a substituent. A plurality of R^{L1} may be the same or different.
R^{L2} represents an alkyl group, a cycloalkyl group, an aryl group, a monovalent heterocyclic group or a halogen atom, and the foregoing groups optionally have a substituent.]

R^{L1} is preferably a hydrogen atom, an alkyl group, a cycloalkyl group, an aryl group or a fluorine atom, more preferably a hydrogen atom or an alkyl group, and the foregoing groups optionally have a substituent.

R^{L2} is preferably an alkyl group or an aryl group, and the foregoing groups optionally have a substituent.

The phosphorescent compound represented by the formula (1) is preferably a phosphorescent compound represented by the formula (1-A) or a phosphorescent compound represented by the formula (1-B), since the light emitting device of the present invention is more excellent in luminance life. 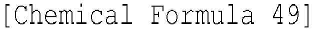 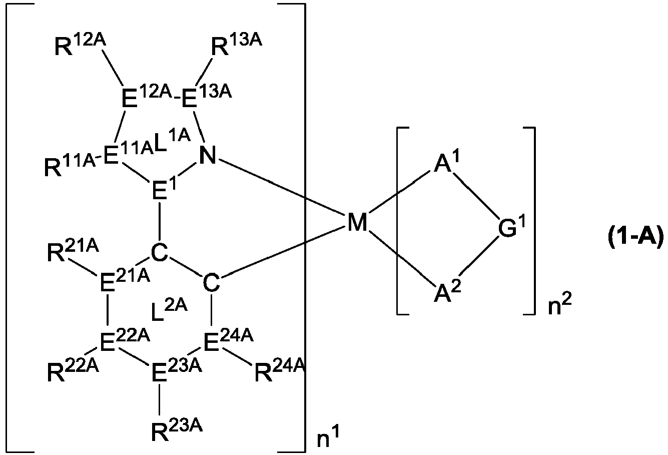 [wherein,
M, n¹, n², E¹ and A¹-G¹-A² represent the same meaning as described above.
E^{11A}, E^{12A}, E^{13A}, E^{21A}, E^{22A}, E^{23A} and E^{24A} each independently represent a nitrogen atom or a carbon atom. When a plurality of E^{11A}, E^{12A}, E^{13A}, E^{21A}, E^{22A}, E^{23A} and E^{24A} are present, they may be the same or different at each occurrence. When E^{11A} is a nitrogen atom, R^{11A} may be present or absent. When E^{12A} is a nitrogen atom, R^{12A} may be present or absent. When E^{13A} is a nitrogen atom, R^{13A} may be present or absent. When E^{21A} is a nitrogen atom, R^{21A} is absent. When E^{22A} is a nitrogen atom, R^{22A} is absent. When E^{23A} is a nitrogen atom, R^{23A} is absent. When E^{24A} is a nitrogen atom, R^{24A} is absent.
R^{11A}, R^{12A}, R^{13A}, R^{21A}, R^{22A}, R^{23A} and R^{24A} each independently represent a hydrogen atom, an alkyl group, a cycloalkyl group, an alkoxy group, a cycloalkoxy group, an aryl group, an aryloxy group, a monovalent heterocyclic group, a substituted amino group or a halogen atom, and the foregoing groups optionally have a substituent. When a plurality of R^{11A}, R^{12A}, R^{13A}, R^{21A}, R^{22A}, R^{23A} and R^{24A} are present, they may be the same or different at each occurrence. R^{11A} and R^{12A}, R^{12A} and R^{13A}, R^{11A} and R^{21A}, R^{21A} and R^{22A}, R^{22A} and R^{23A}, and R^{23A} and R^{24A} may each be combined together to form a ring together with the atoms to which they are attached.
Ring L^{1A} represents a triazole ring or a diazole ring.
Ring L^{2A} represents a benzene ring, a pyridine ring or a diazabenzene ring.]

When Ring L^{1A} is a diazole ring, an imidazole ring in which E^{11A} is a nitrogen atom or an imidazole ring in which E^{12A} is a nitrogen atom is preferable, an imidazole ring in which E^{11A} is a nitrogen atom is more preferable.

When Ring L^{1A} is a triazole ring, a triazole ring in which E^{11A} and E^{12A} are each a nitrogen atom or a triazole ring in which E^{11A} and E^{13A} are each a nitrogen atom is preferable, a triazole ring in which E^{11A} and E^{13A} are each a nitrogen atom is more preferable.

Ring L^{1A} is preferably a diazole ring.

The examples and preferable range of the aryl group, the monovalent heterocyclic group and the substituted amino group represented by R^{11A}, R^{12A}, R^{13A}, R^{21A}, R^{22A}, R^{23A} and R^{24A} are the same as the examples and preferable range of the aryl group, the monovalent heterocyclic group and the substituted amino group as the substituent which Ring L¹ and Ring L² optionally have, respectively.

The examples and preferable range of the substituent which R^{11A}, R^{12A}, R^{13A}, R^{21A}, R^{22A}, R^{23A} and R^{24A} optionally have are the same as the examples and preferable range of the substituent which the substituent which Ring L¹ and Ring L² optionally have optionally further has.

When E^{11A} is a nitrogen atom and R^{11A} is present, R^{11A} is preferably an alkyl group, a cycloalkyl group, an aryl group or a monovalent heterocyclic group, more preferably an aryl group or a monovalent heterocyclic group, further preferably an aryl group, and the foregoing groups optionally have a substituent.

When E^{11A} is a carbon atom, R^{11A} is preferably a hydrogen atom, an alkyl group, a cycloalkyl group, an aryl group, a monovalent heterocyclic group or a substituted amino group, more preferably a hydrogen atom, an alkyl group, a cycloalkyl group or an aryl group, further preferably a hydrogen atom, an alkyl group or a cycloalkyl group, particularly preferably a hydrogen atom, and the foregoing groups optionally have a substituent.

When E^{12A} is a nitrogen atom and R^{12A} is present, R^{12A} is preferably an alkyl group, a cycloalkyl group, an aryl group or a monovalent heterocyclic group, more preferably an aryl group or a monovalent heterocyclic group, further preferably an aryl group, and the foregoing groups optionally have a substituent.

When E^{12A} is a carbon atom, R^{12A} is preferably a hydrogen atom, an alkyl group, a cycloalkyl group, an aryl group, a monovalent heterocyclic group or a substituted amino group, more preferably a hydrogen atom, an alkyl group, a cycloalkyl group or an aryl group, further preferably a hydrogen atom, an alkyl group or a cycloalkyl group, particularly preferably a hydrogen atom, and the foregoing groups optionally have a substituent.

When E^{13A} is a nitrogen atom and R^{13A} is present, R^{13A} is preferably an alkyl group, a cycloalkyl group, an aryl group or a monovalent heterocyclic group, more preferably an aryl group or a monovalent heterocyclic group, further preferably an aryl group, and the foregoing groups optionally have a substituent.

When E^{13A} is a carbon atom, R^{13A} is preferably a hydrogen atom, an alkyl group, a cycloalkyl group, an aryl group, a monovalent heterocyclic group or a substituted amino group, more preferably a hydrogen atom, an alkyl group, a cycloalkyl group or an aryl group, further preferably a hydrogen atom, an alkyl group or a cycloalkyl group, particularly preferably a hydrogen atom, and the foregoing groups optionally have a substituent.

When Ring L^{1A} is a diazole ring, Ring L^{1A} is preferably an imidazole ring in which E^{11A} is a nitrogen atom and R^{11A} is present or an imidazole ring in which E^{12A} is a nitrogen atom and R^{12A} is present, more preferably an imidazole ring in which E^{11A} is a nitrogen atom and R^{11A} is present.

When Ring L^{1A} is a triazole ring, Ring L^{1A} is preferably a triazole ring in which E^{11A} and E^{12A} are each a nitrogen atom and R^{11A} is present and R^{12A} is absent or a triazole ring in which E^{11A} and E^{13A} are each a nitrogen atom and R^{11A} is present and R^{13A} is absent, more preferably a triazole ring in which E^{11A} and E^{13A} are a nitrogen atom and R^{11A} is present and R^{13A} is absent.

When Ring L^{1A} is a triazole ring, two of R^{11A}, R^{12A} and R^{13A} are each preferably an alkyl group, a cycloalkyl group, an aryl group or a monovalent heterocyclic group, more preferably an alkyl group or an aryl group, and the foregoing groups optionally have a substituent.

When Ring L^{2A} is a pyridine ring, Ring L^{2A} is preferably a pyridine ring in which E^{21A} is a nitrogen atom, a pyridine ring in which E^{22A} is a nitrogen atom or a pyridine ring in which E^{23A} is a nitrogen atom, more preferably a pyridine ring in which E^{22A} is a nitrogen atom.

When Ring L^{2A} is a diazabenzene ring, Ring L^{2A} is preferably a pyrimidine ring in which E^{22A} and E^{24A} are each a nitrogen atom or a pyrimidine ring in which E^{22A} and E^{24A} are each a nitrogen atom, more preferably a pyrimidine ring in which E^{22A} and E^{24A} are each a nitrogen atom.

Ring L^{2A} is preferably a benzene ring.

R^{21A}, R^{22A}, R^{23A} and R^{24A} are each preferably a hydrogen atom, an alkyl group, a cycloalkyl group, an alkoxy group, a cycloalkoxy group, an aryl group, a monovalent heterocyclic group, a substituted amino group or a fluorine atom, more preferably a hydrogen atom, an alkyl group, a cycloalkyl group, an aryl group, a monovalent heterocyclic group or a substituted amino group, further preferably a hydrogen atom, an alkyl group or a group represented by the formula (D-A), the formula (D-B) or the formula (D-C), particularly preferably a hydrogen atom or a group represented by the formula (D-A), especially preferably a hydrogen atom, and the foregoing groups optionally have a substituent.

When Ring L^{2A} has an aryl group, a monovalent heterocyclic group or a substituted amino group, it is preferable that R^{22A} or R^{23A} is an aryl group, a monovalent heterocyclic group or a substituted amino group, it is more preferable that R^{22A} is an aryl group, a monovalent heterocyclic group or a substituted amino group.

It is preferable that R^{11A} and R^{12A}, R^{12A} and R^{13A}, R^{11A} and R^{21A}, R^{21A} and R^{22A}, R^{22A} and R^{23A}, and R^{23A} and R^{24A} are not each combined together to form a ring together with the atoms to which they are attached.

The phosphorescent compound represented by the formula (1-A) is preferably a phosphorescent compound represented by the formula (1-A1) to the formula (1-A5), more preferably a phosphorescent compound represented by the formula (1-A1), the formula (1-A3) or the formula (1-A4), further preferably a phosphorescent compound represented by the formula (1-A3) or the formula (1-A4), particularly preferably a phosphorescent compound represented by the formula (1-A4), since the light emitting device of the present invention is further excellent in luminance life. 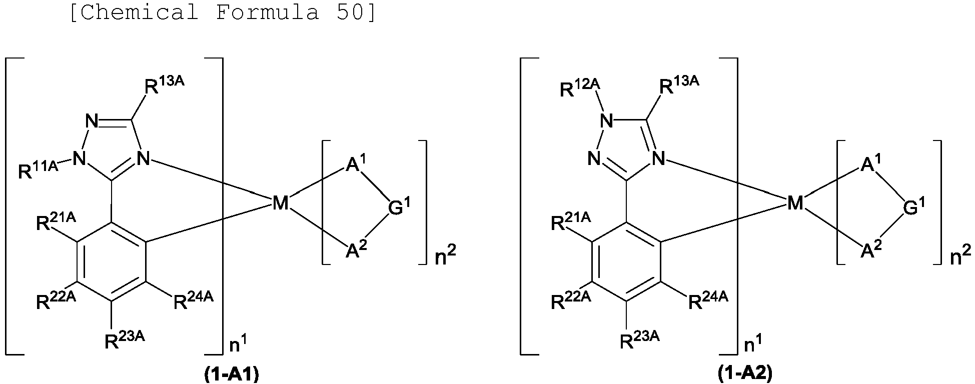 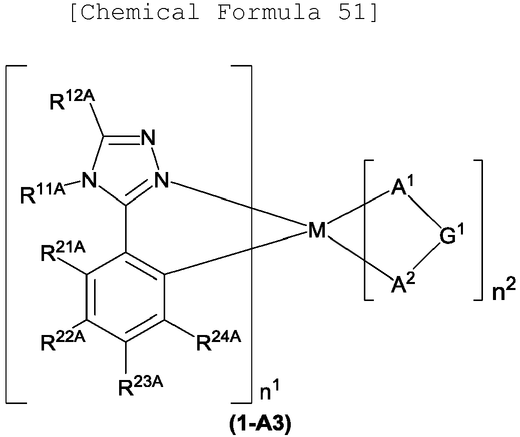 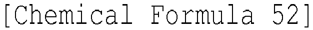 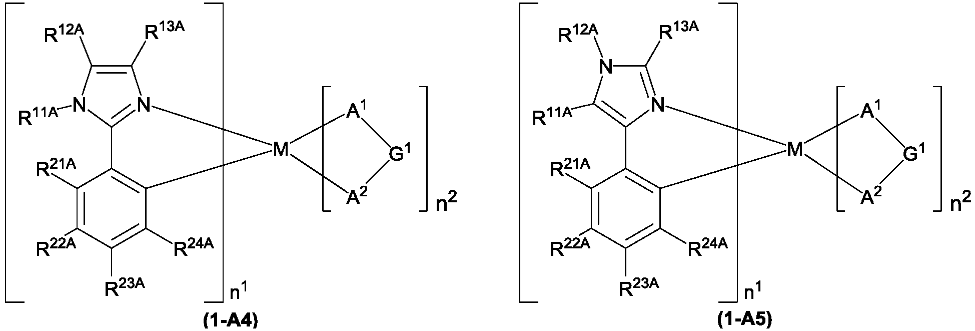 [wherein, M, n¹, n², R^{11A}, R^{12A}, R^{13A}, R^{21A}, R^{22A}, R^{23A}, R^{24A} and A¹-G¹-A² represent the same meaning as described above.]

### [Phosphorescent compound represented by the formula (1-B)]

When Ring L^{1B} is a diazabenzene ring, Ring L^{1B} is preferably a pyrimidine ring in which E^{11B} is a nitrogen atom or a pyrimidine ring in which E^{13B} is a nitrogen atom, more preferably a pyrimidine ring in which E^{11B} is a nitrogen atom.

Ring L^{1B} is preferably a pyridine ring.

When Ring L^{2B} is a pyridine ring, Ring L^{2B} is preferably a pyridine ring in which E^{21B} is a nitrogen atom, a pyridine ring in which E^{22B} is a nitrogen atom or a pyridine ring in which E^{23B} is a nitrogen atom, more preferably a pyridine ring in which E^{22B} is a nitrogen atom.

When Ring L^{2B} is a diazabenzene ring, Ring L^{2B} is preferably a pyrimidine ring in which E^{22B} and E^{24B} are each a nitrogen atom or a pyrimidine ring in which E^{21B} and E^{23B} are each a nitrogen atom, more preferably a pyrimidine ring in which E^{22B} and E^{24B} are each a nitrogen atom.

Ring L^{2B} is preferably a benzene ring.

The examples and preferable range of the aryl group, the monovalent heterocyclic group and the substituted amino group represented by R^{11B}, R^{12B}, R^{13B}, R^{14B}, R^{21B}, R^{22B}, R^{23B} and R^{24B} are the same as the examples and preferable range of the aryl group, the monovalent heterocyclic group and the substituted amino group as the substituent which Ring L¹ and Ring L² optionally have, respectively.

The examples and preferable range of the substituent which R^{11B}, R^{12B}, R^{13B}, R^{14B}, R^{21B}, R^{22B}, R^{23B} and R^{24B} optionally have are the same as the examples and preferable range of the substituent which the substituent which Ring L¹ and Ring L² optionally have optionally further has.

R^{11B}, R^{12B}, R^{13B}, R^{14B}, R^{21B}, R^{22B}, R^{23B} and R^{24B} are each preferably a hydrogen atom, an alkyl group, a cycloalkyl group, an alkoxy group, a cycloalkoxy group, an aryl group, an alkenyl group, a monovalent heterocyclic group, a substituted amino group or a fluorine atom, more preferably a hydrogen atom, an alkyl group, a cycloalkyl group, an aryl group, an alkenyl group, a monovalent heterocyclic group or a substituted amino group, further preferably a hydrogen atom, an alkyl group or a group represented by the formula (D-A), the formula (D-B) or the formula (D-C), particularly preferably a hydrogen atom or a group represented by the formula (D-A), and the foregoing groups optionally have a substituent.

When Ring L^{1B} has an aryl group, a monovalent heterocyclic group or a substituted amino group, it is preferable that R^{11B}, R^{12B} or R^{13B} is an aryl group, a monovalent heterocyclic group or a substituted amino group, it is more preferable that R^{12B} or R^{13B} is an aryl group, a monovalent heterocyclic group or a substituted amino group, it is further preferable that R^{13B} is an aryl group, a monovalent heterocyclic group or a substituted amino group.

When Ring L^{2B} has an aryl group, a monovalent heterocyclic group or a substituted amino group, it is preferable that R^{22B} or R^{23B} is an aryl group, a monovalent heterocyclic group or a substituted amino group, it is more preferable that R^{22B} is an aryl group, a monovalent heterocyclic group or a substituted amino group.

The phosphorescent compound represented by the formula (1-B) is preferably a phosphorescent compound represented by the formula (1-B1) to the formula (1-B5), more preferably a phosphorescent compound represented by the formula (1-B1) to the formula (1-B3), further preferably a phosphorescent compound represented by the formula (1-B1) or a phosphorescent compound represented by the formula (1-B2), particularly preferably a phosphorescent compound represented by the formula (1-B1), since the light emitting device of the present invention is further excellent in luminance life.

The examples and preferable range of the aryl group, the monovalent heterocyclic group and the substituted amino group represented by R^{15B}, R^{16B}, R^{17B} and R^{18B} are the same as the examples and preferable range of the aryl group, the monovalent heterocyclic group and the substituted amino group as the substituent which Ring L¹ and Ring L² optionally have, respectively.

The examples and preferable range of the substituent which R^{15B}, R^{16B}, R^{17B} and R^{18B} optionally have are the same as the examples and preferable range of the substituent which the substituent which Ring L¹ and Ring L² optionally have optionally further has.

R^{15B}, R^{16B}, R^{17B} and R^{18B} are each preferably a hydrogen atom, an alkyl group, a cycloalkyl group, an alkoxy group, a cycloalkoxy group, a fluorine atom, an aryl group, an alkenyl group, a monovalent heterocyclic group or a substituted amino group, more preferably a hydrogen atom, an alkyl group, a cycloalkyl group, an aryl group, a monovalent heterocyclic group or a substituted amino group, further preferably a hydrogen atom, an alkyl group or a cycloalkyl group, particularly preferably a hydrogen atom, and the foregoing groups optionally have a substituent.

The phosphorescent compound includes, for example, phosphorescent compounds represented by the following formulae.

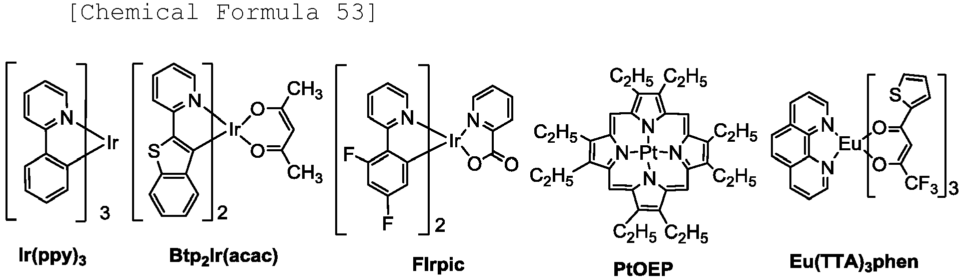

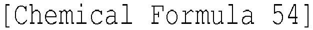

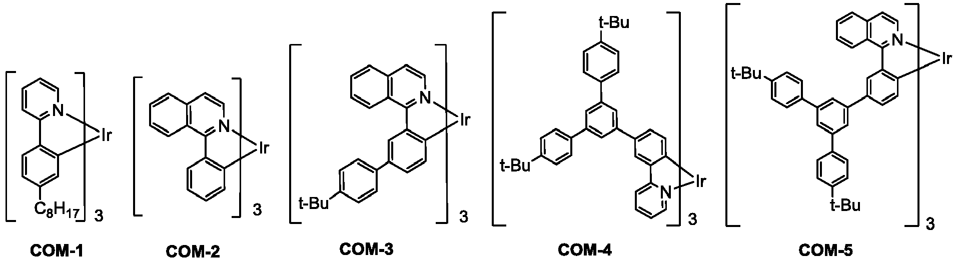

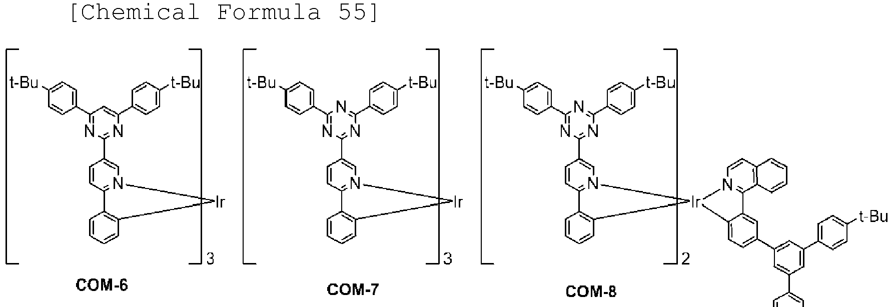

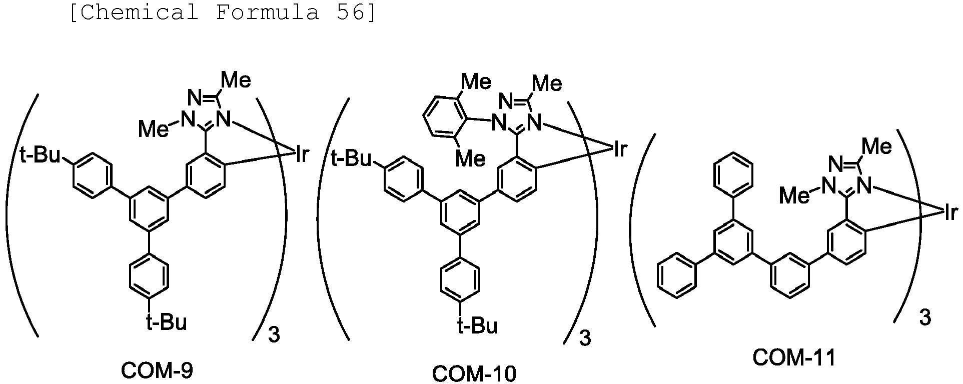

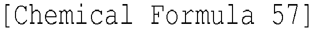

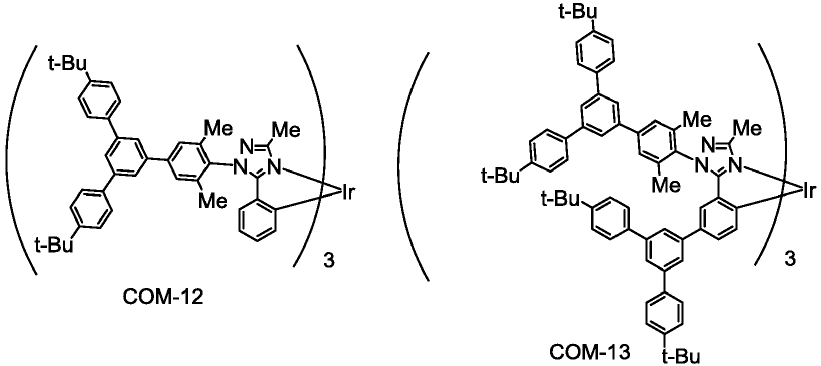

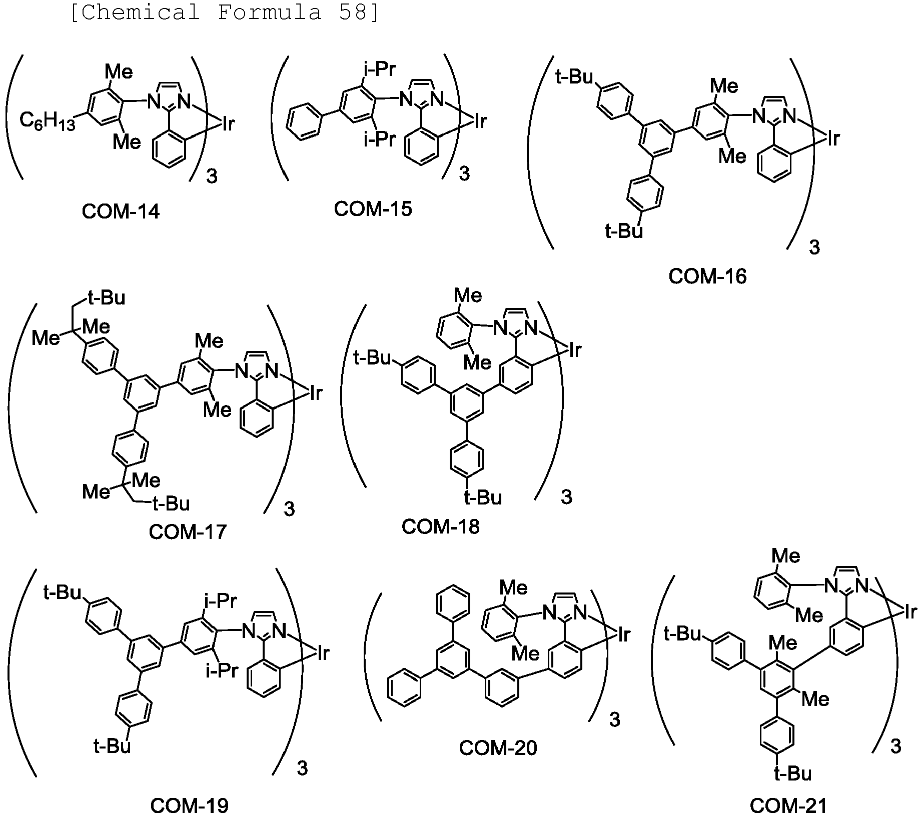

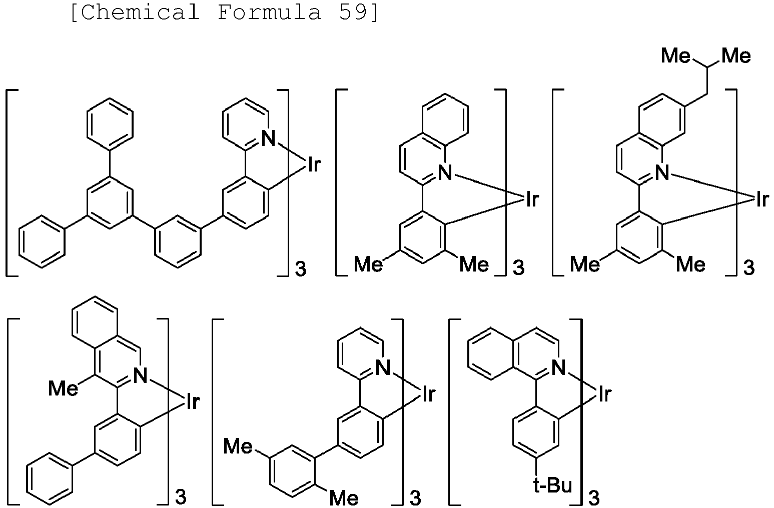

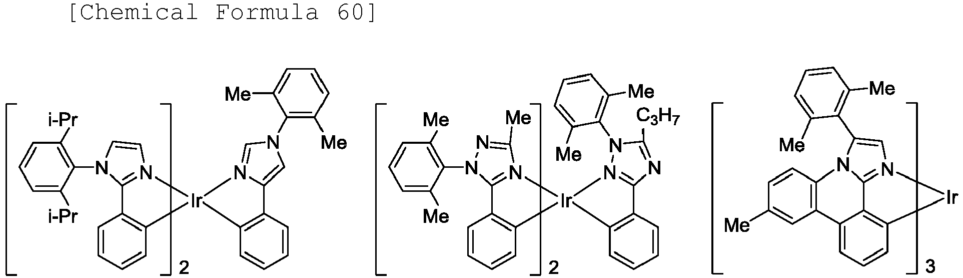

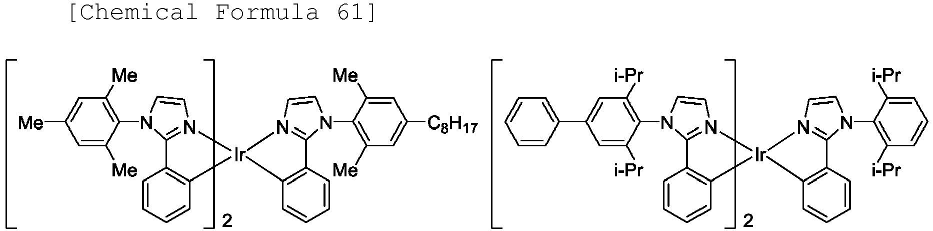

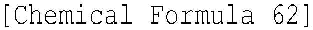

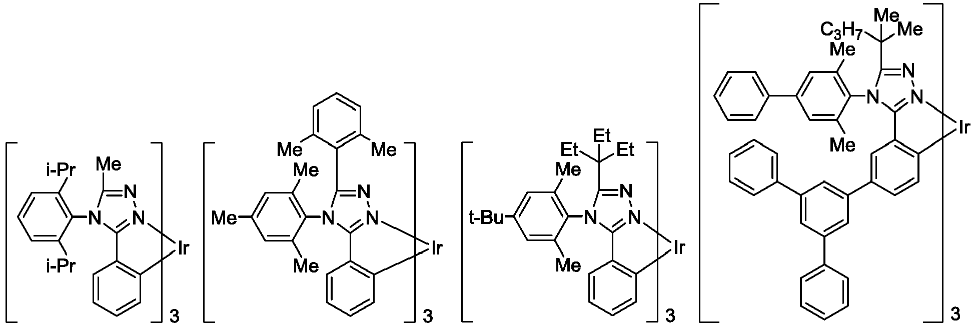

The phosphorescent compound is available from, for example, Aldrich, Luminescence Technology Corp. and American Dye Source.

Further, the phosphorescent compound can also be produced by known methods described in literatures such as Journal of the American Chemical Society, vol. 107, 1431-1432 (1985), Journal of the American Chemical Society, vol. 106, 6647-6653 (1984), International Publication WO 2011/024761, International Publication WO 2002/44189, Japanese Unexamined Patent Application Publication (JP-A) No. 2006-188673 and the like.

### [First composition]

The first organic layer may be a layer containing a composition (hereinafter, referred to also as "first composition") containing a compound represented by the formula (C-1) and at least one material selected from the group consisting of the phosphorescent compound described above, the hole transporting material, the hole injection material, the electron transporting material, the electron injection material, the light emitting material and the antioxidant. The hole transporting material, the hole injection material, the electron transporting material and the electron injection material contained in the first composition are different from the compound represented by the formula (C-1), and the light emitting material contained in the first composition is different from the compound represented by the formula (C-1) and different from the phosphorescent compound.

### Hole transporting material

The hole transporting material is classified into low molecular compounds and polymer compounds, and preferable are polymer compounds. The hole transporting material may have a crosslinking group.

The polymer compound includes, for example, polyvinylcarbazole, and derivatives thereof; polyarylenes having an aromatic amine structure in the side chain or main chain, and derivatives thereof. The polymer compound may also be a compound to which an electron accepting site is bound. The electron accepting site includes, for example, fullerene, tetrafluorotetracyanoquinodimethane, tetracyanoethylene, trinitrofluorenone and the like, preferably fullerene.

In the first composition, the compounding amount of the hole transporting material is usually 1 to 400 parts by mass, preferably 5 to 150 parts by mass, when the amount of the compound represented by the formula (C-1) is taken as 100 parts by mass.

The hole transporting material may be used each singly or in combination of two or more.

### Electron transporting material

The electron transporting material is classified into low molecular compounds and polymer compounds. The electron transporting material may have a crosslinking group.

The low molecular compound includes, for example, metal complexes having 8-hydroxyquinoline as a ligand, oxadiazole, anthraquinodimethane, benzoquinone, naphthoquinone, anthraquinone, tetracyanoanthraquinodimethane, fluorenone, diphenyldicyanoethylene and diphenoquinone, and derivatives thereof.

The polymer compound includes, for example, polyphenylene, polyfluorene, and derivatives thereof. The polymer compound may be doped with a metal.

In the first composition, the compounding amount of the electron transporting material is usually 1 to 400 parts by mass, preferably 5 to 150 parts by mass, when the amount of the compound represented by the formula (C-1) is taken as 100 parts by mass.

The electron transporting material may be used each singly or in combination of two or more.

### Hole injection material and electron injection material

The hole injection material and the electron injection material are each classified into low molecular compounds and polymer compounds. The hole injection material and the electron injection material may have a crosslinking group.

The low molecular compound includes, for example, metal phthalocyanines such as copper phthalocyanine and the like; carbon; oxides of metals such as molybdenum, tungsten and the like; and metal fluorides such as lithium fluoride, sodium fluoride, cesium fluoride, potassium fluoride and the like.

The polymer compound includes electrically conductive polymers such as, for example, polyaniline, polythiophene, polypyrrole, polyphenylenevinylene, polythienylenevinylene, polyquinoline and polyquinoxaline, and derivatives thereof; polymers containing an aromatic amine structure in the main chain or side chain, and the like.

In the first composition, the compounding amounts of the hole injection material and the electron injection material are each usually 1 to 400 parts by mass, preferably 5 to 150 parts by mass, when the amount of the compound represented by the formula (C-1) is taken as 100 parts by mass,.

The electron injection material and the hole injection material may each be used singly or in combination of two or more.

### Ion doping

When the hole injection material or the electron injection material contains an electrically conductive polymer, the electric conductivity of the electrically conductive polymer is preferably 1×10⁻⁵ S/cm to 1×10³ S/cm. For adjusting the electric conductivity of the electrically conductive polymer within such a range, the electrically conductive polymer can be doped with an appropriate amount of ions.

The kind of the ion for doping is an anion for the hole injection material and a cation for the electron injection material. The anion includes, for example, a polystyrenesulfonate ion, an alkylbenzenesulfonate ion and a camphor sulfonate ion. The cation includes, for example, a lithium ion, a sodium ion, a potassium ion and a tetrabutylammonium ion.

The ion for doping may be used each singly or in combination of two or more.

### Light emitting material

The light emitting material is classified into low molecular compounds and polymer compounds. The light emitting material may have a crosslinking group.

The low molecular compound includes, for example, naphthalene and derivatives thereof, anthracene and derivatives thereof, and perylene and derivatives thereof.

The polymer compound includes polymer compounds containing, for example, a phenylene group, a naphthalenediyl group, an anthracenediyl group, a fluorenediyl group, a phenanthrenediyl group, a dihydrophenanthrenediyl group, a group represented by the formula (X) described later, a carbazolediyl group, a phenoxazinediyl group, a phenothiazinediyl group, a pyrenediyl group and the like.

In the first composition, the compounding amount of the light emitting material is usually 1 to 400 parts by mass, preferably 5 to 150 parts by mass, when the amount of the compound represented by the formula (C-1) is taken as 100 parts by mass.

The light emitting material may be used singly or in combination of two or more.

### Antioxidant

The antioxidant may be a compound which is soluble in the same solvent as for a compound represented by the formula (C-1) and which does not disturb light emission and charge transportation, and includes, for example, phenol type antioxidants and phosphorus-based antioxidants.

In the first composition, the compounding amount of the antioxidant is usually 0.001 to 10 parts by mass, when the amount of the compound represented by the formula (C-1) is taken as 100 parts by mass.

The antioxidant may be used each singly or in combination of two or more.

### First ink

The composition containing a compound represented by the formula (C-1) and a solvent (hereinafter, referred to also as "first ink") can be suitably used for application methods such as a spin coat method, a casting method, a micro gravure coat method, a gravure coat method, a bar coat method, a roll coat method, a wire bar coat method, a dip coat method, a spray coat method, a screen printing method, a flexo printing method, an offset printing method, an inkjet printing method, a capillary coat method, a nozzle coat method and the like.

The viscosity of the first ink may be adjusted depending on the kind of the application method, and when applied to a printing method in which a solution passes through a discharge device such as an inkjet printing method and the like, it is preferably 1 to 20 mPa•s at 25°C since clogging and flight bending hardly occur during discharge.

The solvent contained in the first ink is preferably a solvent which can dissolve or uniformly disperse solid components in the ink. The solvent includes, for example, chlorine-based solvents such as 1,2-dichloroethane, 1,1,2-trichloroethane, chlorobenzene, o-dichlorobenzene and the like; ether solvents such as tetrahydrofuran, dioxane, anisole, 4-methylanisole and the like; aromatic hydrocarbon solvents such as toluene, xylene, mesitylene, ethylbenzene, n-hexylbenzene, cyclohexylbenzene and the like; aliphatic hydrocarbon solvents such as cyclohexane, methylcyclohexane, n-pentane, n-hexane, n-heptane, n-octane, n-nonane, n-decane, n-dodecane, bicyclohexyl and the like; ketone solvents such as acetone, methyl ethyl ketone, cyclohexanone, acetophenone and the like; ester solvents such as ethyl acetate, butyl acetate, ethylcellosolve acetate, methyl benzoate, phenyl acetate and the like; polyhydric alcohol solvents such as ethylene glycol, glycerin, 1,2-hexanediol and the like; alcohol solvents such as isopropyl alcohol, cyclohexanol and the like; sulfoxide solvents such as dimethyl sulfoxide and the like; and amide solvents such as N-methyl-2-pyrrolidone, N,N-dimethylformamide and the like. The solvent may be used each singly or in combination of two or more.

In the first ink, the compounding amount of the solvent is usually 1000 to 100000 parts by mass, preferably 2000 to 20000 parts by mass, when the amount of the compound represented by the formula (C-1) is taken as 100 parts by mass.

### [Second organic layer]

The second organic layer which the light emitting device of the present invention has is
a layer A containing at least one of a polymer compound (hereinafter, referred to also as "polymer compound of Layer A) containing a constitutional unit (hereinafter, referred to as "phosphorescent constitutional unit") having a group obtained by removing from a phosphorescent compound represented by the formula (1) (wherein, M is an iridium atom) one or more hydrogen atoms, and a cross-linked body of the polymer compound of Layer A, or
a layer B containing a phosphorescent compound represented by the formula (1) and a cross-linked body of a crosslinking material.

The second organic layer is preferably a layer containing a cross-linked body of the polymer compound of Layer A, or Layer B, and more preferably a layer containing a cross-linked body of the polymer compound of Layer A, since lamination of the light emitting device of the present invention by an application method is easy and the light emitting device of the present invention is more excellent in luminance life.

### <Layer A>

In Layer A, the polymer compound of Layer A and the cross-linked body of the polymer compound of Layer A each may be contained singly or in combination of two or more.

### [Phosphorescent constitutional unit]

The phosphorescent constitutional unit is preferably a constitutional unit having a group obtained by removing from a phosphorescent compound represented by the formula (1) one or more and five or less hydrogen atoms, more preferably a constitutional unit having a group obtained by removing from a phosphorescent compound represented by the formula (1) one or more and three or less hydrogen atoms, further preferably a constitutional unit represented by the formula (1-1B), a constitutional unit represented by the formula (1-2B), a constitutional unit represented by the formula (1-3B) or a constitutional unit represented by the formula (1-4B), particularly preferably a constitutional unit represented by the formula (1-1B), a constitutional unit represented by the formula (1-2B) or a constitutional unit represented by the formula (1-3B), especially preferably a constitutional unit represented by the formula (1-3B), since the light emitting device of the present invention is more excellent in luminance life and since synthesis of the polymer compound of Layer A is easy.

The examples and preferable range of the phosphorescent compound represented by the formula (1) in the phosphorescent constitutional unit are the same as the examples and preferable range of the phosphorescent compound represented by the formula (1) as the phosphorescent compound which may be contained in the first organic layer.

The phosphorescent compound represented by the formula (1) in the phosphorescent constitutional unit is preferably a phosphorescent compound represented by the formula (1-A) or a phosphorescent compound represented by the formula (1-B), more preferably a phosphorescent compound represented by the formula (1-B), since the light emitting device of the present invention is more excellent in luminance life. The phosphorescent compound represented by the formula (1-A) as the phosphorescent compound represented by the formula (1) in the phosphorescent constitutional unit is preferably a phosphorescent compound represented by the formula (1-A1) to the formula (1-A5), more preferably a phosphorescent compound represented by the formula (1-A1), the formula (1-A3) or the formula (1-A4), further preferably a phosphorescent compound represented by the formula (1-A4), since the light emitting device of the present invention is more excellent in luminance life. The phosphorescent compound represented by the formula (1-B) as the phosphorescent compound represented by the formula (1) in the phosphorescent constitutional unit is preferably a phosphorescent compound represented by the formula (1-B1) to the formula (1-B5), more preferably a phosphorescent compound represented by the formula (1-B1) to the formula (1-B3), further preferably a phosphorescent compound represented by the formula (1-B1), since the light emitting device of the present invention is more excellent in luminance life.

### Constitutional unit represented by the formula (1-1B)

R^{A} is preferably an aryl group or a monovalent heterocyclic group, more preferably an aryl group, and the foregoing groups optionally have a substituent.

R^{B} is preferably a hydrogen atom, an alkyl group, a cycloalkyl group, an aryl group or a monovalent heterocyclic group, more preferably a hydrogen atom, an alkyl group, a cycloalkyl group or an aryl group, further preferably a hydrogen atom or an alkyl group, particularly preferably a hydrogen atom, and the foregoing groups optionally have a substituent.

L^{C} is preferably -C(R^{B})₂-, an arylene group or a divalent heterocyclic group, more preferably -C(R^{B})₂- or an arylene group, further preferably an arylene group, particularly preferably a group represented by the formula (A-1) or (A-2), and the foregoing groups optionally have a substituent.

The examples and preferable range of the arylene group and the divalent heterocyclic group represented by L^{C} are the same as the examples and preferable range of the arylene group and the divalent heterocyclic group represented by Ar^{Y1} described later, respectively.

The examples and preferable range of the substituent which R^{A}, R^{B} and L^{C} optionally have are the same as the examples and preferable range of the substituent which the group represented by Ar^{Y1} optionally has described later, respectively.

n^{c1} is usually an integer of 0 to 10, preferably an integer of 0 to 5, more preferably an integer of 0 to 2, further preferably 0 or 1, particularly preferably 0.

When the polymer compound of Layer A is a polymer compound containing a constitutional unit represented by the formula (1-1B), the constitutional unit represented by the formula (1-1B) is an end constitutional unit.

"The end constitutional unit" denotes an end constitutional unit of a polymer compound. The end constitutional unit is preferably a constitutional unit derived from an end capping agent in production of a polymer compound.

M^{1B} is more preferably a group represented by the formula (BM-1). 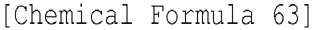 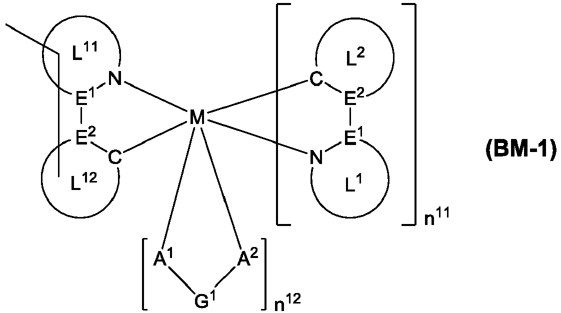 [wherein,
M, E¹, E², Ring L¹, Ring L² and A¹-G¹-A² represent the same meaning as described above.
Ring L¹¹ represents an aromatic hetero ring, and the ring optionally has a substituent. When a plurality of the substituents are present, they may be combined together to form a ring together with the atoms to which they are attached.
Ring L¹² represents an aromatic hydrocarbon ring or an aromatic hetero ring, and the foregoing rings optionally have a substituent. When a plurality of the substituents are present, they may be combined together to form a ring together with the atoms to which they are attached.
The substituent which Ring L¹¹ optionally has and the substituent which Ring L¹² optionally has may be combined together to form a ring together with the atoms to which they are attached.
At least one of Ring L¹¹ and Ring L¹² has one connecting bond.
n¹¹ and n¹² each independently represent an integer of 0 or more, providing that n¹¹+n¹² is 2.]

n¹¹ is preferably 2.

When Ring L¹¹ has no connecting bond, the examples and preferable range of Ring L¹¹ are the same as the examples and preferable range of Ring L¹ described above.

When Ring L¹¹ has a connecting bond, the examples and preferable range of the ring portion excluding the connecting bond of Ring L¹¹ are the same as the examples and preferable range of Ring L¹ described above.

When Ring L¹² has no connecting bond, the examples and preferable range of Ring L¹² are the same as the examples and preferable range of Ring L² described above.

When Ring L¹² has a connecting bond, the examples and preferable range of the ring portion excluding the connecting bond of Ring L¹² are the same as the examples and preferable range of Ring L² described above.

The examples and preferable range of the substituent which Ring L¹¹ and Ring L¹² optionally have are the same as the examples and preferable range of the substituent which Ring L¹ and Ring L² optionally have described above.

### Constitutional unit represented by the formula (1-2B)

L^{d} and L^{e} are each preferably -C(R^{B})₂-, an arylene group or a divalent heterocyclic group, more preferably an arylene group or a divalent heterocyclic group, further preferably an arylene group, particularly preferably a group represented by the formula (A-1) or the formula (A-2), and the foregoing groups optionally have a substituent.

The examples and preferable range of the arylene group and the divalent heterocyclic group represented by L^{d} and L^{e} are the same as the examples and preferable range of the arylene group and the divalent heterocyclic group represented by Ar^{Y1} described later, respectively.

n^{d1} and n^{e1} are each usually an integer of 0 to 10, preferably an integer of 0 to 5, more preferably an integer of 0 to 2, further preferably 0 or 1, particularly preferably 0.

Ar^{1M} is preferably a group obtained by removing from a benzene ring, a naphthalene ring, a fluorene ring, a phenanthrene ring, a dihydrophenanthrene ring, a pyridine ring, a diazabenzene ring, a triazine ring, a carbazole ring, a phenoxazine ring or a phenothiazine ring three hydrogen atoms bonding directly to carbon atoms or hetero atoms constituting the ring, more preferably a group obtained by removing from a benzene ring, a naphthalene ring, a fluorene ring, a phenanthrene ring or a dihydrophenanthrene ring three hydrogen atoms bonding directly to carbon atoms constituting the ring, further preferably a group obtained by removing from a benzene ring or a fluorene ring three hydrogen atoms bonding directly to carbon atoms constituting the ring, particularly preferably a group obtained by removing from a benzene ring three hydrogen atoms bonding directly to carbon atoms constituting the ring, and the foregoing groups optionally have a substituent.

The examples and preferable range of the substituent which L^{d}, L^{e} and Ar^{1M} optionally have are the same as the examples and preferable range of the substituent which the group represented by Ar^{Y1} optionally has described later, respectively.

### Constitutional unit represented by the formula (1-3B)

M^{2B} is more preferably a group represented by the formula (BM-2) or the formula (BM-3), further preferably a group represented by the formula (BM-2). 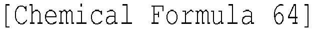 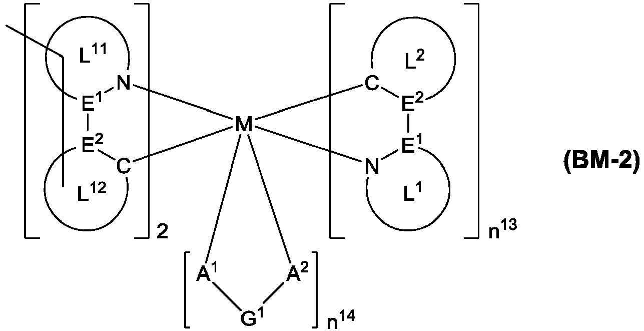 [wherein,
M, E¹, E², Ring L¹, Ring L², Ring L¹¹, Ring L¹² and A¹ -G¹-A² represent the same meaning as described above. A plurality of Ring L¹¹ may be the same or different. A plurality of Ring L¹² may be the same or different.
n¹³ and n¹⁴ each independently represent an integer of 0 or more, provided that n¹³+n¹⁴ is 1.]

n¹³ is preferably 1. 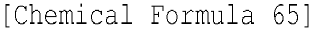 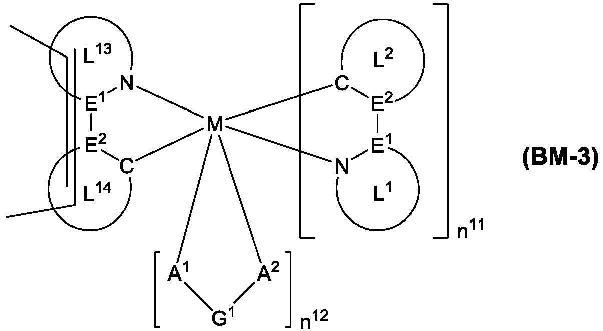 [wherein,
M, E¹, E², Ring L¹, Ring L², A¹ -G¹ -A² , n¹¹ and n¹² represent the same meaning as described above.
Ring L¹³ represents an aromatic hetero ring, and the ring optionally has a substituent. When a plurality of the substituents are present, they may be combined together to form a ring together with the atoms to which they are attached.
Ring L¹⁴ represents an aromatic hydrocarbon ring or an aromatic hetero ring, and the foregoing rings optionally have a substituent. When a plurality of the substituents are present, they may be combined together to form a ring together with the atoms to which they are attached.
The substituent which Ring L¹³ optionally has and the substituent which Ring L¹⁴ optionally has may be combined together to form a ring together with the atoms to which they are attached.
One of Ring L¹³ and Ring L¹⁴ has two connecting bonds, or Ring L¹³ and Ring L¹⁴ each have one connecting bond.]

When Ring L¹³ has no connecting bond, the examples and preferable range of Ring L¹³ are the same as the examples and preferable range of Ring L¹ described above.

When Ring L¹³ has a connecting bond, the examples and preferable range of the ring portion excluding the connecting bond of Ring L¹³ are the same as the examples and preferable range of Ring L¹ described above.

When Ring L¹⁴ has no connecting bond, the examples and preferable range of Ring L¹⁴ are the same as the examples and preferable range of Ring L² described above.

When Ring L¹⁴ has a connecting bond, the examples and preferable range of the ring portion excluding the connecting bond of Ring L¹⁴ are the same as the examples and preferable range of Ring L² described above.

The examples and preferable range of the substituent which Ring L¹³ and Ring L¹⁴ optionally have are the same as the examples and preferable range of the substituent which Ring L¹ and Ring L² optionally have described above.

It is preferable that Ring L¹³ and Ring L¹⁴ each have one connecting bond.

### Constitutional unit represented by the formula (1-4B)

M^{3B} is preferably a group represented by the formula (BM-4). 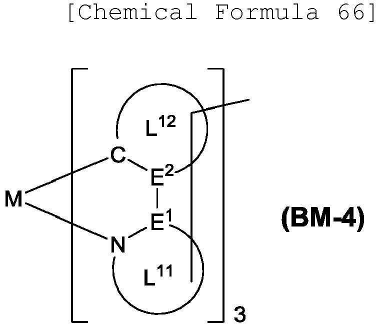 [wherein, M, E¹, E², Ring L¹¹ and Ring L¹² represent the same meaning as described above.]

The phosphorescent constitutional unit includes, for example, constitutional units represented by the formula (1B-1) to the formula (1B-15), the formula (1G-1) to the formula (1G-13), the formula (2G-1) to the formula (2G-16), the formula (3G-1) to the formula (3G-21) and the formula (4G-1) to the formula (4G-5). 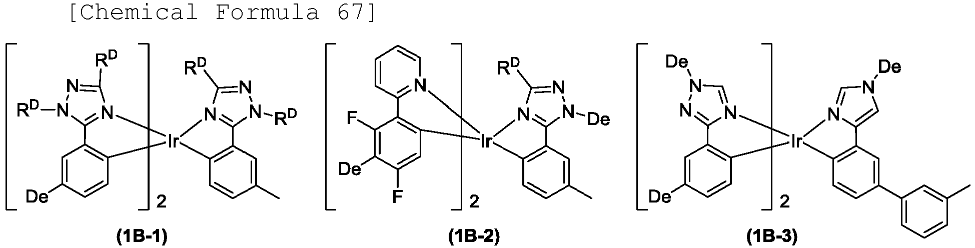 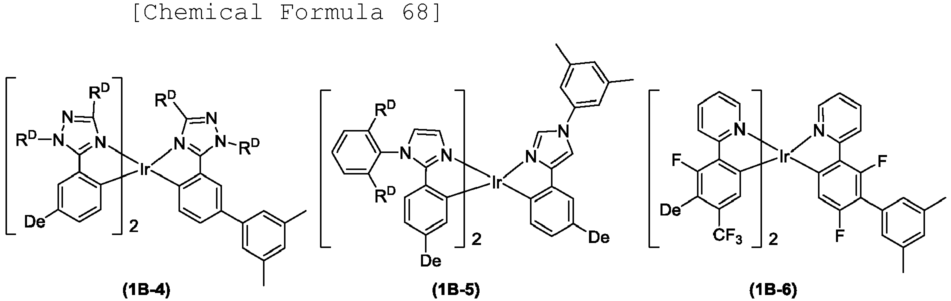 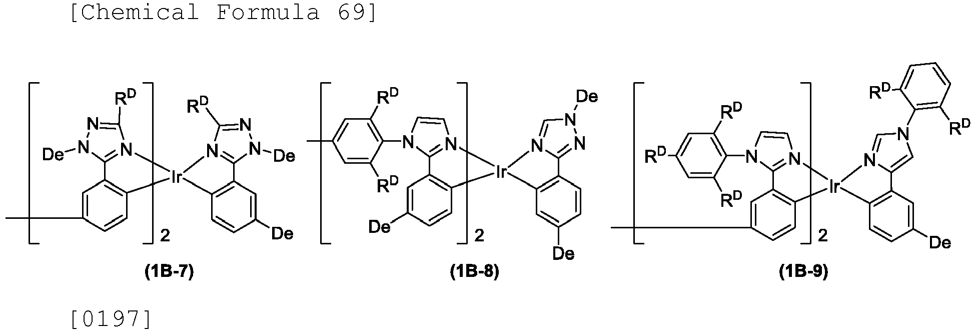 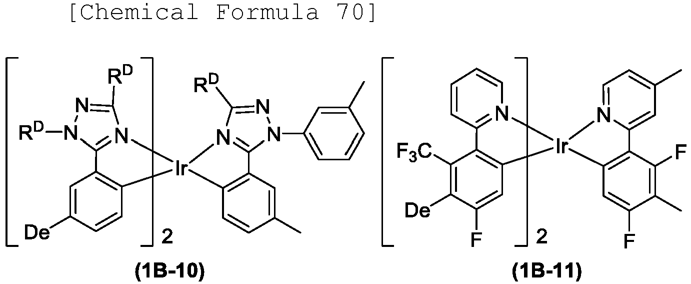 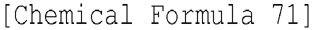 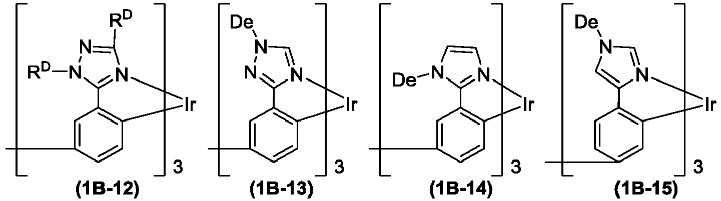 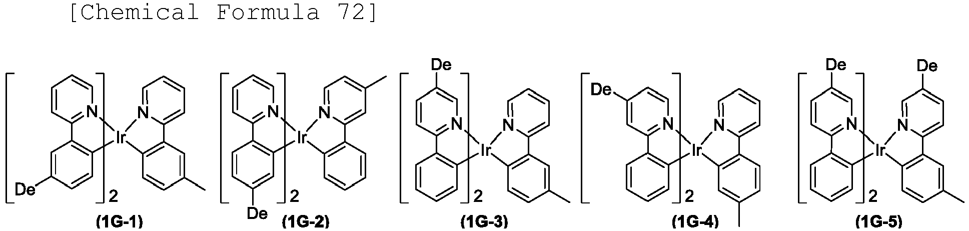 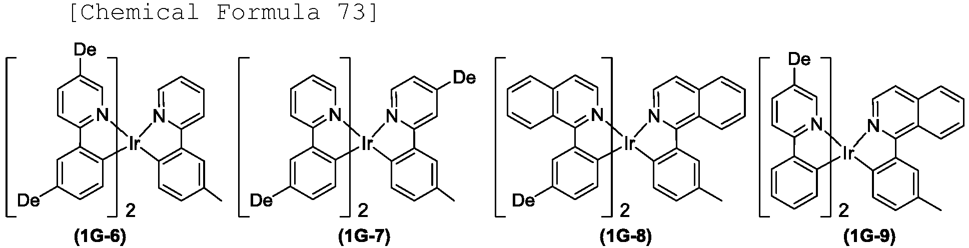 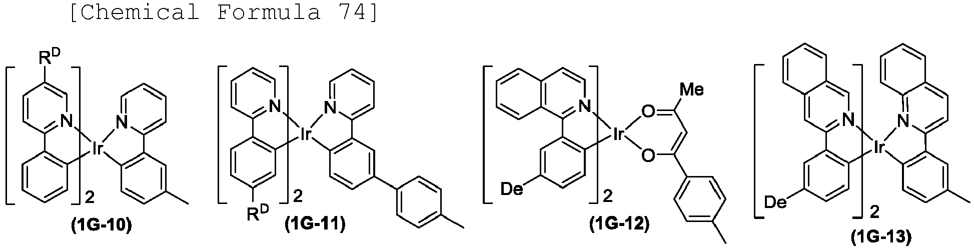 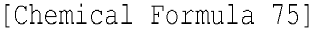 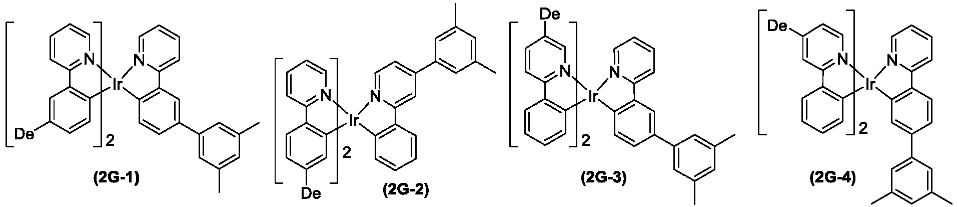 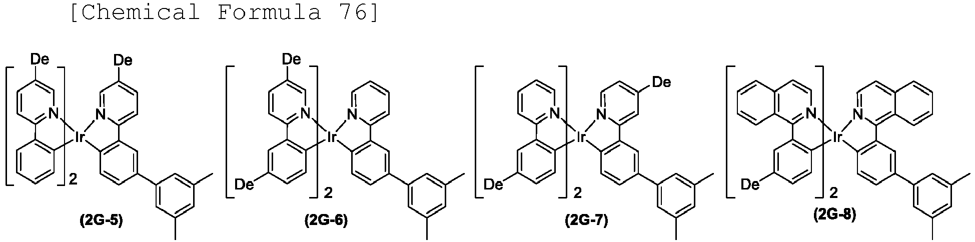 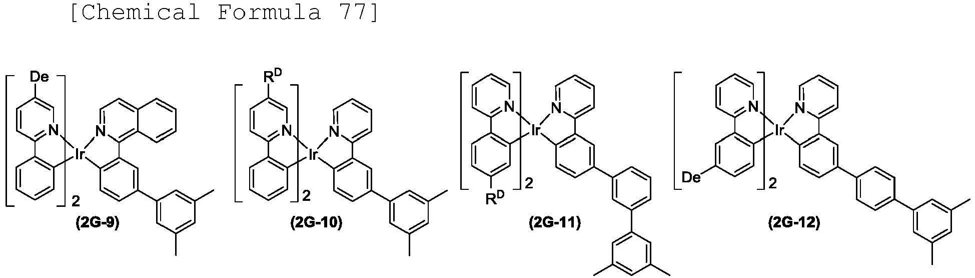 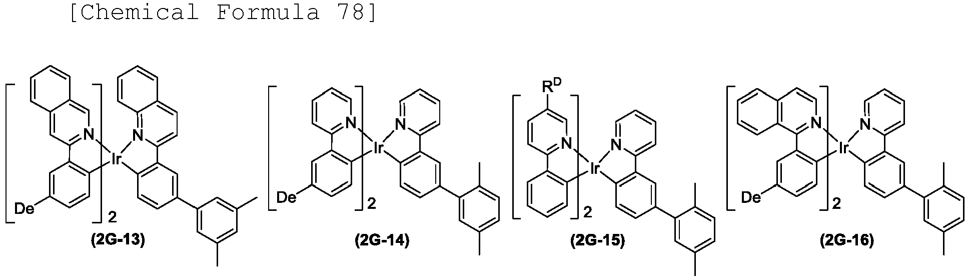 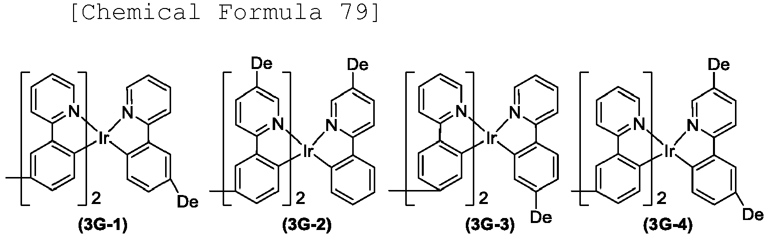 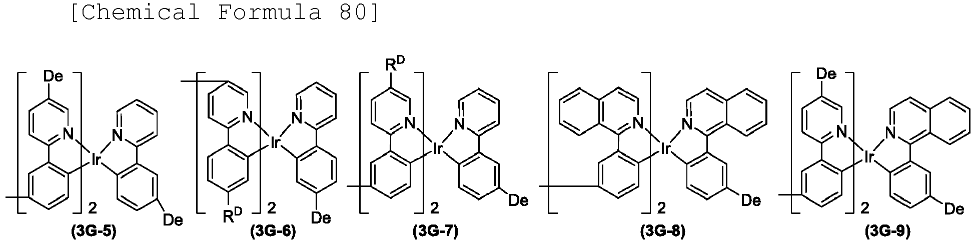 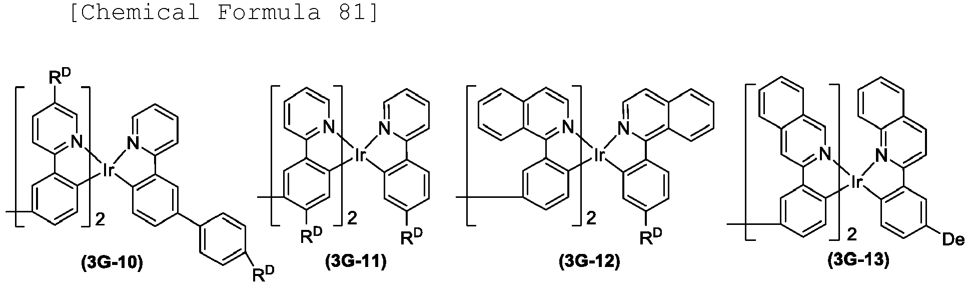 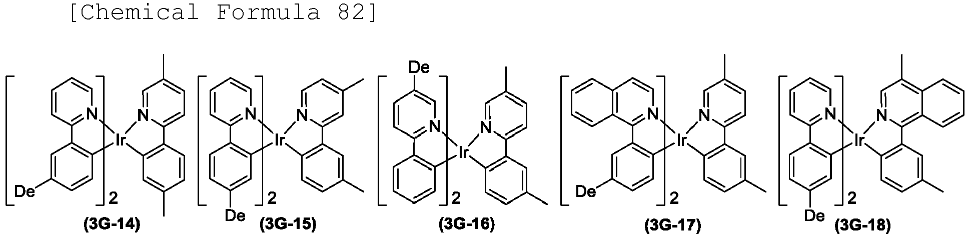 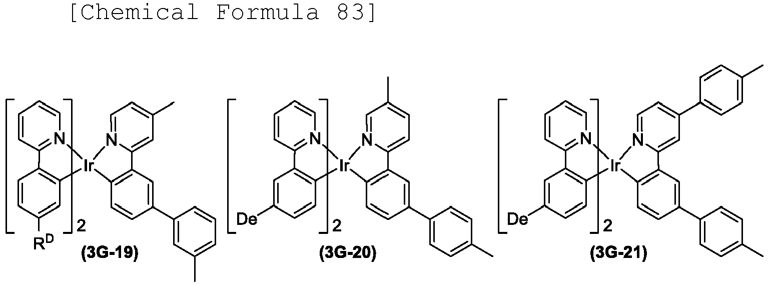 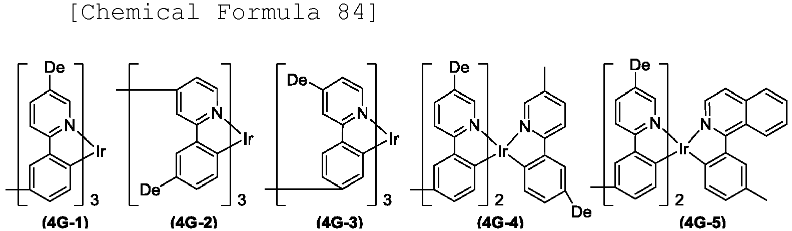 [wherein,
R^{D} represents an alkyl group, a cycloalkyl group, an alkoxy group or a cycloalkoxy group, and the foregoing groups optionally have a substituent. When a plurality of R^{D} are present, they may be the same or different.
De represents a group represented by the formula (D-A), the formula (D-B) or the formula (D-C). When a plurality of De are present, they may be the same or different.]

The alkyl group or the cycloalkyl group as the R^{D} is preferably a methyl group, an ethyl group, an isopropyl group, a tert-butyl group, a hexyl group, a 2-ethylhexyl group, a cyclohexyl group or a tert-octyl group. The alkoxy group or the cycloalkoxy group as the R^{D} is preferably a methoxy group, a 2-ethylhexyloxy group or a cyclohexyloxy group.

R^{D} is preferably an alkyl group optionally having a substituent or a cycloalkyl group optionally having a substituent, more preferably an alkyl group optionally having a substituent, further preferably a methyl group, an ethyl group, an isopropyl group, a tert-butyl group, a hexyl group, a 2-ethylhexyl group or a tert-octyl group.

De is preferably a group represented by the formula (D-A1) to the formula (D-A5), the formula (D-B1) to the formula (D-B6) or the formula (D-C1) to the formula (D-C4), more preferably a group represented by the formula (D-A1), the formula (D-A3), the formula (D-B1) or the formula (D-B5), further preferably a group represented by the formula (D-A1) or the formula (D-A3).

In the polymer compound of Layer A, the amount of the phosphorescent constitutional unit is preferably 0.01 to 50% by mol, more preferably 0.1 to 30% by mol, further preferably 0.5 to 10% by mol, particularly preferably 1 to 5% by mol, with respect to the total amount of the constitutional unit contained in the polymer compound of Layer A, since the light emitting device of the present invention is more excellent in luminance life.

In the polymer compound of Layer A, the phosphorescent constitutional unit may be contained only singly or in combination of two or more.

It is preferable that the polymer compound of Layer A further contains a constitutional unit represented by the formula (X), since hole transportability is excellent. Moreover, it is preferable that the polymer compound of Layer A further contains a constitutional unit represented by the formula (Y), since the light emitting device of the present invention is more excellent in luminance life.

It is preferable that the polymer compound of Layer A further contains a constitutional unit represented by the formula (X) and a constitutional unit represented by the formula (Y), since hole transportability is excellent and since the light emitting device of the present invention is further excellent in luminance life. 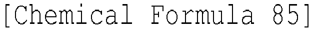 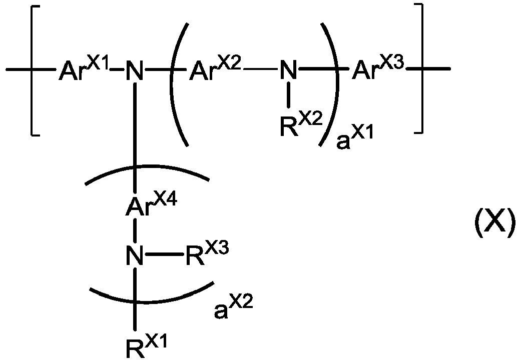 [wherein,
a^{X1} and a^{X2} each independently represent an integer of 0 or more.
Ar^{X1} and Ar^{X3} each independently represent an arylene group or a divalent heterocyclic group, and the foregoing groups optionally have a substituent.
Ar^{X2} and Ar^{X4} each independently represent an arylene group, a divalent heterocyclic group or a divalent group in which at least one arylene group and at least one divalent heterocyclic group are bonded directly, and the foregoing groups optionally have a substituent. When a plurality of Ar^{X2} and Ar^{X4} are present, they may be the same or different at each occurrence.
R^{X1}, R^{X2} and R^{X3} each independently represent a hydrogen atom, an alkyl group, a cycloalkyl group, an aryl group or a monovalent heterocyclic group, and the foregoing groups optionally have a substituent. When a plurality of R^{X2} and R^{X3} are present, they may be the same or different at each occurrence.]

a^{X1} is preferably an integer of 2 or less, more preferably 1, since the light emitting device of the present invention is more excellent in luminance life.

a^{X2} is preferably an integer of 2 or less, more preferably 0, since the light emitting device of the present invention is more excellent in luminance life.

R^{X1}, R^{X2} and R^{X3} are each preferably an alkyl group, a cycloalkyl group, an aryl group or a monovalent heterocyclic group, more preferably an aryl group, and the foregoing groups optionally have a substituent.

The arylene group represented by Ar^{X1} and Ar^{X3} is more preferably a group represented by the formula (A-1) or the formula (A-9), further preferably a group represented by the formula (A-1), and the foregoing groups optionally have a substituent.

The divalent heterocyclic group represented by Ar^{X1} and Ar^{X3} is more preferably a group represented by the formula (AA-1), the formula (AA-2) or the formula (AA-7) to the formula (AA-26), and the foregoing groups optionally have a substituent.

Ar^{X1} and Ar^{X3} are each preferably an arylene group optionally having a substituent.

The arylene group represented by Ar^{X2} and Ar^{X4} is more preferably a group represented by the formula (A-1), the formula (A-6), the formula (A-7), the formula (A-9) to the formula (A-11) or the formula (A-19), and the foregoing groups optionally have a substituent.

The more preferable range of the divalent heterocyclic group represented by Ar^{X2} and Ar^{X4} is the same as the more preferable range of the divalent heterocyclic group represented by Ar^{X1} and Ar^{X3}.

The more preferable range and the further preferable range of the arylene group and the divalent heterocyclic group as the divalent group in which at least one arylene group and at least one divalent heterocyclic group are bonded directly represented by Ar^{X2} and Ar^{X4} are the same as the more preferable range and the further preferable range of the arylene group and the divalent heterocyclic group represented by Ar^{X1} and Ar^{X3}, respectively.

The divalent group in which at least one arylene group and at least one divalent heterocyclic group are bonded directly represented by Ar^{X2} and Ar^{X4} includes, for example, groups represented by the following formulae, and these optionally have a substituent. 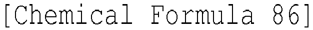 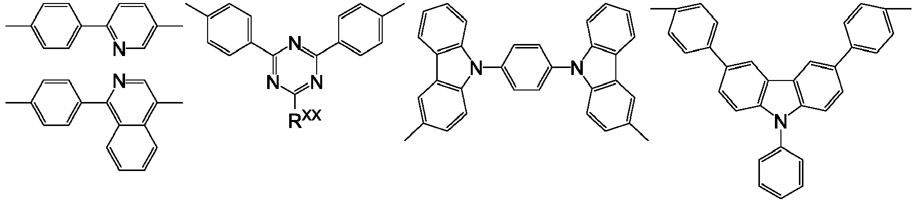 [wherein, R^{XX} represents a hydrogen atom, an alkyl group, a cycloalkyl group, an aryl group or a monovalent heterocyclic group, and the foregoing groups optionally have a substituent.]

R^{XX} is preferably an alkyl group, a cycloalkyl group or an aryl group, and the foregoing groups optionally have a substituent.

Ar^{X2} and Ar^{X4} are each preferably an arylene group optionally having a substituent.

The substituent which groups represented by Ar^{X1} to Ar^{X4} and R^{X1} to R^{X3} optionally have is preferably an alkyl group, a cycloalkyl group or an aryl group, and the foregoing groups optionally further have a substituent

The constitutional unit represented by the formula (X) is preferably a constitutional unit represented by the formula (X-1) to the formula (X-7), more preferably a constitutional unit represented by the formula (X-3) to the formula (X-7), further preferably a constitutional unit represented by the formula (X-3) to the formula (X-6). 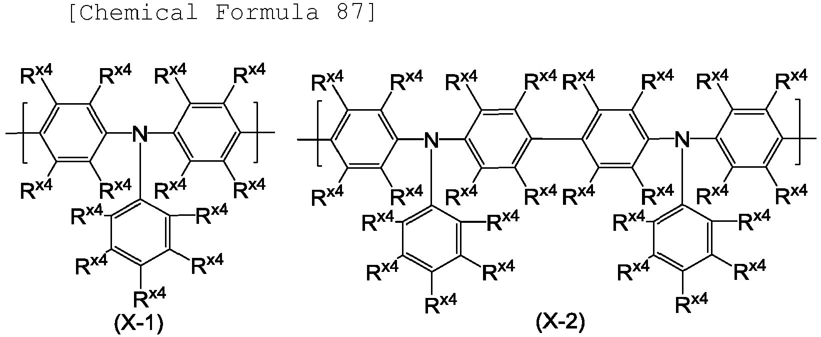 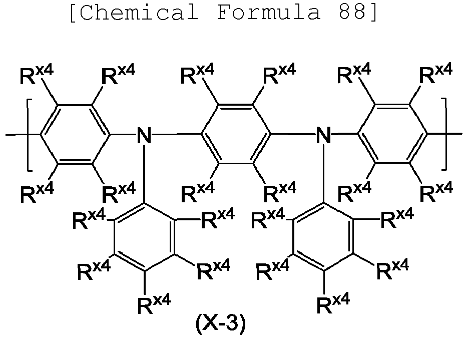 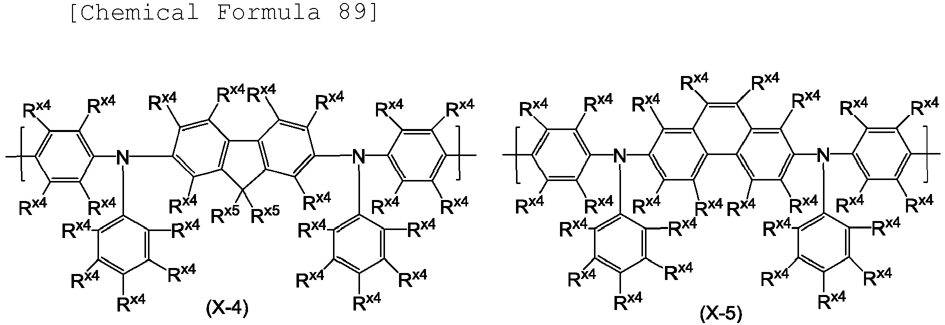 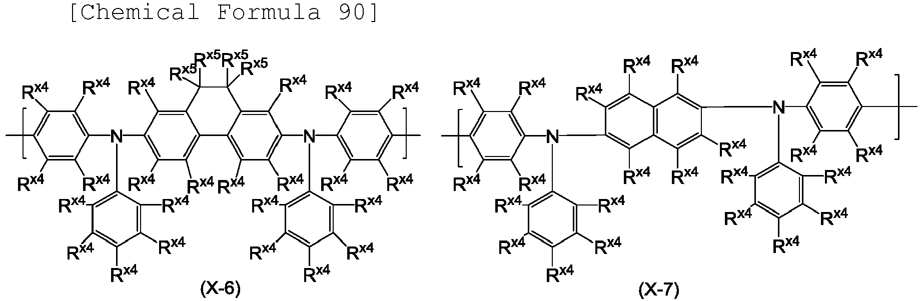 [wherein, R^{X4} and R^{X5} each independently represent a hydrogen atom, an alkyl group, a cycloalkyl group, an alkoxy group, a cycloalkoxy group, an aryl group, an aryloxy group, a halogen atom, a monovalent heterocyclic group or a cyano group, and the foregoing groups optionally have a substituent. A plurality of R^{X4} may be the same or different. A plurality of R^{X5} may be the same or different, and the adjacent groups R^{X5} may be combined together to form a ring together with the carbon atoms to which they are attached.]

The amount of the constitutional unit represented by the formula (X) is preferably 0.1 to 90% by mol, more preferably 1 to 70% by mol, further preferably 10 to 50% by mol, with respect to the total amount of the constitutional unit contained in the polymer compound of Layer A, since hole transportability is excellent.

The constitutional unit represented by the formula (X) includes, for example, constitutional units represented by the formula (X1-1) to the formula (X1-19), preferably constitutional units represented by the formula (X1-6) to the formula (X1-14).

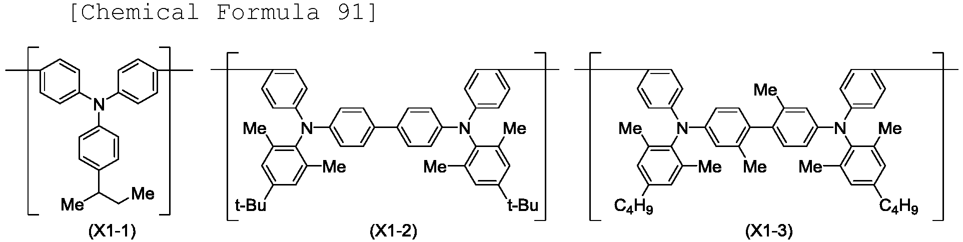

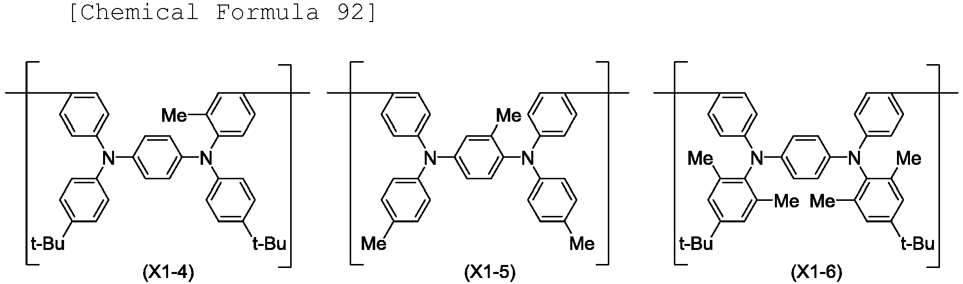

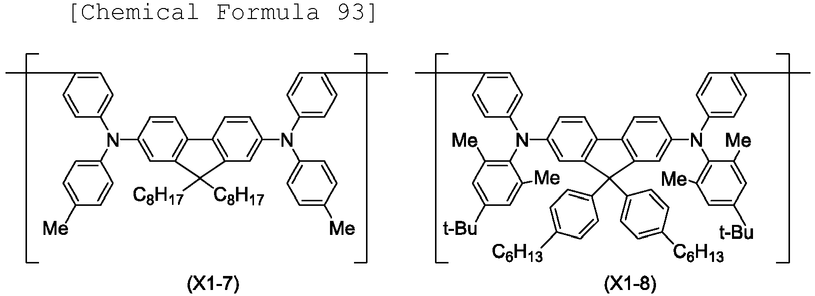

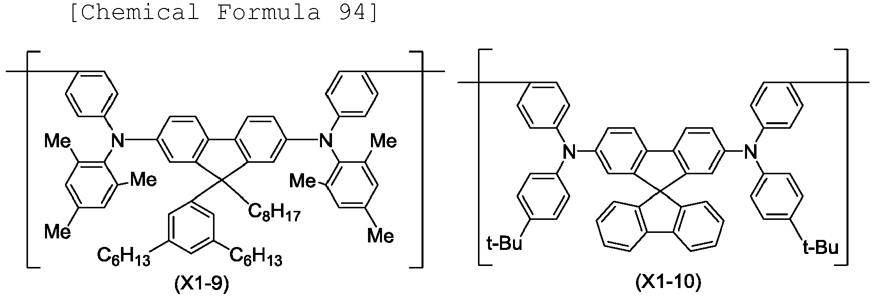

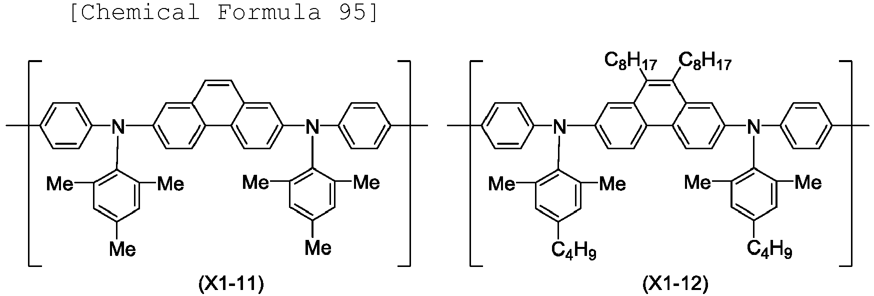

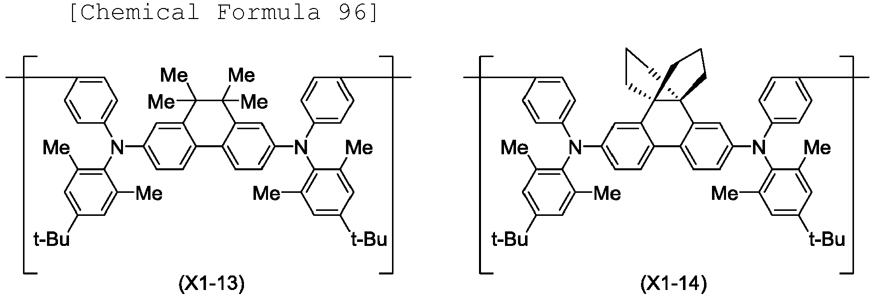

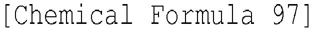

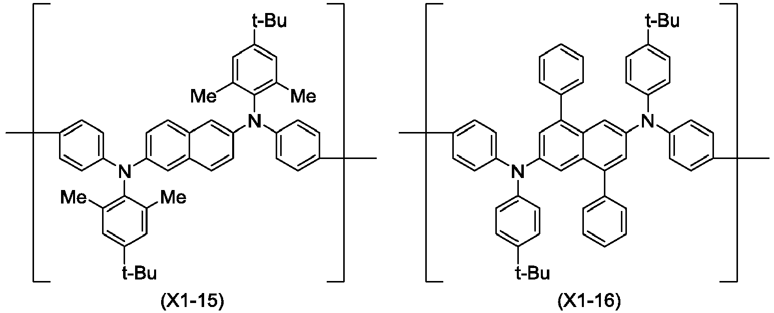

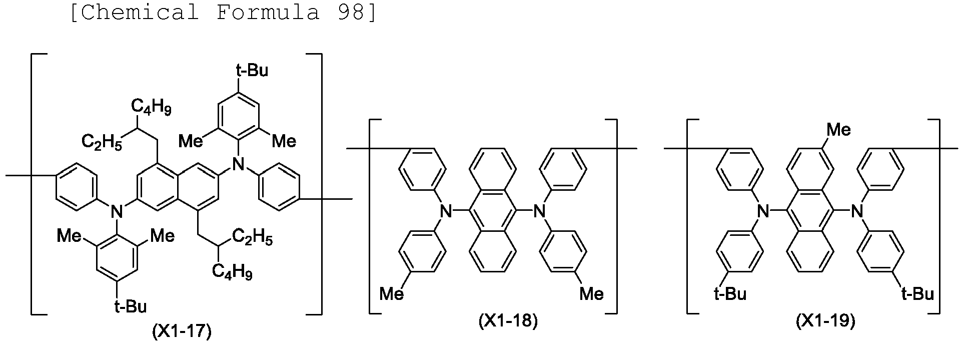

In the polymer compound of Layer A, the constitutional unit represented by the formula (X) may be contained only singly or in combination of two or more. 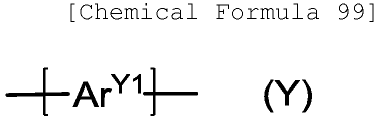 [wherein, Ar^{Y1} is an arylene group, a divalent heterocyclic group or a divalent group in which at least one arylene group and at least one divalent heterocyclic group are bonded directly, and the foregoing groups optionally have a substituent.]

The arylene group represented by Ar^{Y1} is more preferably a group represented by the formula (A-1), the formula (A-6), the formula (A-7), the formula (A-9) to the formula (A-11), the formula (A-13) or the formula (A-19), further preferably a group represented by the formula (A-1), the formula (A-7), the formula (A-9) or the formula (A-19), and the foregoing groups optionally have a substituent.

The divalent heterocyclic group represented by Ar^{Y1} is more preferably a group represented by the formula (AA-4), the formula (AA-10), the formula (AA-13), the formula (AA-15), the formula (AA-18) or the formula (AA-20), further preferably a group represented by the formula (AA-4), the formula (AA-10), the formula (AA-18) or the formula (AA-20), and the foregoing groups optionally have a substituent.

The more preferable range and the further preferable range of the arylene group and the divalent heterocyclic group as the divalent group in which at least one arylene group and at least one divalent heterocyclic group are bonded directly represented by Ar^{Y1} are the same as the more preferable range and the further preferable range of the arylene group and the divalent heterocyclic group represented by Ar^{Y1} described above, respectively.

The divalent group in which at least one arylene group and at least one divalent heterocyclic group are bonded directly represented by Ar^{Y} includes those which are the same as the divalent group in which at least one arylene group and at least one divalent heterocyclic group are bonded directly represented by Ar^{X2} and Ar^{X4} in the formula (X) .

The substituent which the group represented by Ar^{Y1} optionally has is preferably an alkyl group, a cycloalkyl group or an aryl group, and the foregoing groups optionally further have a substituent.

The constitutional unit represented by the formula (Y) includes, for example, constitutional units represented by the formula (Y-1) to the formula (Y-7), and it is preferably a constitutional unit represented by the formula (Y-1) or the formula (Y-2) from the standpoint of the luminance life of the light emitting device of the present invention, preferably a constitutional unit represented by the formula (Y-3) or the formula (Y-4) from the standpoint of electron transportability of the polymer compound of Layer A, preferably a constitutional unit represented by the formula (Y-5) to the formula (Y-7) from the standpoint of hole transportability of the polymer compound of Layer A. 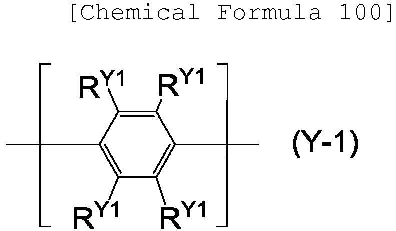 [wherein, R^{Y1} represents a hydrogen atom, an alkyl group, a cycloalkyl group, an alkoxy group, a cycloalkoxy group, an aryl group or a monovalent heterocyclic group, and the foregoing groups optionally have a substituent. A plurality of R^{Y1} may be the same or different, and the adjacent groups R^{Y1} may be combined together to form a ring together with the carbon atoms to which they are attached.]

R^{Y1} is preferably a hydrogen atom, an alkyl group, a cycloalkyl group or an aryl group, and the foregoing groups optionally have a substituent.

The constitutional unit represented by the formula (Y-1) is preferably a constitutional unit represented by the formula (Y-1'). 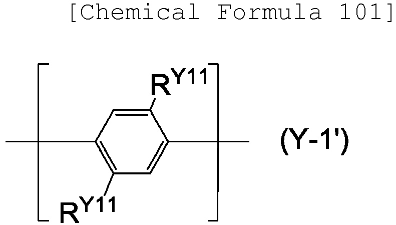 [wherein, R^{Y11} represents an alkyl group, a cycloalkyl group, an alkoxy group, a cycloalkoxy group, an aryl group or a monovalent heterocyclic group, and the foregoing groups optionally have a substituent. A plurality of R^{Y11} may be the same or different.]

R^{Y11} is preferably an alkyl group, a cycloalkyl group or an aryl group, more preferably an alkyl group or a cycloalkyl group, and the foregoing groups optionally have a substituent. 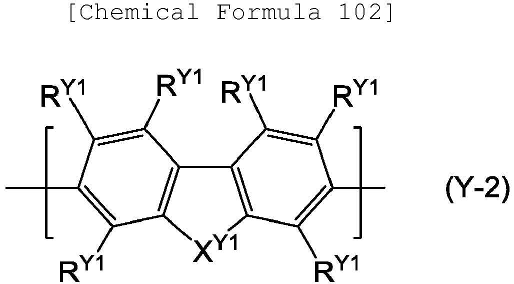 [wherein,
R^{Y1} represents the same meaning as described above.
X^{Y1} represents a group represented by -C(R^{Y2})₂-, - C(R^{Y2}) =C(R^{Y2})- or -C(R^{Y2})₂-C(R^{Y2})₂-. R^{Y2} represents a hydrogen atom, an alkyl group, a cycloalkyl group, an alkoxy group, a cycloalkoxy group, an aryl group or a monovalent heterocyclic group, and the foregoing groups optionally have a substituent. A plurality of R^{Y2} may be the same or different, and groups R^{Y2} may be combined together to form a ring together with the carbon atoms to which they are attached.]

R^{Y2} is preferably an alkyl group, a cycloalkyl group, an aryl group or a monovalent heterocyclic group, more preferably an alkyl group, a cycloalkyl group or an aryl group, and the foregoing groups optionally have a substituent.

Regarding the combination of two groups R^{Y2} in the group represented by -C(R^{Y2})₂- represented by X^{Y1}, it is preferable that both are alkyl groups or cycloalkyl groups, both are aryl groups, both are monovalent heterocyclic groups, or one is an alkyl group or a cycloalkyl group and the other is an aryl group or a monovalent heterocyclic group, it is more preferable that one is an alkyl group or a cycloalkyl group and the other is an aryl group, and the foregoing groups optionally have a substituent. Two groups R^{Y2} may be combined together to form a ring together with the atoms to which they are attached, and when R^{Y2} forms a ring, the group represented by -C(R^{Y2})₂- is preferably a group represented by the formula (Y-A1) to the formula (Y-A5), more preferably a group represented by the formula (Y-A4), and the foregoing groups optionally have a substituent.

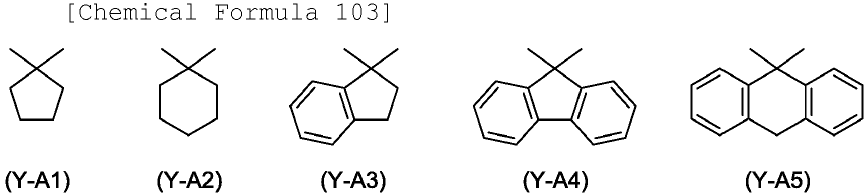

Regarding the combination of two groups R^{Y2} in the group represented by-C(R^{Y2})=C(R^{Y2})- represented by X^{Y1}, it is preferable that both are alkyl groups or cycloalkyl groups, or one is an alkyl group or a cycloalkyl group and the other is an aryl group, and the foregoing groups optionally have a substituent.

Four groups R^{Y2} in the group represented by -C(R^{Y2})₂-C(R^{Y2})₂- represented by X^{Y1} are preferably alkyl groups or cycloalkyl groups optionally having a substituent. A plurality of R^{Y2} may be combined together to form a ring together with the atoms to which they are attached, and when R^{Y2} forms a ring, the group represented by -C(R^{Y2})₂-C(R^{Y2})₂- is preferably a group represented by the formula (Y-B1) to the formula (Y-B5), more preferably a group represented by the formula (Y-B3), and the foregoing groups optionally have a substituent. 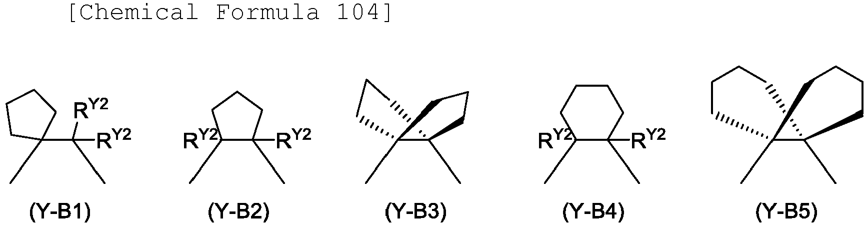 [wherein, R^{Y2} represents the same meaning as described above.]

The constitutional unit represented by the formula (Y-2) is preferably a constitutional unit represented by the formula (Y-2'). 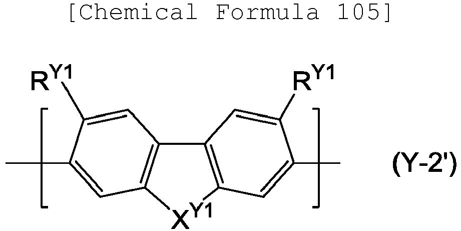 [wherein, R^{Y1} and X^{Y1} represent the same meaning as described above.] 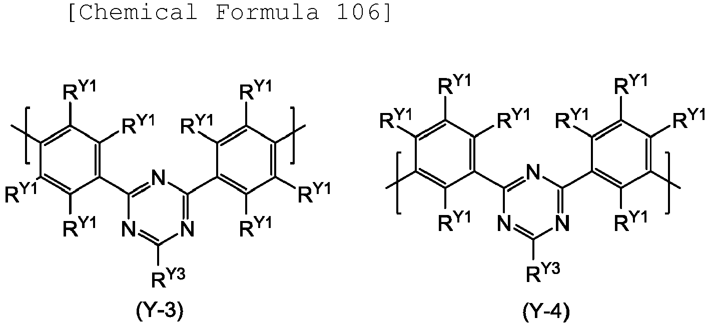 [wherein,
R^{Y1} represents the same meaning as described above.
R^{Y3} represents a hydrogen atom, an alkyl group, a cycloalkyl group, an alkoxy group, a cycloalkoxy group, an aryl group or a monovalent heterocyclic group, and the foregoing groups optionally have a substituent.]

R^{Y3} is preferably an alkyl group, a cycloalkyl group, an alkoxy group, a cycloalkoxy group, an aryl group or a monovalent heterocyclic group, more preferably an aryl group, and the foregoing groups optionally have a substituent. 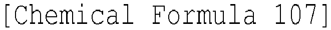 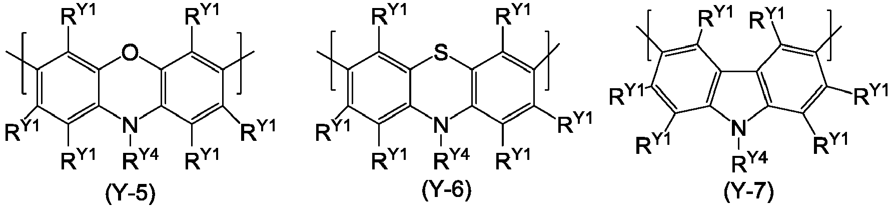 [wherein,
R^{Y1} represents the same meaning as described above.
R^{Y4} represents a hydrogen atom, an alkyl group, a cycloalkyl group, an alkoxy group, a cycloalkoxy group, an aryl group or a monovalent heterocyclic group, and the foregoing groups optionally have a substituent.]

R^{Y4} is preferably an alkyl group, a cycloalkyl group, an alkoxy group, a cycloalkoxy group, an aryl group or a monovalent heterocyclic group, more preferably an aryl group, and the foregoing groups optionally have a substituent.

The constitutional unit represented by the formula (Y) includes, for example, constitutional units represented by the formula (Y-11) to the formula (Y-56).

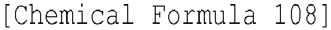

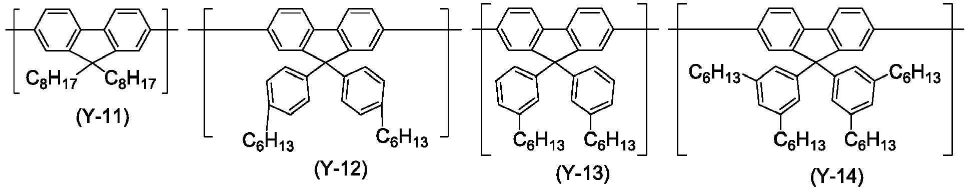

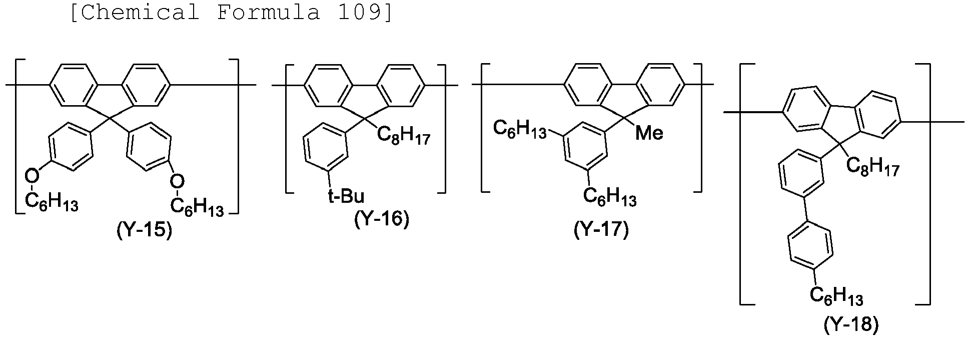

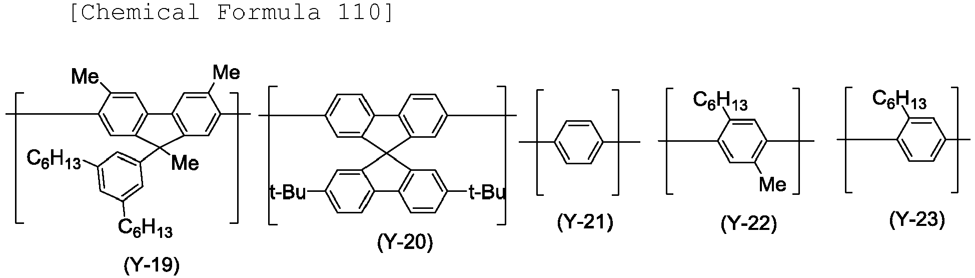

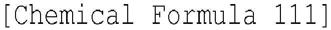

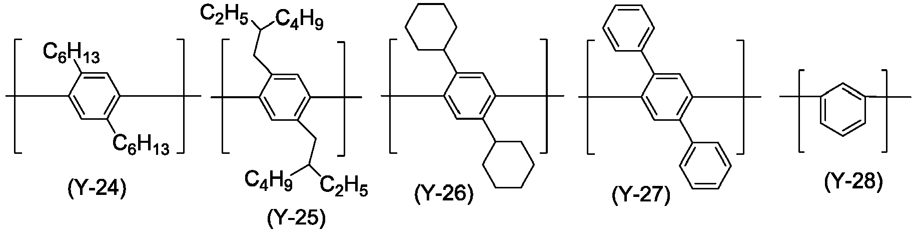

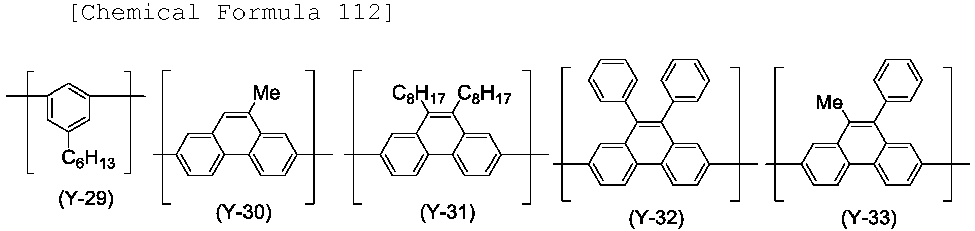

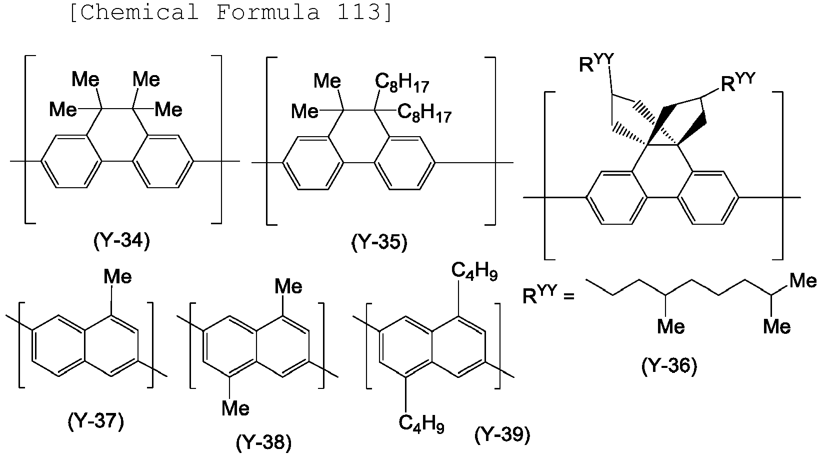

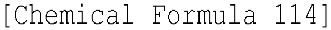

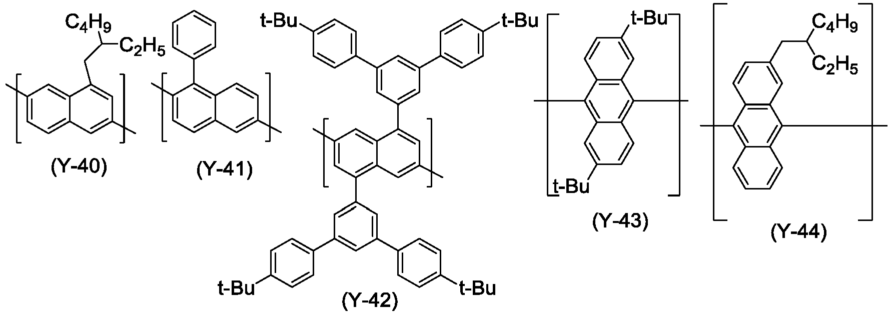

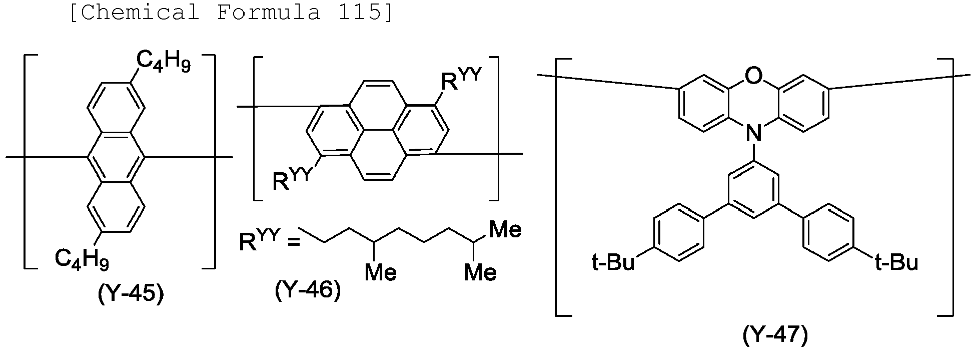

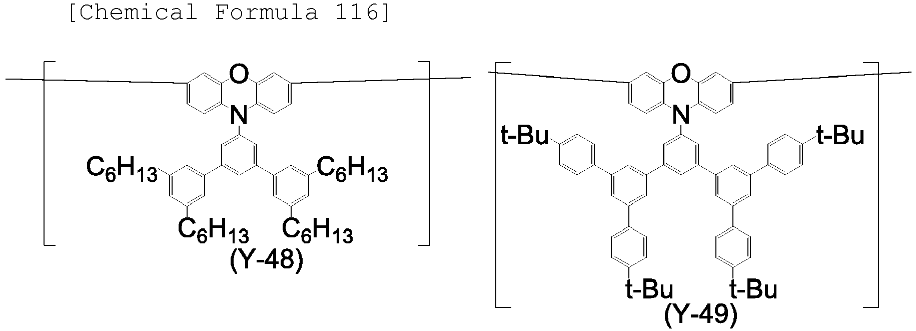

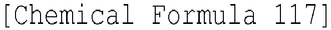

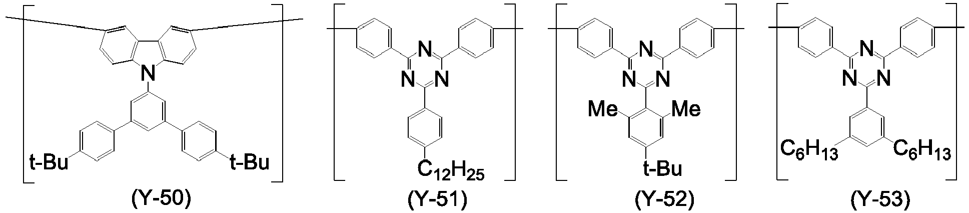

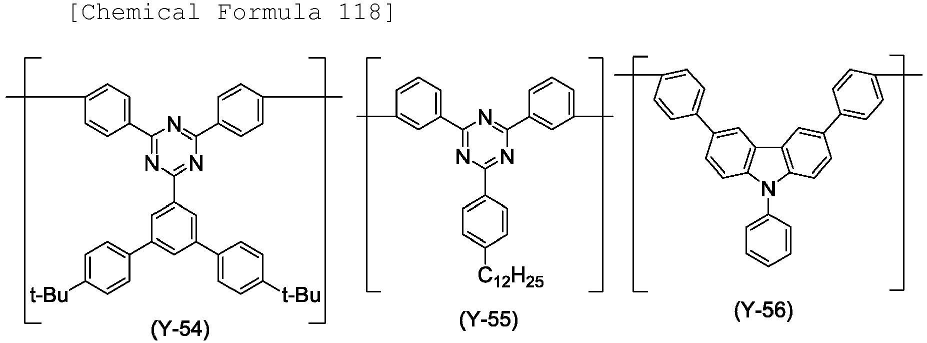

The amount of the constitutional unit represented by the formula (Y) in which Ar^{Y1} is an arylene group is preferably 0.5 to 80% by mol, more preferably 30 to 60% by mol, with respect to the total amount of the constitutional unit contained in the polymer compound of Layer A, since the light emitting device of the present invention is more excellent in luminance life.

The amount of the constitutional unit represented by the formula (Y) in which Ar^{Y1} is a divalent heterocyclic group or a divalent group in which at least one arylene group and at least one divalent heterocyclic group are bonded directly is preferably 0.1 to 90% by mol, more preferably 1 to 70% by mol, further preferably 10 to 50% by mol, with respect to the total amount of the constitutional unit contained in the polymer compound of Layer A, since the polymer compound of Layer A is excellent in charge transportability.

The constitutional unit represented by the formula (Y) may be contained only singly or in combination of two or more in the polymer compound of Layer A.

The polymer compound of Layer A includes, for example, polymer compounds P-1 to P-3. "Other" constitutional unit denotes a constitutional unit other than the phosphorescent constitutional unit, the constitutional unit represented by the formula (X) and the constitutional unit represented by the formula (Y).

**[Table 1]**

| polymer compound | constitutional unit and mol fraction thereof | | | |
|---|---|---|---|---|
| | phosphorescent constitutional unit | the formula (X) | the formula (Y) | others |
| | p'' | q'' | r'' | s'' |
| P-1 | 0.1 to 99.9 | 0.1 to 99.9 | 0 | 0 to 30 |
| P-2 | 0.1 to 99.9 | 0 | 0.1 to 99.9 | 0 to 30 |
| P-3 | 0.1 to 99.8 | 0.1 to 99.8 | 0.1 to 99.8 | 0 to 30 |

| | | | | |
|---|---|---|---|---|
| [in the table, p'', q'', r'' and s'' represent the mol fraction of each constitutional unit. p''+q''+r''+s'' = 100 and 70 ≤ p''+q''+r'' ≤ 100.] | | | | |

The polymer compound of Layer A is preferably a polymer compound containing a phosphorescent constitutional unit and a constitutional unit having a crosslinking group (hereinafter, referred to also as "polymer compound of Layer A'"), since the light emitting device of the present invention can be formed by an application method, and further, lamination is easy in the light emitting device. That is, the cross-linked body of the polymer compound of Layer A is preferably a cross-linked body of the polymer compound of Layer A'.

The amount of the constitutional unit having a crosslinking group contained in the polymer compound of Layer A' is preferably 0.5 to 80% by mol, more preferably 3 to 65% by mol, further preferably 5 to 50% by mol, with respect to the total amount of the constitutional unit contained in the polymer compound of Layer A', since the polymer compound of Layer A' is excellent in stability and crosslinkability. The constitutional unit having a crosslinking group may be contained only singly or in combination of two or more in the polymer compound of Layer A' .

In the constitutional unit having a crosslinking group contained in the polymer compound of Layer A', the crosslinking group is preferably a crosslinking group selected from Group A of crosslinking group, since the light emitting device of the present invention is more excellent in luminance life.

The crosslinking group selected from Group A of crosslinking group is preferably a crosslinking group represented by the formula (XL-1) to the formula (XL-4), the formula (XL-7) to the formula (XL-10) or the formula (XL-14) to the formula (XL-17), more preferably a crosslinking group represented by the formula (XL-1), the formula (XL-3), the formula (XL-9), the formula (XL-10), the formula (XL-16) or the formula (XL-17), further preferably a crosslinking group represented by the formula (XL-1), the formula (XL-16) or the formula (XL-17), particularly preferably a crosslinking group represented by the formula (XL-1) or the formula (XL-17), especially preferably a crosslinking group represented by the formula (XL-17), since the light emitting device of the present invention is more excellent in luminance life.

When the polymer compound of Layer A' contains two or more constitutional units having at least one crosslinking group selected from Group A of crosslinking group, it is preferable that at least two constitutional units having at least one crosslinking group selected from Group A of crosslinking group are mutually different. The combination of mutually different crosslinking groups is preferably a combination of a crosslinking group represented by the formula (XL-1), the formula (XL-2), the formula (XL-5) to the formula (XL-8) or the formula (XL-14) to the formula (XL-16) with a crosslinking group represented by the formula (XL-3), the formula (XL-4), the formula (XL-13) or the formula (XL-17), more preferably a combination of a crosslinking group represented by the formula (XL-1) or the formula (XL-16) with a crosslinking group represented by the formula (XL-17), further preferably a combination of a crosslinking group represented by the formula (XL-1) with a crosslinking group represented by the formula (XL-17).

The constitutional unit having a crosslinking group selected from Group A of crosslinking group contained in the polymer compound of Layer A' is preferably a constitutional unit represented by the formula (2) or a constitutional unit represented by the formula (2'), and constitutional units represented by the following formulae may also be permissible.

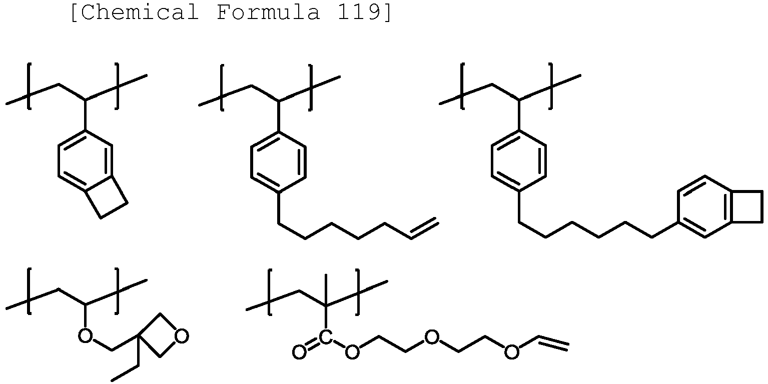

### Constitutional unit represented by the formula (2)

nA is preferably an integer of 0 to 3, more preferably an integer of 0 to 2, further preferably 1 or 2, particularly preferably 1, since the light emitting device of the present invention is more excellent in luminance life.

n is preferably 2, since the light emitting device of the present invention is more excellent in luminance life.

Ar³ is preferably an aromatic hydrocarbon group optionally having a substituent, since the light emitting device of the present invention is more excellent in luminance life.

The number of carbon atoms of the aromatic hydrocarbon group represented by Ar³ is, not including the number of carbon atoms of the substituent, usually 6 to 60, preferably 6 to 30, more preferably 6 to 18.

The arylene group portion obtained by removing n substituents from an aromatic hydrocarbon group represented by Ar³ is preferably a group represented by the formula (A-1) to the formula (A-20), more preferably a group represented by the formula (A-1), the formula (A-2), the formula (A-6) to the formula (A-10), the formula (A-19) or the formula (A-20), further preferably a group represented by the formula (A-1), the formula (A-2), the formula (A-7), the formula (A-9) or the formula (A-19), and the foregoing groups optionally have a substituent.

The number of carbon atoms of the heterocyclic group represented by Ar³ is, not including the number of carbon atoms of the substituent, usually 2 to 60, preferably 3 to 30, more preferably 4 to 18.

The divalent heterocyclic group portion obtained by removing n substituents from a heterocyclic group represented by Ar³ is preferably a group represented by the formula (AA-1) to the formula (AA-34).

The aromatic hydrocarbon group and the heterocyclic group represented by Ar³ optionally have a substituent, and the substituent is preferably an alkyl group, a cycloalkyl group, an alkoxy group, a cycloalkoxy group, an aryl group, an aryloxy group, a halogen atom, a monovalent heterocyclic group or a cyano group.

The number of carbon atoms of the alkylene group represented by L^{A} is, not including the number of carbon atoms of the substituent, usually 1 to 20, preferably 1 to 15, more preferably 1 to 10. The number of carbon atoms of the cycloalkylene group represented by L^{A} is, not including the number of carbon atoms of the substituent, usually 3 to 20.

The alkylene group and the cycloalkylene group optionally have a substituent and examples thereof include a methylene group, an ethylene group, a propylene group, a butylene group, a hexylene group, a cyclohexylene group and an octylene group.

The alkylene group and the cycloalkylene group represented by L^{A} optionally have a substituent. The substituent which the alkylene group and the cycloalkylene group optionally have is preferably an alkyl group, a cycloalkyl group, an alkoxy group, a cycloalkoxy group, a halogen atom or a cyano group, and the foregoing groups optionally further have a substituent.

The arylene group represented by L^{A} optionally has a substituent. The arylene group is preferably a phenylene group or a fluorenediyl group, more preferably a m-phenylene group, a p-phenylene group, a fluorene-2,7-diyl group or a fluorene-9,9-diyl group. The substituent which the arylene group optionally has is preferably an alkyl group, a cycloalkyl group, an alkoxy group, a cycloalkoxy group, an aryl group, an aryloxy group, a monovalent heterocyclic group, a halogen atom, a cyano group or a crosslinking group selected from Group A of crosslinking group, and the foregoing groups optionally further have a substituent.

The divalent heterocyclic group represented by L^{A} is preferably a group represented by the formula (AA-1) to the formula (AA-34).

L^{A} is preferably an arylene group or an alkylene group, more preferably a phenylene group, a fluorenediyl group or an alkylene group, and the foregoing groups optionally have a substituent, since production of the polymer compound of Layer A' is easy.

The crosslinking group represented by X is preferably a crosslinking group represented by the formula (XL-1) to the formula (XL-4), the formula (XL-7) to the formula (XL-10) or the formula (XL-14) to the formula (XL-17), more preferably a crosslinking group represented by the formula (XL-1), the formula (XL-3), the formula (XL-9), the formula (XL-10), the formula (XL-16) or the formula (XL-17), further preferably a crosslinking group represented by the formula (XL-1), the formula (XL-16) or the formula (XL-17), particularly preferably a crosslinking group represented by the formula (XL-1) or the formula (XL-17), especially preferably a crosslinking group represented by the formula (XL-17), since the light emitting device of the present invention is more excellent in luminance life.

The amount of the constitutional unit represented by the formula (2) is preferably 0.5 to 80% by mol, more preferably 3 to 65% by mol, further preferably 5 to 50% by mol, with respect to the total amount of the constitutional unit contained in the polymer compound of Layer A', since the polymer compound of Layer A' is excellent in stability and crosslinkability.

The constitutional unit represented by the formula (2) may be contained only singly or in combination of two or more in the polymer compound of Layer A'.

When the polymer compound of Layer A' contains two or more constitutional units represented by the formula (2), it is preferable for at least two constitutional units represented by the formula (2) that crosslinking groups represented by X are mutually different. The preferable range of the combination of the mutually different crosslinking groups represented by X is the same as the preferable range of the combination of mutually different crosslinking groups described above.

### Constitutional unit represented by the formula (2')

mA is preferably an integer of 0 to 3, more preferably an integer of 0 to 2, further preferably 0 or 1, particularly preferably 0, since the light emitting device of the present invention is more excellent in luminance life.

m is preferably 1 or 2, more preferably 2, since the light emitting device of the present invention is more excellent in luminance life.

c is preferably 0, since production of the polymer compound of Layer A' is easy and since the light emitting device of the present invention is more excellent in luminance life.

Ar⁵ is preferably an aromatic hydrocarbon group optionally having a substituent, since the light emitting device of the present invention is more excellent in luminance life.

The definition and examples of the arylene group portion obtained by removing m substituents from an aromatic hydrocarbon group represented by Ar⁵ are the same as the definition and examples of the arylene group represented by Ar^{x2} in the formula (X).

The definition and examples of the divalent heterocyclic group portion obtained by removing m substituents from a heterocyclic group represented by Ar⁵ are the same as the definition and examples of the divalent heterocyclic group represented by Ar^{x2} in the formula (X).

The definition and examples of the divalent group obtained by removing m substituents from a group in which at least one aromatic hydrocarbon group and at least one heterocyclic group are bonded directly represented by Ar⁵ are the same as the definition and examples of the divalent group in which at least one arylene group and at least one divalent heterocyclic group are bonded directly represented by Ar^{x2} in the formula (X).

Ar⁴ and Ar⁶ are each preferably an arylene group optionally having a substituent, since the light emitting device of the present invention is more excellent in luminance life.

The definition and examples of the arylene group represented by Ar⁴ and Ar⁶ are the same as the definition and examples of the arylene group represented by Ar^{x1} and Ar^{x3} in the formula (X) described later.

The definition and examples of the divalent heterocyclic group represented by Ar⁴ and Ar⁶ are the same as the definition and examples of the divalent heterocyclic group represented by Ar^{x1} and Ar^{x3} in the formula (X) described later.

The group represented by Ar⁴, Ar⁵ and Ar⁶ optionally have a substituent, and the substituent is preferably an alkyl group, a cycloalkyl group, an alkoxy group, a cycloalkoxy group, an aryl group, an aryloxy group, a halogen atom, a monovalent heterocyclic group and a cyano group.

The definition and examples of the alkylene group, the cycloalkylene group, the arylene group and the divalent heterocyclic group represented by K^{A} are the same as the definition and examples of the alkylene group, the cycloalkylene group, the arylene group and the divalent heterocyclic group represented by L^{A}, respectively.

K^{A} is preferably a phenylene group or a methylene group, since production of the polymer compound of Layer A' is easy.

The definition and examples of the crosslinking group represented by X' are the same as the definition and examples of the crosslinking group represented by X described above.

The amount of the constitutional unit represented by the formula (2') is preferably 0.5 to 50% by mol, more preferably 3 to 30% by mol, further preferably 5 to 20% by mol, with respect to the total amount of the constitutional unit contained in the polymer compound of Layer A', since the polymer compound of Layer A' is excellent in stability and the polymer compound of Layer A' is excellent in crosslinkability.

The constitutional unit represented by the formula (2') may be contained only singly or in combination of two or more in the polymer compound of Layer A'.

When the polymer compound of Layer A' contains two constitutional units represented by the formula (2'), it is preferable for at least two constitutional units represented by the formula (2') that crosslinking groups represented by X' are mutually different. The preferable range of the combination of the mutually different crosslinking groups represented by X' are the same as the preferable range of the combination of mutually different crosslinking groups described above.

### Preferable embodiments of constitutional unit represented by the formula (2) or (2')

The constitutional unit represented by the formula (2) includes, for example, constitutional units represented by the formula (2-1) to the formula (2-30), and the constitutional unit represented by the formula (2') includes, for example, constitutional units represented by the formula (2'-1) to the formula (2'-9). Of them, preferable are constitutional units represented by the formula (2-1) to the formula (2-30), more preferable are constitutional units represented by the formula (2-1) to the formula (2-15), the formula (2-19), the formula (2-20), the formula (2-23), the formula (2-25) or the formula (2-30), further preferable are constitutional units represented by the formula (2-1) to the formula (2-9) or the formula (2-30), since the polymer compound of Layer A' is excellent in crosslinkability.

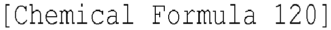

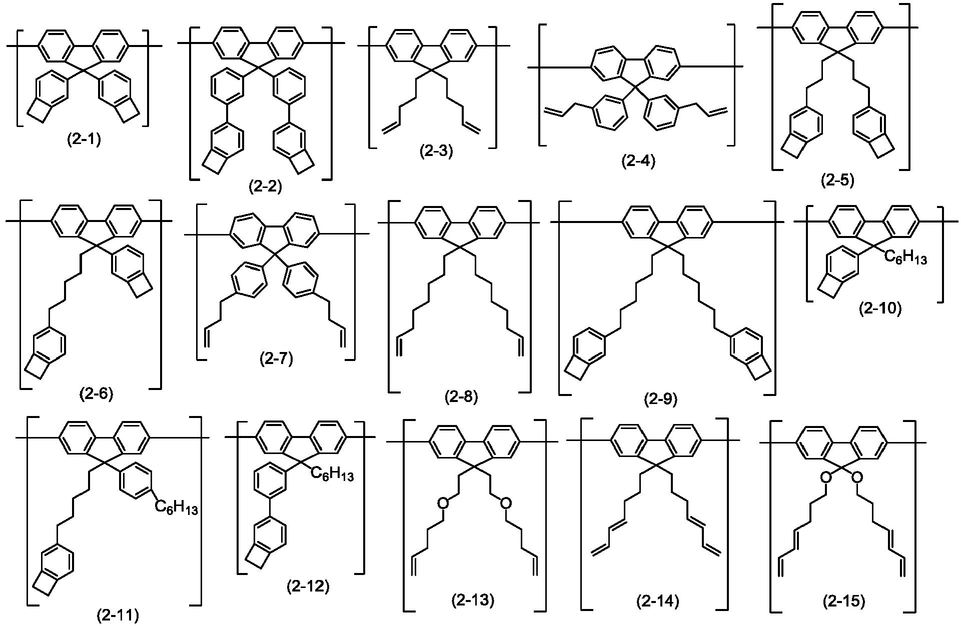

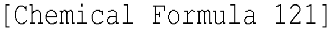

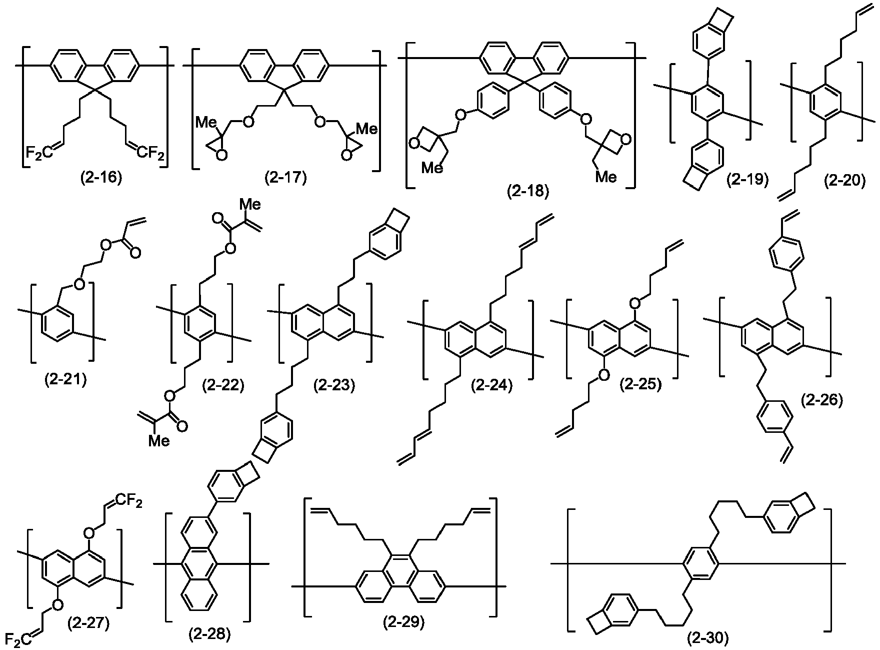

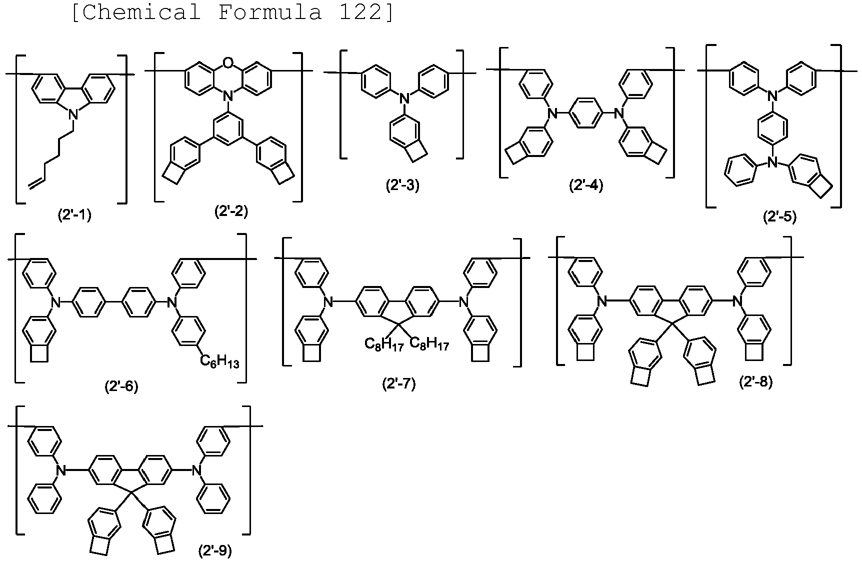

The polymer compound of Layer A' includes, for example, polymer compounds P-4 to P-15. "Other" constitutional unit denotes a constitutional unit other than the phosphorescent constitutional unit, the constitutional unit having a crosslinking group, the constitutional unit represented by the formula (X) and the constitutional unit represented by the formula (Y).

**[Table 2]**

| polymer compound | constitutional unit and mol fraction thereof | | | | | |
|---|---|---|---|---|---|---|
| | phosphorescent constitutional unit | constitutional unit having a crosslinking group | | the formula (X) | the formula (Y) | others |
| | | the formula (2) | the formula (2') | | | |
| | p'" | q'" | r'" | s'" | t'" | u'" |
| P-4 | 0.1 to 99.9 | 0.1 to 99.9 | 0 | 0 | 0 | 0 to 30 |
| P-5 | 0.1 to 99.9 | 0 | 0.1 to 99.9 | 0 | 0 | 0 to 30 |
| P-6 | 0.1 to 99.8 | 0.1 to 99.8 | 0.1 to 99.8 | 0 | 0 | 0 to 30 |
| P-7 | 0.1 to 99.8 | 0.1 to 99.8 | 0 | 0.1 to 99.8 | 0 | 0 to 30 |
| P-8 | 0.1 to 99.8 | 0.1 to 99.8 | 0 | 0 | 0.1 to 99.8 | 0 to 30 |
| P-9 | 0.1 to 99.8 | 0 | 0.1 to 99.8 | 0.1 to 99.8 | 0 | 0 to 30 |
| P-10 | 0.1 to 99.8 | 0 | 0.1 to 99.8 | 0 | 0.1 to 99.8 | 0 to 30 |
| P-11 | 0.1 to 99.7 | 0.1 to 99.7 | 0.1 to 99.7 | 0.1 to 99.7 | 0 | 0 to 30 |
| P-12 | 0.1 to 99.7 | 0.1 to 99.7 | 0.1 to 99.7 | 0 | 0.1 to 99.7 | 0 to 30 |
| P-13 | 0.1 to 99.7 | 0.1 to 99.7 | 0 | 0.1 to 99.7 | 0.1 to 99.7 | 0 to 30 |
| P-14 | 0.1 to 99.7 | 0 | 0.1 to 99.7 | 0.1 to 99.7 | 0.1 to 99.7 | 0 to 30 |
| P-15 | 0.1 to 99.6 | 0.1 to 99.6 | 0.1 to 99.6 | 0.1 to 99.6 | 0.1 to 99.6 | 0 to 30 |

| | | | | | | |
|---|---|---|---|---|---|---|
| [in the table, p'", q"', r"', s"', t"' and u"' represent the mol fraction of each constitutional unit. p"'+q"'+r"'+s"'+t"'+u"' = 100 and 70 ≤ p"'+q"'+r"'+s"'+t'" ≤ 100.] | | | | | | |

The polymer compound of Layer A and the polymer compound of Layer A' may be any of a block copolymer, a random copolymer, an alternating copolymer or a graft copolymer, and may also be a compound in other form, and a copolymer in which several raw material monomers are copolymerized is preferable.

The polymer compound of Layer A and the polymer compound of Layer A' have a polystyrene-equivalent number-average molecular weight of preferably 5×10³ to 1×10⁶, more preferably 1×10⁴ to 5×10⁵, further preferably 1.5×10⁴ to 1×10⁵.

### Production method of polymer compound of Layer A and polymer compound of Layer A'

The polymer compound of Layer A and the polymer compound of Layer A' can be produced by using known polymerization methods described in, for example, Chemical Review, vol. 109, pp. 897-1091 (2009), JP-A No. 2003-171659, International Publication WO 2006/003000, JP-A No. 2010-43243, JP-A No. 2011-105701, International Publication WO 2013/021180, JP-A No. 2015-174931 and JP-A No. 2015-174932, and methods of polymerizing by a coupling reaction using a transition metal catalyst such as Suzuki reaction, Yamamoto reaction, Buchwald reaction, Stille reaction, Negishi reaction, Kumada reaction and the like are exemplified.

The method of charging monomers in the above-described production method includes a method in which the whole monomer is charged in the reaction system at once, a method in which partial monomers are charged and reacted, then, the remaining monomers are charged at once, continuously or in parts, a method in which monomers are charged continuously or in parts, and the like.

The transition metal catalyst includes a palladium catalyst, a nickel catalyst and the like.

The post treatment of the polymerization reaction is conducted by using a known method, for example, a method of removing water-soluble impurities by liquid separation, a method of adding the reaction liquid after the polymerization reaction to a lower alcohol such as methanol and the like, filtrating the deposited precipitate, then, drying it, and other methods, singly or in combination. When the purity of the polymer host is low, it can be purified by a usual method such as, for example, crystallization, re-precipitation, continuous extraction with a Soxhlet extractor, column chromatography and the like.

### Composition of Layer A

Layer A may be a layer containing a composition (hereinafter, referred to also as "composition of Layer A") containing at least one of a polymer compound of Layer A and a cross-linked body of a polymer compound of Layer A, and at least one material selected from the group consisting of a hole transporting material, a hole injection material, an electron transporting material, an electron injection material, a light emitting material and an antioxidant. In the composition of Layer A, the hole transporting material, the hole injection material, the electron transporting material, the electron injection material and the light emitting material are different from the polymer compound of Layer A and the cross-linked body of the polymer compound of Layer A.

The examples and preferable range of the hole transporting material, the electron transporting material, the hole injection material and the electron injection material contained in the composition of Layer A are the same as the examples and preferable range of the hole transporting material, the electron transporting material, the hole injection material and the electron injection material contained in the first composition. The light emitting material contained in the composition of Layer A includes the phosphorescent compound and the light emitting material contained in the first composition, and examples and preferable range thereof are the same as the examples and preferable range of the phosphorescent compound and the light emitting material contained in the first composition, respectively. In the composition of Layer A, the contents of the hole transporting material, the electron transporting material, the hole injection material, the electron injection material and the light emitting material are each usually 1 to 1000 parts by mass, preferably 5 to 500 parts by mass, when the sum of the polymer compound of Layer A and the cross-linked body of the polymer compound of Layer A is taken as 100 parts by mass.

The examples and preferable range of the antioxidant contained in the composition of Layer A are the same as the examples and preferable range of the antioxidant contained in the first composition. In the composition of Layer A, the content of the antioxidant is usually 0.001 to 10 parts by mass, when the sum of the polymer compound of Layer A and the cross-linked body of the polymer compound of Layer A is taken as 100 parts by mass.

### Ink of Layer A and ink of Layer A'

Layer A can be formed using, for example, a composition containing a polymer compound of Layer A and a solvent (hereinafter, referred to also as "ink of Layer A") or a composition containing a polymer compound of Layer A' and a solvent (hereinafter, referred to also as "ink of Layer A'"), and is preferably formed using a composition containing a polymer compound of Layer A' and a solvent (hereinafter, referred to also as "ink of Layer A'").

The ink of Layer A and the ink of Layer A' can be suitably used for the application method explained in the section of the first ink. The preferable ranges of the viscosity of the ink of Layer A and the ink of Layer A' are the same as the preferable range of the viscosity of the first ink. The examples and preferable range of the solvent contained in the ink of Layer A and the ink of Layer A' are the same as the examples and preferable range of the solvent contained in the first ink.

In the ink of Layer A, the content of the solvent is usually 1000 to 100000 parts by mass, preferably 2000 to 20000 parts by mass, when the amount of the polymer compound of Layer A is taken as 100 parts by mass.

In the ink of Layer A', the content of the solvent is usually 1000 to 100000 parts by mass, preferably 2000 to 20000 parts by mass, when the amount of the polymer compound of Layer A' is taken as 100 parts by mass.

### [Layer B]

The phosphorescent compound represented by the formula (1) and the cross-linked body of a crosslinking material contained in Layer B each may be used singly or in combination of two or more.

### Crosslinking material

In Layer B, the crosslinking material includes, for example, low molecular compounds having a crosslinking group (hereinafter, referred to as "low molecular compound of Layer B") and polymer compounds containing a constitutional unit having a crosslinking group (hereinafter, referred to as "polymer compound of Layer B"), and is preferably a polymer compound of Layer B, since the light emitting device of the present invention is more excellent in luminance life.

The crosslinking group which the low molecular compound of Layer B and the polymer compound of Layer B have is preferably a crosslinking group selected from Group A of crosslinking group, since the light emitting device of the present invention is more excellent in luminance life. That is, in Layer B, the crosslinking material is preferably a low molecular compound having a crosslinking group selected from Group A of crosslinking group or a polymer compound containing a constitutional unit having a crosslinking group selected from Group A of crosslinking group, more preferably a polymer compound containing a constitutional unit having a crosslinking group selected from Group A of crosslinking group, since the light emitting device of the present invention is more excellent in luminance life.

The examples and preferable range of the crosslinking group selected from Group A of crosslinking group which the low molecular compound of Layer B and the polymer compound of Layer B optionally have are the same as the examples and preferable range of the crosslinking group selected from Group A of crosslinking group which the polymer compound Layer A' optionally has.

### Polymer compound of Layer B

The examples and preferable range of the constitutional unit having a crosslinking group contained in the polymer compound of Layer B are the same as the examples and preferable range of the constitutional unit having a crosslinking group contained in the polymer compound of Layer A'.

It is preferable that the polymer compound of Layer B contains no phosphorescent constitutional unit.

The amount of the constitutional unit having a crosslinking group contained in the polymer compound of Layer B is preferably 0.5 to 80% by mol, more preferably 3 to 65% by mol, further preferably 5 to 50% by mol, with respect to the total amount of the constitutional unit contained in the polymer compound of Layer B, since the polymer compound of Layer B is excellent in stability and crosslinkability. The constitutional unit having a crosslinking group may be contained only singly or in combination of two or more in the polymer compound of Layer B.

The constitutional unit having a crosslinking group contained in the polymer compound of Layer B is preferably a constitutional unit having a crosslinking group selected from Group A of crosslinking group, more preferably a constitutional unit represented by the formula (2) or a constitutional unit represented by the formula (2').

The examples and preferable range of the constitutional unit having a crosslinking group selected from Group A of crosslinking group which may be contained in the polymer compound of Layer B are the same as the examples and preferable range of the constitutional unit having a crosslinking group selected from Group A of crosslinking group which may be contained in the polymer compound of Layer A'.

The examples and preferable range of the constitutional unit represented by the formula (2) and the constitutional unit represented by the formula (2') which may be contained in the polymer compound of Layer B are the same as the examples and preferable range of the constitutional unit represented by the formula (2) and the constitutional unit represented by the formula (2') which may be contained in the polymer compound of Layer A', respectively.

When the polymer compound of Layer B contains a constitutional unit represented by the formula (2), the amount of the constitutional unit represented by the formula (2) is preferably 0.5 to 80% by mol, more preferably 3 to 65% by mol, further preferably 5 to 50% by mol, with respect to the total amount of the constitutional unit contained in the polymer compound of Layer B, since the polymer compound of Layer B is excellent in stability and crosslinkability. The constitutional unit represented by the formula (2) may be contained only singly or in combination of two or more in the polymer compound of Layer B.

When the polymer compound of Layer B contains a constitutional unit represented by the formula (2'), the amount of the constitutional unit represented by the formula (2') is preferably 0.5 to 50% by mol, more preferably 3 to 30% by mol, further preferably 5 to 20% by mol, with respect to the total amount of the constitutional unit contained in the polymer compound of Layer B, since the polymer compound of Layer B is excellent in stability and since the polymer compound of Layer A' is excellent in crosslinkability.

The constitutional unit represented by the formula (2') may be contained only singly or in combination of two or more in the polymer compound of Layer B.

It is preferable that the polymer compound of Layer B further contains a constitutional unit represented by the formula (X), since hole transportability is excellent. Moreover, it is preferable that the polymer compound of Layer B further contains a constitutional unit represented by the formula (Y), since the light emitting device of the present invention is more excellent in luminance life.

It is preferable that the polymer compound of Layer B further contains a constitutional unit represented by the formula (X) and a constitutional unit represented by the formula (Y), since hole transportability is excellent and since the light emitting device of the present invention is further excellent in luminance life.

The examples and preferable range of the constitutional unit represented by the formula (X) which may be contained in the polymer compound of Layer B are the same as the examples and preferable range of the constitutional unit represented by the formula (X) which may be contained in the polymer compound of Layer A.

When the polymer compound of Layer B contains a constitutional unit represented by the formula (X), the amount of the constitutional unit represented by the formula (X) contained in polymer compound of Layer B is preferably 1 to 90% by mol, more preferably 10 to 70% by mol, further preferably 30 to 50% by mol, with respect to the total amount of the constitutional unit contained in the polymer compound of Layer B, since hole transportability is more excellent.

The constitutional unit represented by the formula (X) may be contained only singly or in combination of two or more in the polymer compound of Layer B.

The examples and preferable range of the constitutional unit represented by the formula (Y) which may be contained in the polymer compound of Layer B are the same as the examples and preferable range of the constitutional unit represented by the formula (Y) which may be contained in the polymer compound of Layer A.

When the polymer compound of Layer B contains a constitutional unit represented by the formula (Y) and Ar^{Y1} is an arylene group, the amount of the constitutional unit represented by the formula (Y) contained in the polymer compound of Layer B is preferably 0.5 to 90% by mol, more preferably 30 to 80% by mol, with respect to the total amount of the constitutional unit contained in the polymer compound of Layer B, since the light emitting device of the present invention is more excellent in luminance life.

When the polymer compound of Layer B contains a constitutional unit represented by the formula (Y) and Ar^{Y1} is a divalent heterocyclic group or a divalent group in which an arylene group and a divalent heterocyclic group are bonded directly, the amount of the constitutional unit represented by the formula (Y) contained in the polymer compound of Layer B is preferably 0.5 to 50% by mol, more preferably 3 to 30% by mol, with respect to the total amount of the constitutional unit contained in the polymer compound of Layer B, since the light emitting device of the present embodiment is more excellent in charge transpostability.

The constitutional unit represented by the formula (Y) may be contained only singly or in combination of two or more in the polymer compound of Layer B.

The polymer compound of Layer B includes, for example, polymer compounds P-16 to P-23. "Other" constitutional unit denotes a constitutional unit other than the constitutional units represented by the formula (2), the formula (2'), the formula (X) and the formula (Y).

**[Table 3]**

| polymer compound | constitutional unit and mol fraction thereof | | | | |
|---|---|---|---|---|---|
| | the formula (2) | the formula (2') | the formula (X) | the formula (Y) | others |
| | p' | q' | r' | s' | t' |
| P-16 | 0.1 to 99.9 | 0.1 to 99.9 | 0 | 0 | 0 to 30 |
| P-17 | 0.1 to 99.9 | 0 | 0.1 to 99.9 | 0 | 0 to 30 |
| P-18 | 0.1 to 99.9 | 0 | 0 | 0.1 to 99.9 | 0 to 30 |
| P-19 | 0 | 0.1 to 99.9 | 0.1 to 99.9 | 0 | 0 to 30 |
| P-20 | 0 | 0.1 to 99.9 | 0 | 0.1 to 99.9 | 0 to 30 |
| P-21 | 0.1 to 99.8 | 0.1 to 99.8 | 0.1 to 99.8 | 0 | 0 to 30 |
| P-22 | 0.1 to 99.8 | 0.1 to 99.8 | 0 | 0.1 to 99.8 | 0 to 30 |
| P-23 | 0.1 to 99.7 | 0.1 to 99.7 | 0.1 to 99.7 | 0.1 to 99.7 | 0 to 30 |

| | | | | | |
|---|---|---|---|---|---|
| [in the table, p', q', r', s' and t' represent the mol fraction of each constitutional unit. p'+q'+r'+s'+t' = 100 and 70 ≤ p'+q'+r'+s' ≤ 100.] | | | | | |

The polymer compound of Layer B may be any of a block copolymer, a random copolymer, an alternating copolymer or a graft copolymer, and may also be a compound in other form, and a copolymer in which several raw material monomers are copolymerized is preferable.

The polymer compound of Layer B has a polystyrene-equivalent number-average molecular weight of preferably 5×10³ to 1×10⁶, more preferably 1×10⁴ to 5×10⁵, more preferably 1.5×10⁴ to 1×10⁵.

### Production method of polymer compound of Layer B

The polymer compound of Layer B can be produced by the same method as the production method of the polymer compound of Layer A and the polymer compound of Layer A'.

### Low molecular compound of Layer B

The low molecular compound of Layer B is preferably a low molecular compound represented by the formula (3). 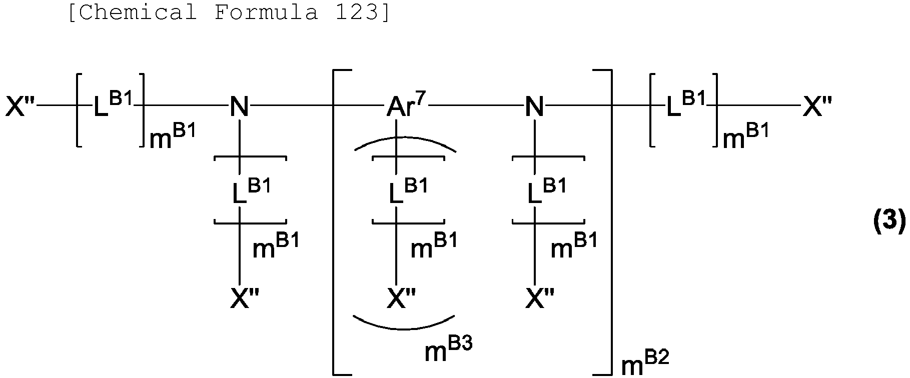 [wherein,
m^{B1}, m^{B2} and m^{B3} each independently represent an integer of 0 or more. A plurality of m^{B1} may be the same or different. When a plurality of m^{B3} are present, they may be the same or different.
Ar⁷ represents an aromatic hydrocarbon group, a heterocyclic group, or a group in which at least one aromatic hydrocarbon group and at least one heterocyclic group are bonded directly, and the foregoing groups optionally have a substituent. When a plurality of Ar⁷ are present, they may be the same or different.
L^{B1} represents an alkylene group, a cycloalkylene group, an arylene group, a divalent heterocyclic group, a group represented by -NR'"-, an oxygen atom or a sulfur atom, and the foregoing groups optionally have a substituent. R'" represents a hydrogen atom, an alkyl group, a cycloalkyl group, an aryl group or a monovalent heterocyclic group, and the foregoing groups optionally have a substituent. When a plurality of L^{B1} are present, they may be the same or different.
X" represents a crosslinking group, a hydrogen atom, an alkyl group, a cycloalkyl group, an aryl group or a monovalent heterocyclic group, and the foregoing groups optionally have a substituent. A plurality of X" may be the same or different. At least one of the plurality of X" is a crosslinking group.]

m^{B1} is usually an integer of 0 to 10, and it is preferably an integer of 0 to 5, more preferably an integer of 0 to 2, further preferably 0 or 1, particularly preferably 0, since synthesis of the low molecular compound of Layer B is easy.

m^{B2} is usually an integer of 0 to 10, and it is preferably an integer of 0 to 5, more preferably an integer of 0 to 3, further preferably 1 or 2, particularly preferably 1, since synthesis of the low molecular compound of Layer B is easy and since the light emitting device of the present invention is more excellent in luminance life.

m^{B3} is usually an integer of 0 to 5, and it is preferably an integer of 0 to 4, more preferably an integer of 0 to 2, further preferably 0, since synthesis of the low molecular compound of Layer B is easy.

The definition and examples of the arylene group portion obtained by removing m^{B3} substituents from an aromatic hydrocarbon group represented by Ar⁷ are the same as the definition and examples of the arylene group represented by Ar^{x2} in the formula (X) described above.

The definition and examples of the divalent heterocyclic group portion obtained by removing m^{B3} substituents from a heterocyclic group represented by Ar⁷ are the same as the definition and examples of the divalent heterocyclic group portion represented by Ar^{x2} in the formula (X) described above.

The definition and examples of the divalent group obtained by removing m^{B3} substituents from a group in which at least one aromatic hydrocarbon group and at least one heterocyclic group are bonded directly represented by Ar⁷ are the same as the definition and examples of the divalent group in which at least one arylene group and at least one divalent heterocyclic group are bonded directly represented by Ar^{x2} in the formula (X) described above.

The definition and examples of the substituent which the group represented by Ar⁷ optionally has are the same as the definition and examples of the substituent which the group represented by Ar^{x2} optionally has in the formula (X) described above.

Ar⁷ is preferably an aromatic hydrocarbon group, and this aromatic hydrocarbon group optionally has a substituent, since the light emitting device of the present invention is more excellent in luminance life.

The definition and examples of the alkylene group, the cycloalkylene group, the arylene group and the divalent heterocyclic group represented by L^{B1} are the same as the definition and examples of the alkylene group, the cycloalkylene group, the arylene group and the divalent heterocyclic group represented by L^{A} described above, respectively.

L^{B1} is preferably an alkylene group, an arylene group or an oxygen atom, more preferably an alkylene group or an arylene group, further preferably a phenylene group, a fluorenediyl group or an alkylene group, particularly preferably a phenylene group or an alkylene group, and the foregoing groups optionally have a substituent, since synthesis of the low molecular compound of Layer B is easy.

X" is preferably a crosslinking group represented by any of the formula (XL-1) to the formula (XL-17), an aryl group or a monovalent heterocyclic group, more preferably a crosslinking group represented by the formula (XL-1), the formula (XL-3), the formula (XL-7) to the formula (XL-10), the formula (XL-16) or the formula (XL-17) or an aryl group, further preferably a crosslinking group represented by the formula (XL-1), the formula (XL-16) or the formula (XL-17), a phenyl group, a naphthyl group or a fluorenyl group, particularly preferably a crosslinking group represented by the formula (XL-16) or the formula (XL-17), a phenyl group or a naphthyl group, especially preferably a crosslinking group represented by the formula (XL-16) or a naphthyl group, and the foregoing groups optionally have a substituent.

The low molecular compound of Layer B includes, for example, compounds represented by the formula (3-1) to the formula (3-16), and is preferably a compound represented by the formula (3-1) to the formula (3-10), more preferably a compound represented by the formula (3-5) to the formula (3-9) .

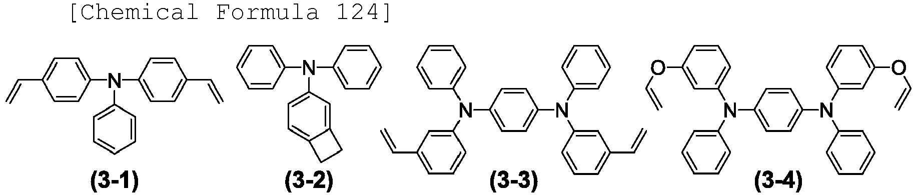

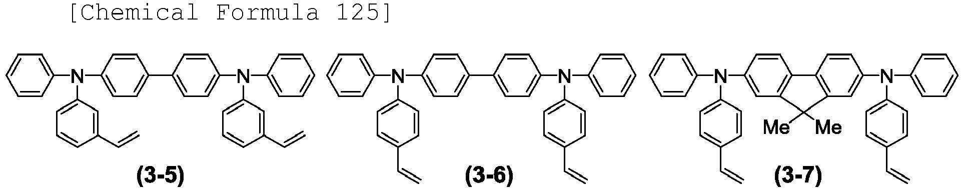

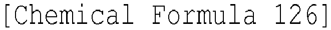

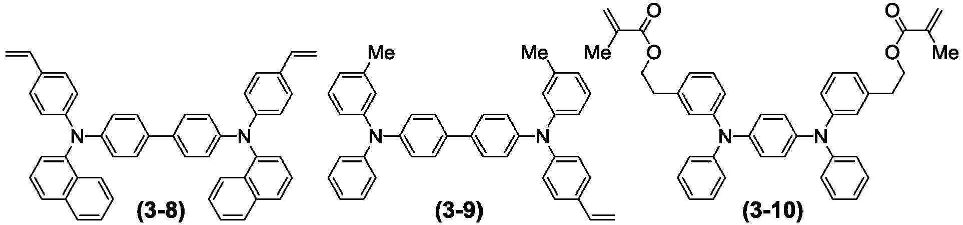

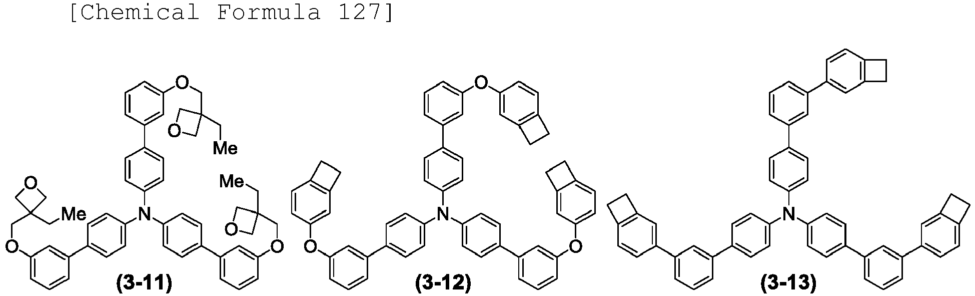

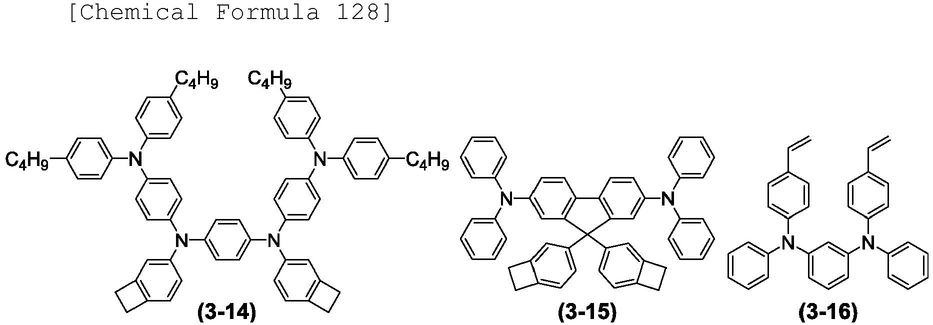

The low molecular compound of Layer B is available from, for example, Aldrich, Luminescence Technology Corp. and American Dye Source. The low molecular compound of Layer B can be synthesized according to methods described in, for example, International Publication WO 1997/033193, International Publication WO 2005/035221 and International Publication WO 2005/049548, as other means.

### Phosphorescent compound represented by the formula (1) contained in Layer B

The examples and preferable range of the phosphorescent compound represented by the formula (1) contained Layer B are the same as the examples and preferable range of the phosphorescent compound represented by the formula (1) as the phosphorescent compound which may be contained in the first organic layer.

The phosphorescent compound represented by the formula (1) contained Layer B is preferably a phosphorescent compound represented by the formula (1-A) or a phosphorescent compound represented by the formula (1-B), more preferably a phosphorescent compound represented by the formula (1-B), since the light emitting device of the present invention is more excellent in luminance life. When the phosphorescent compound represented by the formula (1-A) is contained in Layer B, the phosphorescent compound represented by the formula (1-A) is preferably a phosphorescent compound represented by the formula (1-A1) to the formula (1-A5), more preferably a phosphorescent compound represented by the formula (1-A1), the formula (1-A3) or the formula (1-A4), further preferably a phosphorescent compound represented by the formula (1-A4), since the light emitting device of the present invention is more excellent in luminance life. When the phosphorescent compound represented by the formula (1-B) is contained in Layer B, the phosphorescent compound represented by the formula (1-B) is preferably a phosphorescent compound represented by the formula (1-B1) to the formula (1-B5), more preferably a phosphorescent compound represented by the formula (1-B1) to the formula (1-B3), further preferably a phosphorescent compound represented by the formula (1-B1), since the light emitting device of the present invention is more excellent in luminance life.

### Composition of Layer B

Layer B may be a layer containing a composition (hereinafter, referred to also as "composition of Layer B") containing a phosphorescent compound represented by the formula (1) and at least one material selected from the group consisting of a hole transporting material, a hole injection material, an electron transporting material, an electron injection material, a light emitting material and an antioxidant. In the composition of Layer B, the hole transporting material, the hole injection material, the electron transporting material and the electron injection material are different from the cross-linked body of a crosslinking material, and the light emitting material is different from the phosphorescent compound represented by the formula (1) and the cross-linked body of a crosslinking material.

The examples and preferable range of the hole transporting material, the electron transporting material, the hole injection material, the electron injection material and the light emitting material contained in the composition of Layer B are the same as the examples and preferable range of the hole transporting material, the electron transporting material, the hole injection material, the electron injection material and the light emitting material contained in the first composition.

In the composition of Layer B, the contents of the hole transporting material, the electron transporting material, the hole injection material, the electron injection material and the light emitting material are each usually 1 to 1000 parts by mass, preferably 5 to 500 parts by mass, when the sum of the phosphorescent compound represented by the formula (1) and the cross-linked body of a crosslinking material is taken as 100 parts by mass.

The examples and preferable range of the antioxidant contained in the composition of Layer B are the same as the examples and preferable range of the antioxidant contained in the first composition. In the composition of Layer B, the content of the antioxidant is usually 0.001 to 10 parts by mass, when the sum of the phosphorescent compound represented by the formula (1) and the cross-linked body of a crosslinking material is taken as 100 parts by mass.

### Ink of Layer B

Layer B can be formed using, for example, a composition containing a phosphorescent compound represented by the formula (1), a crosslinking material and a solvent (hereinafter, referred to also as "ink of Layer B") .

The ink of Layer B can be suitably used for the application method explained in the section of the first ink. The preferable range of the viscosity of the ink of Layer B is the same as the preferable range of the viscosity of the first ink. The examples and preferable range of the solvent contained in the ink of Layer B are the same as the examples and preferable range of the solvent contained in the first ink.

In the ink of Layer B, the content of the solvent is usually 1000 to 100000 parts by mass, preferably 2000 to 20000 parts by mass, when the sum of a phosphorescent compound represented by the formula (1) and a crosslinking material is taken as 100 parts by mass.

### <Layer constitution of light emitting device>

The light emitting device of the present invention may have layers other than the anode, the cathode, the first organic layer and the second organic layer.

In the light emitting device of the present invention, the first organic layer is usually a light emitting layer (hereinafter, referred to as "first light emitting layer").

In the light emitting device of the present invention, the second organic layer is usually a hole transporting layer, a light emitting layer (namely, a light emitting layer different from the first light emitting layer, hereinafter referred to as "second light emitting layer") or an electron transporting layer, preferably a hole transporting layer or a second light emitting layer, more preferably a second light emitting layer.

In the light emitting device of the present invention, when a first light emitting layer and a second light emitting layer are present, it is possible to control the light emission color of the light emitting device and it is also possible to control the light emission color to white by adjusting the light emission color of the first light emitting layer and the light emission color of the second light emitting layer.

For example, when the first light emitting layer is a first organic layer containing a compound represented by the formula (C-1) and a phosphorescent compound (hereinafter, referred to a "first phosphorescent light emitting layer") and the second light emitting layer is a second organic layer, it is possible to control the light emission color and it is also possible to control the light emission color to white by adjusting the ratio of the content of a phosphorescent compound in the first phosphorescent light emitting layer to the content of a phosphorescent compound represented by the formula (1) and a polymer compound of Layer A or a cross-linked body of a polymer compound of Layer A in the second organic layer.

The light emission color of a light emitting device can be confirmed by determining the chromaticity coordinate (CIE chromaticity coordinate) by measuring the emission chromaticity of the light emitting device. In the white light emission color, X of the chromaticity coordinate is in the range of 0.20 to 0.55 and Y of the chromaticity coordinate is in the range of 0.20 to 0.55, preferable X of the chromaticity coordinate is in the range of 0.25 to 0.50 and Y of the chromaticity coordinate is in the range of 0.25 to 0.50.

The maximum peak wavelength of at least one emission spectrum of a phosphorescent compound contained in a first phosphorescent light emitting layer is preferably 380 nm or more and less than 495 nm, more preferably 420 nm or more and 480 nm or less from the standpoint of controlling the light emission color of the light emitting device of the present invention (particularly, standpoint of controlling the light emission color to white, hereinafter referred to simply as "same standpoint").

From the same standpoint, the first phosphorescent light emitting layer is preferably a layer containing two or more phosphorescent compounds. In this case, it is preferable that the maximum peak wavelengths of the emission spectra of at least two phosphorescent compounds represented by the formula (1) contained in the first phosphorescent light emitting layer are mutually different, and its difference is preferably 10 to 200 nm, more preferably 20 to 100 nm. Regarding the combination of the maximum peak wavelengths of the emission spectra of at least two phosphorescent compounds, it is preferable that one is 380 nm or more and less the 495 nm and the other is 495 nm or more and 750 nm or less, it is more preferable that one is 420 nm or more and 480 nm or less and the other is 500 nm or more and 570 nm or less.

From the same standpoint, when the second organic layer is a Layer A, the maximum peak wavelength of the emission spectrum of at least one of a phosphorescent compound corresponding to the residue of a phosphorescent compound represented by the formula (1) contained in a polymer compound of Layer A and a phosphorescent compound corresponding to the residue of a phosphorescent compound represented by the formula (1) contained in a polymer compound of Layer A' is preferably 495 nm or more and 750 nm or less, more preferably 590 nm or more and 640 nm or less.

From the same standpoint, when the second organic layer is Layer A, the emission spectrum of at least one of a polymer compound of Layer A and a polymer compound of Layer A' preferably has a maximal wavelength at 495 nm or more and 750 nm or less, more preferably has a maximal wavelength at 590 nm or more and 640 nm or less.

From the same standpoint, when the second organic layer is Layer B, the maximum peak wavelength of the emission spectrum of at least one of the phosphorescent compound represented by the formula (1) contained in Layer B is preferably 495 nm or more and 750 nm or less, more preferably 590 nm or more and 640 nm or less.

From the same standpoint, when the second organic layer is Layer A, it is preferable that the polymer compound of Layer A contains two or more phosphorescent compounds corresponding to the residue of a phosphorescent compound represented by the formula (1) contained in the polymer compound of Layer A. Further, it is preferable that the polymer compound of Layer A' contains two or more phosphorescent compounds corresponding to the residue of a phosphorescent compound represented by the formula (1) contained in the polymer compound of Layer A'. In these cases, it is preferable that the maximum peak wavelengths of the emission spectra of at least two phosphorescent compounds corresponding to the residue of a phosphorescent compound represented by the formula (1) are mutually different, and its difference is preferably 20 to 200 nm, more preferably 40 to 120 nm. Regarding the combination of the maximum peak wavelengths of the emission spectra of at least two phosphorescent compounds corresponding to the residue of a phosphorescent compound represented by the formula (1), it is preferable that one is 495 nm or more and 570 nm or less and the other is 590 nm or more and 640 nm or less.

From the same standpoint, when the second organic layer is Layer A, it is preferable that Layer A further contains a light emitting material different from the polymer compound of Layer A and the polymer compound of Layer A', and the examples and preferable range of this light emitting material are the same as the examples and preferable range of the light emitting material contained in the composition of Layer A. In this case, it is preferable that the maximum peak wavelength of the emission spectrum of a phosphorescent compound corresponding to the residue of a phosphorescent compound represented by the formula (1) contained in the polymer compound of Layer A and the polymer compound of Layer A' and the maximum peak wavelength of the emission spectrum of a light emitting material different from the polymer compound of Layer A and the polymer compound of Layer A' are mutually different, and its difference is preferably 20 to 200 nm, more preferably 40 to 120 nm. Regarding the combination of the maximum peak wavelength of the emission spectrum of a phosphorescent compound corresponding to the residue of a phosphorescent compound represented by the formula (1) and the maximum peak wavelength of the emission spectrum of a light emitting material different from the polymer compound of Layer A and the polymer compound of Layer A', it is preferable that one is 495 nm or more and 570 nm or less and the other is 590 nm or more and 640 nm or less.

From the same standpoint, when the second organic layer is Layer B, it is preferable that Layer B is a layer containing two or more phosphorescent compounds represented by the formula (1). In this case, it is preferable that the maximum peak wavelengths of the emission spectra of at least two phosphorescent compounds represented by the formula (1) contained in Layer B are mutually different, and its difference is preferably 20 to 200 nm, more preferably 40 to 120 nm. Regarding the combination of the maximum peak wavelengths of the emission spectra of at least two phosphorescent compounds represented by the formula (1), it is preferable that one is 495 nm or more and 570 nm or less and the other is 590 nm or more and 640 nm or less.

The maximum peak wavelength and the maximal wavelength of the emission spectrum of a compound can be evaluated by dissolving the compound in an organic solvent such as xylene, toluene, chloroform, tetrahydrofuran and the like to prepare a dilute solution (1×10⁻⁶ to 1×10⁻³% by mass), and measuring the PL spectrum of the dilute solution at room temperature. The organic solvent for dissolving a compound is preferably toluene or xylene.

In the light emitting device of the present invention, it is preferable that the first organic layer and the second organic layer are adjacent, since the light emitting device of the present invention is more excellent in luminance life. In the light emitting device of the present invention, the second organic layer is preferably a layer disposed between an anode and the first organic layer, more preferably a hole transporting layer or a second light emitting layer disposed between an anode and the first organic layer, further preferably a second light emitting layer disposed between an anode and the first organic layer, since the light emitting device of the present invention is more excellent in luminance life.

In the light emitting device of the present invention, when the second organic layer is a hole transporting layer disposed between an anode and the first organic layer, it is preferable that a hole injection layer is further present between an anode and the second organic layer, since the light emitting device of the present invention is more excellent in luminance life. When the second organic layer is a hole transporting layer disposed between an anode and the first organic layer, it is preferable that at least one layer out of an electron injection layer and an electron transporting layer is further present between an cathode and the first organic layer, since the light emitting device of the present invention is more excellent in luminance life.

In the light emitting device of the present invention, when the second organic layer is a second light emitting layer disposed between a anode and the first organic layer, it is preferable that at least one layer out of a hole injection layer and a hole transporting layer is further present between an anode and the second organic layer, since the light emitting device of the present invention is more excellent in luminance life. When the second organic layer is a second light emitting layer disposed between an anode and the first organic layer, it is preferable that at least one layer out of an electron injection layer and an electron transporting layer is further present between a cathode the first organic layer, since the light emitting device of the present invention is more excellent in luminance life.

In the light emitting device of the present invention, when the second organic layer is a second light emitting layer disposed between a cathode and the first organic layer, it is preferable that at least one layer out of a hole injection layer and a hole transporting layer is further present between an anode and the first organic layer, since the light emitting device of the present invention is more excellent in luminance life. When the second organic layer is a second light emitting layer disposed between a cathode and the first organic layer, it is preferable that at least one layer out of an electron injection layer and an electron transporting layer is further present between a cathode and the second organic layer, since the light emitting device of the present invention is more excellent in luminance life.

In the light emitting device of the present invention, when the second organic layer is an electron transporting layer disposed between a cathode and the first organic layer, it is preferable that at least one layer out of a hole injection layer and a hole transporting layer is further present between an anode and the first organic layer, since the light emitting device of the present invention is more excellent in luminance life. When the second organic layer is an electron transporting layer disposed between a cathode and the first organic layer, it is preferable that an electron injection layer is further present between a cathode and the second organic layer, since the light emitting device of the present invention is more excellent in luminance life.

The specific layer constitution of the light emitting device of the present invention includes, for example, layer constitutions represented by the following (D1) to (D15). The light emitting device of the present invention usually has a substrate, and an anode may be first laminated on the substrate, or a cathode may be first laminated on the substrate.

(D1) anode/second light emitting layer (second organic layer)/first light emitting layer (first organic layer)/cathode
(D2) anode/hole transporting layer (second organic layer)/first light emitting layer (first organic layer)/cathode
(D3) anode/hole injection layer/second light emitting layer (second organic layer)/first light emitting layer (first organic layer)/cathode
(D4) anode/hole injection layer/second light emitting layer (second organic layer)/first light emitting layer (first organic layer)/electron transporting layer/cathode
(D5) anode/hole injection layer/second light emitting layer (second organic layer)/first light emitting layer (first organic layer)/electron injection layer/cathode
(D6) anode/hole injection layer/second light emitting layer (second organic layer)/first light emitting layer (first organic layer)/electron transporting layer/electron injection layer/cathode
(D7) anode/hole injection layer/hole transporting layer (second organic layer)/first light emitting layer (first organic layer)/cathode
(D8) anode/hole injection layer/hole transporting layer (second organic layer)/first light emitting layer (first organic layer)/electron transporting layer/cathode
(D9) anode/hole injection layer/hole transporting layer (second organic layer)/first light emitting layer (first organic layer)/electron injection layer/cathode
(D10) anode/hole injection layer/hole transporting layer (second organic layer)/first light emitting layer (first organic layer)/electron transporting layer/electron injection layer/cathode
(D11) anode/hole injection layer/hole transporting layer/second light emitting layer (second organic layer)/first light emitting layer (first organic layer)/electron transporting layer/electron injection layer/cathode
(D12) anode/hole injection layer/hole transporting layer (second organic layer)/first light emitting layer (first organic layer)/second light emitting layer/electron transporting layer/electron injection layer/cathode
(D13) anode/hole injection layer/hole transporting layer/first light emitting layer (first organic layer)/second light emitting layer (second organic layer)/electron transporting layer/electron injection layer/cathode
(D14) anode/hole injection layer/hole transporting layer/first light emitting layer (first organic layer)/electron transporting layer (second organic layer)/electron injection layer/cathode
(D15) anode/hole injection layer/hole transporting layer (second organic layer)/second light emitting layer/first light emitting layer (first organic layer)/electron transporting layer/electron injection layer/cathode

In the above-described (D1) to (D15), "/" means that layers before and behind that are laminated adjacently. For example, "second light emitting layer (second organic layer)/first light emitting layer (first organic layer)" means that a second light emitting layer (second organic layer) and a first light emitting layer (first organic layer) are laminated adjacently.

Layer constitutions represented by (D3) to (D12) are preferable, layer constitutions represented by (D3) to (D10) are more preferable, layer constitutions represented by (D3) to (D6) are further preferable, since the light emitting device of the present invention is more excellent in luminance life.

In the light emitting device of the present invention, if necessary, two or more layers of the anode, the hole injection layer, the hole transporting layer, the second light emitting layer, the electron transporting layer, the electron injection layer and the cathode may be provided, respectively.

When a plurality of the anode, the hole injection layer, the hole transporting layer, the second light emitting layer, the electron transporting layer, the electron injection layer and the cathode are present, they may be the same or different at each occurrence.

The thicknesses of the anode, the hole injection layer, the hole transporting layer, the first organic layer, the second organic layer, the second light emitting layer, the electron transporting layer, the electron injection layer and the cathode are usually 1 nm to 1 µm, preferably 2 nm to 500 nm, further preferably 5 nm to 150 nm.

In the light emitting device of the present invention, the order, number and thickness of layers to be laminated may be controlled in view of the light emission efficiency and the device life of the light emitting device.

### [Second light emitting layer]

The second light emitting layer is a second organic layer or a layer containing a light emitting material. When the second light emitting layer is a layer containing a light emitting material, the light emitting material contained in the second light emitting layer includes, for example, light emitting materials which may be contained in the first composition described above. The light emitting material contained in the second light emitting layer may be contained singly or in combination of two or more.

When the light emitting device of the present invention has a second light emitting layer and if the second light emitting layer is not a hole transporting layer described later and an electron transporting layer described later, it is preferable that the second light emitting layer is a second organic layer.

### [Hole transporting layer]

The hole transporting layer is a second organic layer or a layer containing a hole transporting material. When the hole transporting layer is a layer containing a hole transporting material, the hole transporting material includes, for example, hole transporting materials which may be contained in the first composition described above. The hole transporting material contained in the hole transporting layer may be contained singly or in combination of two or more.

When the light emitting device of the present invention has a hole transporting layer and if the second organic layer is not the second light emitting layer described above and an electron transporting layer described later, it is preferable that the hole transporting layer is a second organic layer.

### [Electron transporting layer]

The electron transporting layer is a second organic layer or a layer containing an electron transporting material, preferably a layer containing an electron transporting material. When the electron transporting layer is a layer containing an electron transporting material, the electron transporting material contained in the electron transporting layer includes, for example, electron transporting materials which may be contained in the first composition described above. The electron transporting material contained in the electron transporting layer may be contained singly or in combination of two or more.

When the light emitting device of the present invention has an electron transporting layer and if the second organic layer is not the second light emitting layer described above and the hole transporting layer described above, it is preferable that the electron transporting layer is a second organic layer.

### [Hole injection layer and electron injection layer]

The hole injection layer is a layer containing a hole injection material. The hole injection material contained in the hole injection layer includes, for example, hole injection materials which may be contained in the first composition described above. The hole injection material contained in the hole injection layer may be contained singly or in combination of two or more.

The electron injection layer is a layer containing an electron injection material. The electron injection material contained in the electron injection layer includes, for example, electron injection materials which may be contained in the first composition described above. The electron injection material contained in the electron injection layer may be contained singly or in combination of two or more.

### [Substrate/electrode]

The substrate in the light emitting device may advantageously be a substrate on which an electrode can be formed and which does not change chemically in forming an organic layer, and is, for example, a substrate made of a material such as glass, plastic, silicon and the like. When an opaque substrate is used, it is preferable that the electrode farthest from the substrate is transparent or semi-transparent.

The material of the anode includes, for example, electrically conductive metal oxides and semi-transparent metals, preferably includes indium oxide, zinc oxide, tin oxide; electrically conductive compounds such as indium-tin-oxide (ITO), indium-zinc-oxide and the like; silver-palladium-copper (APC) complex; NESA, gold, platinum, silver and copper.

The material of the cathode includes, for example, metals such as lithium, sodium, potassium, rubidium, cesium, beryllium, magnesium, calcium, strontium, barium, aluminum, zinc, indium and the like; alloys composed of two or more of them; alloys composed of at least one of them and at least one of silver, copper, manganese, titanium, cobalt, nickel, tungsten and tin; and graphite and graphite intercalation compounds. The alloy includes, for example, a magnesium-silver alloy, a magnesium-indium alloy, a magnesium-aluminum alloy, an indium-silver alloy, a lithium-aluminum alloy, a lithium-magnesium alloy, a lithium-indium alloy and a calcium-aluminum alloy.

In the light emitting device of the present invention, at least one of the anode and the cathode is usually transparent or semi-transparent, and it is preferable that the anode is transparent or semi-transparent.

The method for forming the anode and the cathode includes, for example, a vacuum vapor deposition method, a sputtering method, an ion plating method, a plating method and a lamination method.

### [Production method of light emitting device]

The method for forming a first organic layer, a second organic layer and other layers in the light emitting device of the present invention includes, for example, a vacuum vapor deposition method from a powder and a method by film formation from a solution or melted state when a low molecular compound is used, and, for example, a method by film formation from a solution or melted state when a polymer compound is used.

The first organic layer, the second organic layer and the other layers can be formed by application methods such as a spin coat method, an inkjet printing method and the like listed in the section of the first ink described above using the above-described various inks and inks containing various materials. The first organic layer and the second organic layer may also be formed by dry methods such as a vapor deposition method and the like.

In the case of forming a first organic layer by an application method, it is preferable to use a fist ink.

In the case of forming a second organic layer by an application method, it is preferable to use an ink of Layer A, an ink of Layer A' or an ink of Layer B.

In the case of forming a second organic layer (particularly, Layer A) by an application using an ink of Layer A', the polymer compound of Layer A' contained in the second organic layer can be cross-linked by heating or irradiating (preferably, heating) after formation of the second organic layer. When the polymer compound of Layer A' is contained in the second organic layer in cross-linked state (cross-linked body of polymer compound of Layer A), the second organic layer is substantially insolubilized in a solvent. Hence, the second organic layer can be suitably used for lamination of a light emitting device.

In the case of forming a second organic layer (particularly, Layer B) by an application using an ink of Layer B, the crosslinking material contained in the second organic layer can be cross-linked by heating or irradiating (preferably, heating) after formation of the second organic layer. When the crosslinking material is contained in the second organic layer in cross-linked state (cross-linked body of crosslinking material), the second organic layer is substantially insolubilized in a solvent. Hence, the second organic layer can be suitably used for lamination of a light emitting device.

The heating temperature of the second organic layer is usually 25°C to 300°C, preferably 50°C to 260°C, more preferably 130°C to 230°C, further preferably 180°C to 210°C.

The heating time of the second organic layer is usually 0.1 minute to 1000 minutes, preferably 0.5 minutes to 500 minutes, more preferably 1 minute to 120 minutes, further preferably 10 minutes to 60 minutes.

The kind of light used for light irradiation is, for example, ultraviolet light, near ultraviolet light or visible light.

As the method for analyzing the components contained in the first organic layer or the second organic layer, for example, chemical separation analysis methods such as extraction and the like, instrumental analysis methods such as infrared spectroscopy (IR), nuclear magnetic resonance spectroscopy (NMR), mass spectrometry (MS) and the like, and analysis methods combining chemical separation analysis methods and instrumental analysis methods are be mentioned.

The first organic layer or the second organic layer can be subjected to solid-liquid extraction using an organic solvent such as toluene, xylene, chloroform, tetrahydrofuran and the like to separate the components into components substantially insoluble in an organic solvent (insoluble component) and components soluble in an organic solvent (soluble component). The insoluble component can be analyzed by infrared spectroscopy or nuclear magnetic resonance spectroscopy, and the soluble component can be analyzed by nuclear magnetic resonance spectroscopy or mass spectrometry.

### [Application of light emitting device]

In order to obtain planar light emission using a light emitting device, the planar anode and the planar cathode may be arranged so as to overlap each other. In order to obtain patterned light emission, there are a method of installing a mask having a patterned window on the surface of a planar light emitting device, a method in which a layer to be formed as a non-light emitting part is formed extremely thick so as to cause substantially non light emission and a method of forming an anode or a cathode, or both electrodes in a pattern. A segment type display capable of displaying numerals, letters and the like can be obtained by forming a pattern by any one of these methods and disposing several electrodes so that several electrodes can be turned on and off independently. In order to obtain a dot matrix display, both the anode and the cathode may be formed in a stripe shape and arranged so as to be orthogonal to each other. Partial color display and multicolor display become possible by a method of separately coating plural kinds of polymer compounds having different emission colors or a method using a color filter or a fluorescence conversion filter. The dot matrix display can be driven passively or can be driven actively in combination with a TFT and the like. These displays can be used for displays of computers, televisions, portable terminals, and the like. The planar light emitting device can be suitably used as a planar light source for backlight of a liquid crystal display, or as a planar light source for illumination. If a flexible substrate is used, it can be used as a curved light source and a curved display.

### EXAMPLES

The present invention will be illustrated further in detail by examples below, but the present invention is not limited to these examples.

In examples, the polystyrene-equivalent number-average molecular weight (Mn) and the polystyrene-equivalent weight-average molecular weight (Mw) of polymer compounds were determined by the following size exclusion chromatography (SEC) using tetrahydrofuran as a mobile phase.

A polymer compound to be measured was dissolved in tetrahydrofuran at a concentration of about 0.05% by mass, and 10 µL of the solution was injected into SEC. The mobile phase was flowed at a flow rate of 1.0 mL/min. As a column, PLgel MIXED-B (manufactured by Polymer Laboratories Ltd.) was used. As a detector, a UV-VIS detector (trade name: UV-8320GPC manufactured by Tosoh Corp.) was used.

NMR was measured by the following method.

Five to ten mg of a measurement sample was dissolved in about 0.5 mL of deutero-chloroform (CDCl₃), deutero-tetrahydrofuran, deutero-dimethyl sulfoxide, deutero-acetone, deutero-N,N-dimethylformamide, deutero-toluene , deutero-methanol, deutero-ethanol, deutero-2-propanol or deutero-methylene chloride, and NMR thereof was measured using an NMR apparatus (trade name: JNM-ECZ400S/L1 manufactured by JEOL RESONANCE).

As an indicator of the purity of the compound, high performance liquid chromatography (HPLC) area percentage value was used. This value is a value by HPLC (trade name: LC-20A manufactured by Shimadzu Corp.) at UV = 254 nm unless otherwise stated. In this operation, the compound to be measured was dissolved in tetrahydrofuran or chloroform so as to give a concentration of 0.01 to 0.2% by mass, and 1 to 10 µL of the solution was poured into HPLC depending on the concentration. As a mobile phase of HPLC, acetonitrile/tetrahydrofuran were used while changing the ratio thereof from 100/0 to 0/100 (volume ratio), and flowed at a flow rate of 1.0 mL/min. As a column, SUMIPAX ODS Z-CLUE (manufactured by Sumika Chemical Analysis Service, Ltd., internal diameter: 4.6 mm, length: 250 mm, particle size: 3 µm) or an ODS column having the equivalent performance was used. As a detector, a photodiode array detector (trade name: SPD-M20A manufactured by Shimadzu Corp.) was used.

In the present example, the maximum peak wavelength of the emission spectrum of the compound was measured by a spectrophotometer (manufactured by JASCO Corp., FP-6500) at room temperature. The compound was dissolved in xylene at a concentration of about 0.8×10⁻⁴% by mass to prepare a xylene solution which was then used as a sample. As the excitation light, UV light having a wavelength of 325 nm was used.

### <Synthesis Example M1> Synthesis of compounds M1 to M5 and phosphorescent compound RM1

Compounds M1, M2 and M3 were synthesized according to a method described in International Publication WO 2013/146806.

A compound M4 was synthesized according to a method described in JP-A No. 2012-33845.

A compound M5 was synthesized according to a method described in JP-A No. 2010-189630.

A phosphorescent compound RM1 was synthesized according to a method described in International Publication WO 2009/157424. 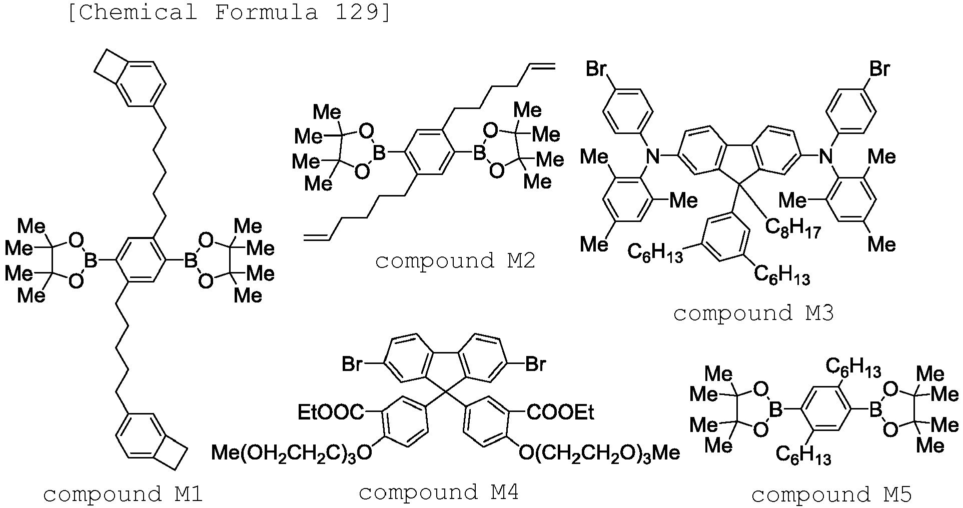 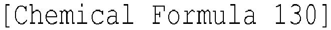 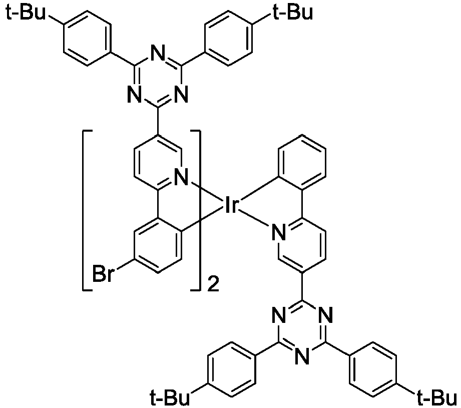 phosphorescent compound RM1

### <Synthesis Example HTL1> Synthesis of polymer compound HTL-1

An inert gas atmosphere was prepared in a reaction vessel, then, the compound M1 (0.800 g), the compound M2 (0.149 g), the compound M3 (1.66 g), dichlorobis(tris-o-methoxyphenylphosphine)palladium (1.4 mg) and toluene (45 mL) were added, and the mixture was heated at 100°C. Thereafter, into this was dropped a 20% by mass tetraethyl ammonium hydroxide aqueous solution (16 mL), and the solution was refluxed for 7 hours. Thereafter, to this were added 2-ethylphenylboronic acid (90 mg) and dichlorobis(tris-o-methoxyphenylphosphine)palladium (1.3 mg), and the solution was refluxed for 17.5 hours. Thereafter, to this was added a sodium diethyldithiacarbamate aqueous solution, and the mixture was stirred at 85°C for 2 hours. The resultant reaction liquid was cooled, then, washed with 3.6% by mass hydrochloric acid, 2.5% by mass ammonia water, and water, respectively. The resultant solution was dropped into methanol, to generate a precipitate. The resultant precipitate was dissolved in toluene, and purified by passing through an alumina column and a silica gel column in this order. The resultant solution was dropped into methanol, stirred, then, the resultant precipitate was collected by filtration, and dried, to obtain 1.64 g of a polymer compound HTL-1. The polymer compound HTL-1 had an Mn of 3.5×10⁴ and an Mw of 2.2×10⁵.

The polymer compound HTL-1 is a copolymer constituted of a constitutional unit derived from the compound M1, a constitutional unit derived from the compound M2 and a constitutional unit derived from the compound M3 at a molar ratio of 40:10:50 according to the theoretical values calculated from the amounts of the charged raw materials.

### <Synthesis Example HTL2> Synthesis of polymer compound HTL-2

An inert gas atmosphere was prepared in a reaction vessel, then, the compound M1 (2.52 g), the compound M2 (0.470 g), the compound M3 (4.90 g), the phosphorescent compound RM1 (0.530 g), dichlorobis(tris-o-methoxyphenylphosphine)palladium (4.2 mg) and toluene(158 mL) were added, and the mixture was heated at 100°C. Thereafter, into this was dropped a 20% by mass tetraethyl ammonium hydroxide aqueous solution (16 mL), and the solution was refluxed for 8 hours. Thereafter, to this were added phenylboronic acid (116 mg) and dichlorobis(tris-o-methoxyphenylphosphine)palladium (4.2 mg), and the solution was refluxed for 15 hours. Thereafter, to this was added a sodium diethyldithiacarbamate aqueous solution, and the mixture was stirred at 85°C for 2 hours. The resultant reaction liquid was cooled, then, washed with 3.6% by mass hydrochloric acid, 2.5% by mass ammonia water, and water, respectively. The resultant solution was dropped into methanol, to generate a precipitate. The resultant precipitate was dissolved in toluene, and purified by passing through an alumina column and a silica gel column in this order. The resultant solution was dropped into methanol, stirred, then, the resultant precipitate was collected by filtration and dried, to obtain 6.02 g of a polymer compound HTL-2. The polymer compound HTL-2 had an Mn of 3.8×10⁴ and an Mw of 4.5×10⁵.

The polymer compound HTL-2 is a copolymer constituted of a constitutional unit derived from the compound M1, a constitutional unit derived from the compound M2, a constitutional unit derived from the compound M3 and a constitutional unit derived from the phosphorescent compound RM1 at a molar ratio of 40:10:47:3 according to the theoretical values calculated from the amounts of the charged raw materials.

The emission spectrum of the polymer compound HTL-2 had a maximal wavelength at 404 nm and 600 nm and the maximum peak wavelength of the emission spectrum of the polymer compound HTL-2 was 404 nm.

### <Synthesis Examples B1, B3, G1 and R1> Synthesis of phosphorescent compounds B1, B3, G1 and R1

A phosphorescent compound B1 was synthesized with reference to methods described in International Publication WO 2006/121811 and JP-A No. 2013-048190.

A phosphorescent compound B3 was synthesized with reference to a method described in International Publication WO 2006/121811.

A phosphorescent compound G1 was synthesized with reference to a method described in International Publication WO 2009/131255.

A phosphorescent compound R1 was synthesized according to a method described in JP-A No. 2008-179617.

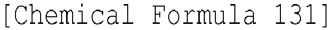

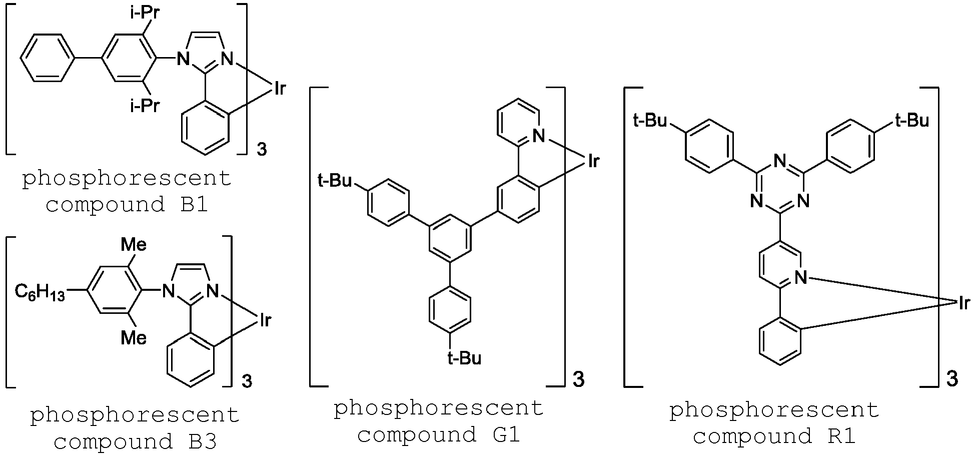

The maximum peak wavelength of the emission spectrum of the phosphorescent compound B1 was 471 nm.

The maximum peak wavelength of the emission spectrum of the phosphorescent compound B3 was 469 nm.

The maximum peak wavelength of the emission spectrum of the phosphorescent compound G1 was 514 nm.

The maximum peak wavelength of the emission spectrum of the phosphorescent compound R1 was 594 nm. The maximum peak wavelength of the emission spectrum of the phosphorescent compound R1 is the maximum peak wavelength of the emission spectrum of a phosphorescent compound corresponding the residue of the phosphorescent compound RM1 contained in the polymer compound HTL-2.

### <Synthesis Example B2> Synthesis of phosphorescent compound B2

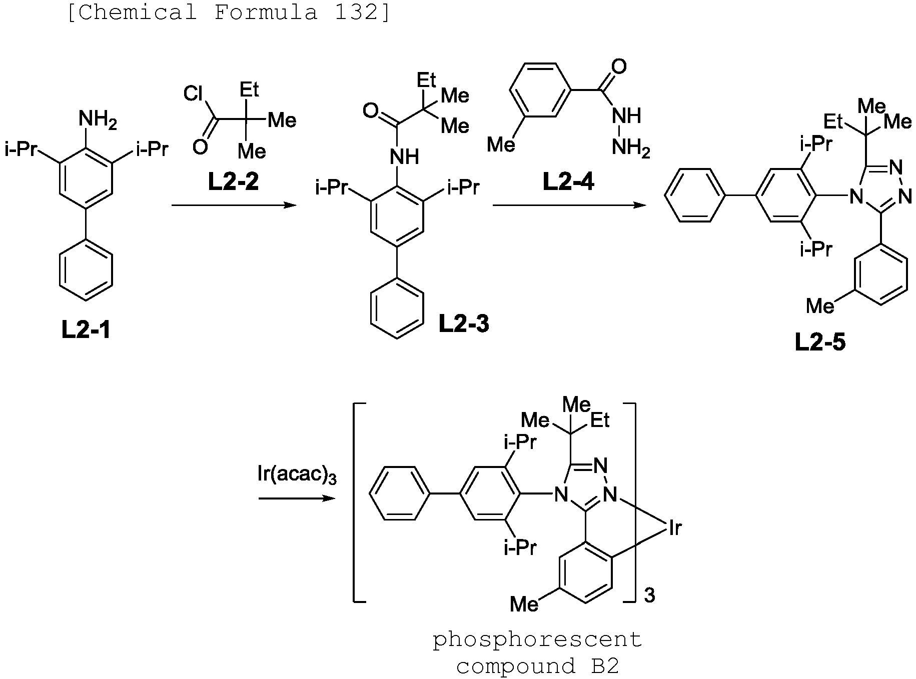

### (Synthesis of compound L2-3)

A nitrogen gas atmosphere was prepared in a reaction vessel, then, a compound L2-1 (21.4 g), triethylamine (13.0 mL) and tetrahydrofuran (300 mL) were added, and the mixture was cooled to 0°C. Thereafter, into this was dropped a compound L2-2 (12.8 mL), and the mixture was stirred at room temperature for 16 hours. Thereafter, to this was added ion exchanged water (100 mL), to generate a precipitate. The reaction liquid containing the resultant precipitate was filtrated, to obtain a residue L2-3-1 and a filtrate L2-3-2.

The resultant residue L2-3-1 was washed with toluene, then, dried under reduced pressure, to obtain a solid L2-3' (24.5 g).

An aqueous layer was removed from the resultant filtrate L2-3-2, the resultant organic layer was dried over magnesium sulfate, then, filtrated. The resultant filtrate was concentrated under reduced pressure, then, crystallized with a mixed solvent of toluene and heptane. The resultant solid was dried under reduced pressure, to obtain a solid L2-3' '(3.9 g).

The resultant solid L2-3' and the solid L2-3" were combined, then, crystallized with a mixed solvent of toluene and heptane. The resultant solid was dried under reduced pressure, to obtain a compound L2-3 (27.8 g, white solid). The HPLC area percentage value of the compound L2-3 was 98.9%.

The analysis result of the compound L2-3 is as described below.
¹H-NMR (600 MHz, THF-d₈): δ (ppm) = 7.57 (d, 2H), 7.43 (t, 2H), 7.35 (s, 2H), 7.34 (t, 1H), 6.82 (brs, 1H), 3.08 (septet, 2H), 1.73 (q, 2H), 1.34 (s, 6H), 1.25 (d, 12H), 1.00 (t, 3H).

### (Synthesis of compound L2-5)

A compound L2-5 was synthesized with reference to a method described in Organic Letters, vol. 17, pp. 1184-1187, 2015, using the compound L2-3 (19.1 g), the compound L2-4 (9.0 g), chlorobenzene (150 mL), 2-fluoropyridine (5.15 mL) and trifluoromethanesulfonic anhydride (10.0 mL).

The analysis result of the compound L2-5 is as described below.
¹H-NMR (600 MHz, CDCl₃): δ (ppm) = 7.68 (d, 2H), 7.52 (t, 2H), 7.50 (s, 2H), 7.43 (t, 1H), 7.26 (s, 1H), 7.05-6.98 (m, 3H), 2.53 (septet, 2H), 2.15 (s, 3H), 1.88 (q, 2H), 1.28 (d, 6H), 1.23 (s, 6H), 0.89 (t, 3H), 0.77 (d, 6H) .

### (Synthesis of phosphorescent compound B2)

A nitrogen gas atmosphere was prepared in a reaction vessel, then, tris(acetylacetonato)iridium(III) (0.72 g), the compound L2-5 (2.8 g) and pentadecane (2 mL) were added, and the mixture was stirred at 300°C for 24 hours. The resultant reaction liquid was cooled down to room temperature, then, purified by silica gel column chromatography (a mixed solvent of methylene chloride and ethyl acetate), then, crystallized sequentially using a mixed solvent of acetonitrile and toluene, a mixed solvent of toluene and methanol, and a mixed solvent of methylene chloride and acetonitrile. The resultant solid was washed with methylene chloride, then, dried under reduced pressure, to obtain a phosphorescent compound B2 (0.82 g). The HPLC area percentage value of the phosphorescent compound B2 was 98.8%.

The analysis result of the phosphorescent compound B2 is as described below.
¹H-NMR (600 MHz, THF-d₈): δ (ppm) = 7.74 (d, 6H), 7.64 (dd, 6H), 7.48 (t, 6H), 7.38 (t, 3H), 6.68 (d, 3H), 6.30 (d, 3H), 5.62 (s, 3H), 2.94 (septet, 3H), 2.37 (septet, 3H), 1.75 (s, 9H), 1.71-1.64 (m, 6H), 1.34 (d, 9H), 1.22-1.17 (m, 27H), 0.98 (d, 9H), 0.90 (d, 9H), 0.81 (d, 9H).

The maximum peak wavelength of the emission spectrum of the phosphorescent compound B2 was 474 nm.

### <Synthesis Examples HM-1 and HM-6 to HM-8> Synthesis and acquisition of compounds HM-1 and HM-6 to HM-8

A compound HM-1 was purchased from Luminescence Technology Corp.

A compound HM-6 and a compound HM-7 were synthesized with reference to a method described in International Publication WO 2012/048820.

A compound HM-8 was synthesized with reference to a method described in International Publication WO 2014/023388.

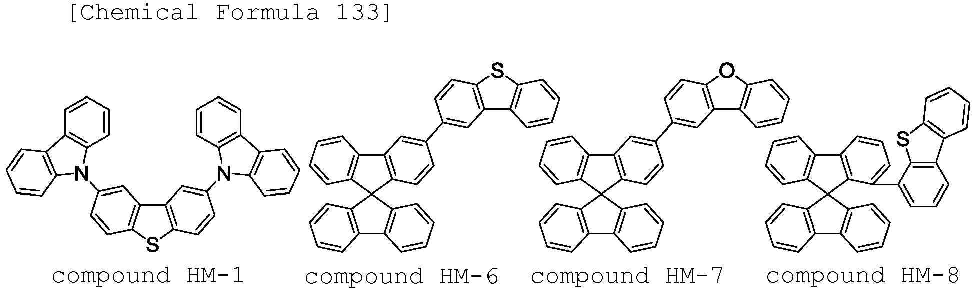

### <Synthesis Example HM-2> Synthesis of compound HM-2

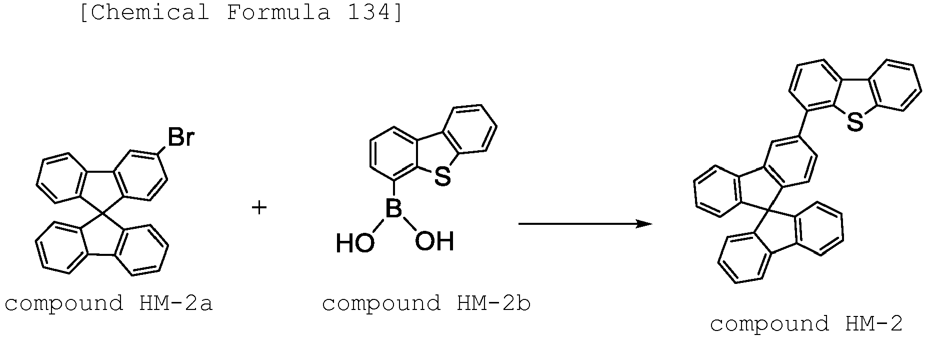

A nitrogen gas atmosphere was prepared in a reaction vessel, then, a compound HM-2a (15.6 g), a compound HM-2b (10.3 g), toluene (390 mL), tetrakis(triphenylphosphine)palladium(0) (2.2 g) and a 20% by mass tetrabutylammonium hydroxide aqueous solution (194 g) were added, and the mixture was stirred at 90°C for 4 hours. The resultant reaction liquid was cooled down to room temperature, then, filtrated through a filter paved with Celite. The resultant filtrate was washed with ion exchanged water, then, the resultant organic layer was dried over anhydrous sodium sulfate, and filtrated. The resultant filtrate was concentrated under reduced pressure, to obtain a solid. The resultant solid was crystallized using a mixed solvent of toluene and 2-propanol, then, dried at 50°C under reduced pressure, to obtain a compound HM-2 (15.2 g). The HPLC area percentage value of the compound HM-2 was 99.5% or more.

The analysis result of the compound HM-2 is as described below.
¹H-NMR (CD₂Cl₂, 400 MHz): δ (ppm) = 6.70-6.83 (4H, m), 7.15 (3H, t), 7.39 (3H, t), 7.48 (3H, t), 7.59 (2H, t), 7.83-7.93 (4H, m), 8.18-8.23 (3H, m).

### <Synthesis Example HM-3> Synthesis of compound HM-3

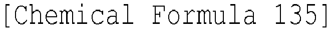

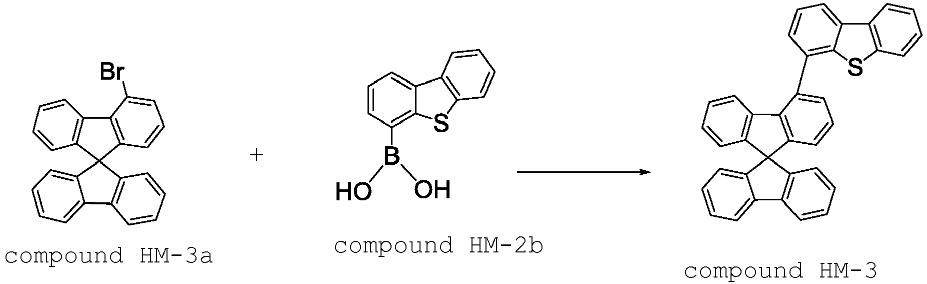

A nitrogen gas atmosphere was prepared in a reaction vessel, then, a compound HM-3a (13.5 g), a compound HM-2b (8.9 g), toluene (404 mL), tetrakis(triphenylphosphine)palladium(0) (2.0g) and a 20% by mass tetrabutylammonium hydroxide aqueous solution (166 g) were added, and the mixture was stirred at 90°C for 3 hours. The resultant reaction liquid was cooled down to room temperature, then, filtrated through a filter paved with Celite. The resultant filtrate was washed with ion exchanged water, then, the resultant organic layer was dried over anhydrous sodium sulfate, and filtrated. The resultant filtrate was concentrated under reduced pressure, to obtain a solid. The resultant solid was purified by silica gel column chromatography (a mixed solvent of hexane and chloroform), and further, crystallized using a mixed solvent of toluene and methanol, then, dried at 50°C under reduced pressure, to obtain a compound HM-3 (10.5 g). The HPLC area percentage value of the compound HM-3 was 99.5% or more.

The analysis result of the compound HM-3 is as described below.
¹H-NMR (CD₂Cl₂, 400 MHz): δ (ppm) = 6.51 (1H, d), 6.60 (1H, d), 6.80 (4H, m), 6.92 (1H, t), 7.21 (3H, m), 7.34 (1H, d), 7.39-7.50 (4H, m), 7.65 (1H, d), 7.71 (1H, t), 7.81 (1H, d), 7.88 (2H, d), 8.28-8.35 (2H, m).

### <Synthesis Example HM-4> Synthesis of compound HM-4

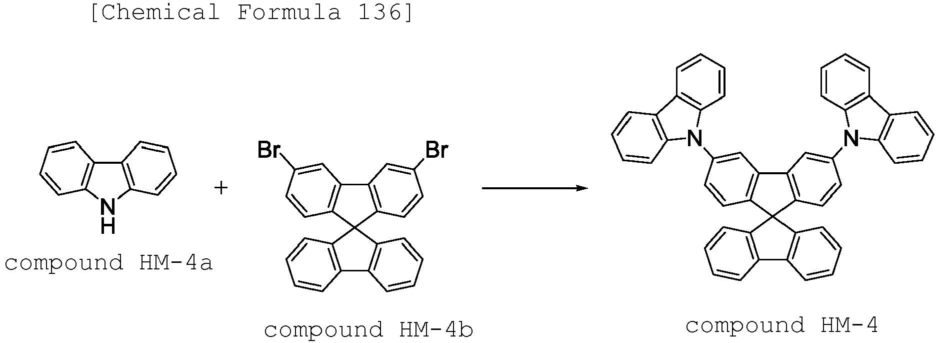

A nitrogen gas atmosphere was prepared in a reaction vessel, then, a compound HM-4a (1.6 g), a compound HM-4b (1.3 g), xylene (63 mL), palladium(II) acetate (22 mg), tri-tert-butylphosphonium tetrafluoroborate (63 mg) and sodium tert-butoxide (1.9 g) were added, and the mixture was stirred for 54 hours under reflux with heat. The resultant reaction liquid was cooled down to room temperature, then, filtrated through a filter paved with silica gel and Celite. The resultant filtrate was washed with ion exchanged water, then, the resultant organic layer was dried over anhydrous sodium sulfate, and filtrated. The resultant filtrate was concentrated under reduced pressure, to obtain a solid. The resultant solid was purified by silica gel column chromatography (a mixed solvent of hexane and chloroform), and further, crystallized using a mixed solvent of chloroform and 2-propanol, then, dried at 50°C under reduced pressure, to obtain a compound HM-4 (1.0 g). The HPLC area percentage value of the compound HM-4 was 99.5% or more.

The analysis result of the compound HM-4 is as described below.
¹H-NMR (CD₂Cl₂, 400 MHz): δ (ppm) = 7.08 (4H, t), 7.34 (6H, m), 7.47-7.57 (12H, m), 8.02 (2H, d), 8.12 (2H, s), 8.22 (4H, d).

### <Synthesis Example HM-5> Synthesis of compound HM-5

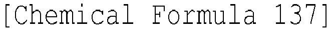

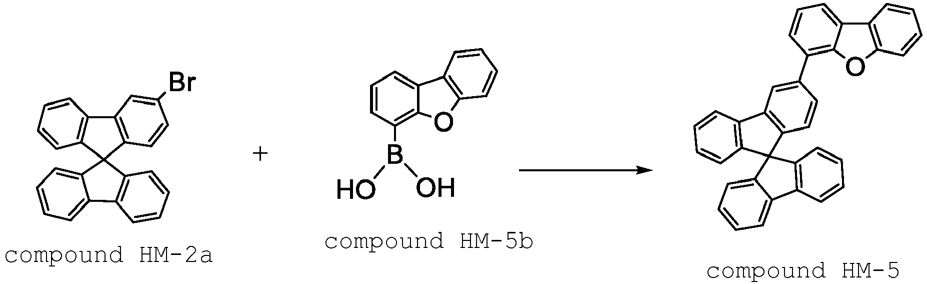

A nitrogen gas atmosphere was prepared in a reaction vessel, then, a compound HM-2a (1.64 g), a compound HM-5b (1.00 g), toluene (40 mL), tetrakis(triphenylphosphine)palladium(0) (0.24 g) and a 20% by mass tetrabutylammonium hydroxide aqueous solution (20 g) were added, and the mixture was stirred at 90°C for 3 hours. The resultant reaction liquid was cooled down to room temperature, then, toluene was added, and the liquid was washed with ion exchanged water. The resultant organic layer was dried over anhydrous magnesium sulfate, then, filtrated through a filter paved with silica gel and Celite. The resultant filtrate was concentrated under reduced pressure, to obtain a solid. The resultant solid was crystallized using a mixed solvent of toluene and 2-propanol, then, dried at 50°C under reduced pressure, to obtain a compound HM-5 (1.7 g). The HPLC area percentage value of the compound HM-5 was 99.5% or more.

The analysis result of the compound HM-5 is as described below.
¹H-NMR (CDCl₃, 400 MHz): δ (ppm) = 8.36 (d, 1H), 8.03-7.99 (m, 1H), 7.98-7.93 (m, 2H), 7.89-7.86 (m, 2H), 7.70-7.60 (m, 3H), 7.51-7.35 (m, 6H), 7.17-7.12 (m, 3H), 6.89 (d, 1H), 6.86-6.82 (m, 2H), 6.78 (d, 1H).

### <Synthesis Example ETL1> Synthesis of polymer compound ETL-1

An inert gas atmosphere was prepared in a reaction vessel, then, the compound M4 (9.23 g), the compound M5 (4.58 g), dichlorobis(tris-o-methoxyphenylphosphine)palladium (8.6 mg), methyltrioctylammonium chloride (manufactured by Sigma Aldrich, trade name: Aliquat336 (registered trademark))(0.098 g) and toluene(175 mL) were added, and the mixture was heated at 105°C. Thereafter, into this was dropped a 12% by mass sodium carbonate aqueous solution (40.3 mL), and the solution was refluxed for 29 hours. Thereafter, to this were added phenylboronic acid (0.47 g) and dichlorobis(tris-o-methoxyphenylphosphine)palladium (8.7 mg), and the solution was refluxed for 14 hours. Thereafter, to this was added a sodium diethyldithiacarbamate aqueous solution, and the mixture was stirred at 80°C for 2 hours. The resultant reaction liquid was cooled, then, dropped into methanol, to generate a precipitate. The resultant precipitate was collected by filtration, and washed with methanol and water, respectively, then, dried. The resultant solid was dissolved in chloroform, and purified by passing through an alumina column and a silica gel column in series through which chloroform had been passed previously. The resultant purified liquid was dropped into methanol, and the mixture was stirred, to generate a precipitate. The resultant precipitate was collected by filtration, and dried, to obtain a polymer compound ETL-1a (7.15 g). The polymer compound ETL-1a had an Mn of 3.2×10⁴ and an Mw of 6.0×10⁴.

The polymer compound ETL-1a is a copolymer constituted of a constitutional unit derived from the compound M4 and a constitutional unit derived from the compound M5 at a molar ratio of 50:50 according to the theoretical values calculated from the amounts of the charged raw materials.

An argon gas atmosphere was prepared in a reaction vessel, then, the polymer compound ETL-1a (3.1 g), tetrahydrofuran (130 mL), methanol (66 mL), cesium hydroxide monohydrate (2.1 g) and water (12.5 mL) were added, and the mixture was stirred at 60°C for 3 hours. Thereafter, to this was added methanol (220 mL), and the mixture was stirred for 2 hours. The resultant reaction mixture was concentrated, then, dropped into isopropyl alcohol, and stirred, to generate a precipitate. The resultant precipitate was collected by filtration, and dried, to obtain a polymer compound ETL-1 (3.5 g). The polymer compound ETL-1 was analyzed by ¹H-NMR, to confirm that the signal at the ethyl ester portion in the polymer compound ETL-1 disappeared, and the reaction was completed.

The polymer compound ETL-1 is a copolymer constituted of a constitutional unit represented by the following formula and a constitutional unit derived from the compound M5 at a molar ratio of 50:50, according to the theoretical values calculated from the amounts of the charged raw materials of the polymer compound ETL-1a.

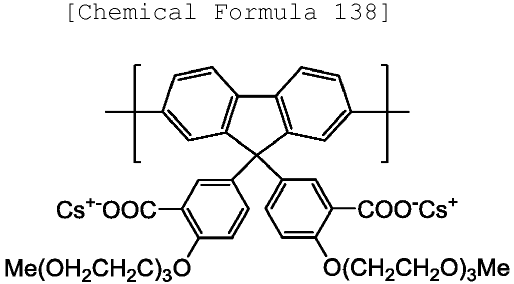

### <Example D1> Fabrication and evaluation of light emitting device D1

### (Formation of anode and hole injection layer)

An ITO film with a thickness of 45 nm was deposited on a glass substrate by a sputtering method, to form an anode. On the anode, a hole injection material ND-3202 (manufactured by Nissan Chemical Corporation) was spin-coated, to form a film with a thickness of 35 nm. In an air atmosphere, the film was heated on a hot plate at 50°C for 3 minutes, and further, heated at 230°C for 15 minutes, to form a hole injection layer.

### (Formation of second organic layer)

The polymer compound HTL-2 was dissolved in xylene at a concentration of 0.7% by mass. The resultant xylene solution was spin-coated on the hole injection layer, to form a film with a thickness of 20 nm, and the film was heated on a hot plate at 180°C for 60 minutes under a nitrogen gas atmosphere, to form a second organic layer (second light emitting layer). By this heating, the polymer compound HTL-2 became a cross-linked body.

### (Formation of first organic layer)

The compound HM-2, the phosphorescent compound B1 and the phosphorescent compound G1 (compound HM-2/phosphorescent compound B1/phosphorescent compound G1 = 74% by mass/25% by mass/1% by mass) were dissolved at a concentration of 2.0% by mass in toluene. The resultant toluene solution was spin-coated on the second organic layer, to form a film with a thickness of 75 nm, and the film was heated at 130°C for 10 minutes under a nitrogen gas atmosphere, to form a first organic layer (first light emitting layer).

### (Formation of electron transporting layer)

The polymer compound ETL-1 was dissolved in 2,2,3,3,4,4,5,5-octafluoro-1-pentanol at a concentration of 0.25% by mass. The resultant 2,2,3,3,4,4,5,5-octafluoro-1-pentanol solution was spin-coated on the first light emitting layer, to form a film with a thickness of 10 nm, and the film was heated at 130°C for 10 minutes under a nitrogen gas atmosphere, to form an electron transporting layer.

### (Formation of cathode)

The substrate carrying the electron transporting layer formed thereon was placed in a vapor deposition machine and the inner pressure thereof was reduced to 1.0×10⁻⁴ Pa or less, then, as cathode, sodium fluoride was vapor-deposited with a thickness of about 4 nm on the electron transporting layer, then, aluminum was vapor-deposited with a thickness of about 80 nm on the sodium fluoride layer. After vapor deposition, sealing was performed with a glass substrate, to fabricate a light emitting device D1.

### (Evaluation of light emitting device)

Voltage was applied to the light emitting device D1, to observe EL light emission. The CIE chromaticity coordinate (x, y) at 1000 cd/m² was (0.48, 0.46). The light emitting device was driven under constant current at a current value of 1 mA, and the time until the luminance reached 85% of the initial luminance was measured.

### <Example D2> Fabrication and evaluation of light emitting device D2

A light emitting device D2 was fabricated in the same manner as in Example D1, except that (Formation of second organic layer) of Example D1 was changed to (Formation of second organic layer: -D2) described below.

### (Formation of second organic layer: -D2)

The polymer compound HTL-1 and the phosphorescent compound R1 (polymer compound HTL-1/phosphorescent compound R1 = 65% by mass/35% by mass) were dissolved at a concentration of 0.7% by mass in xylene. The resultant xylene solution was spin-coated on the hole injection layer to form a film with a thickness of 20 nm, and the film was heated on a hot plate at 180°C for 60 minutes under a nitrogen gas atmosphere, to form a second organic layer (second light emitting layer). By this heating, the polymer compound HTL-1 became a cross-linked body.

Voltage was applied to the light emitting device D2, to observe EL light emission. The CIE chromaticity coordinate (x, y) at 1000 cd/m² was (0.35, 0.51). The light emitting device was driven under constant current at a current value of 1 mA, and the time until the luminance reached 85% of the initial luminance was measured.

### <Example D3> Fabrication and evaluation of light emitting device D3

A light emitting device D3 was fabricated in the same manner as in Example D1, except that "the compound HM-3" was used instead of "the compound HM-2" in (Formation of first organic layer) of Example D1.

Voltage was applied to the light emitting device D3, to observe EL light emission. The CIE chromaticity coordinate (x, y) at 1000 cd/m² was (0.44, 0.46). The light emitting device was driven under constant current at a current value of 1 mA, and the time until the luminance reached 85% of the initial luminance was measured.

### <Example D4> Fabrication and evaluation of light emitting device D4

A light emitting device D4 was fabricated in the same manner as in Example D1, except that "the compound HM-8" was used instead of "the compound HM-2" in (Formation of first organic layer) of Example D1.

Voltage was applied to the light emitting device D4, to observe EL light emission. The CIE chromaticity coordinate (x, y) at 1000 cd/m² was (0.42, 0.47). The light emitting device was driven under constant current at a current value of 1 mA, and the time until the luminance reached 85% of the initial luminance was measured.

### <Comparative Example CD1> Fabrication and evaluation of light emitting device CD1

A light emitting device CD1 was fabricated in the same manner as in Example D1, except that "the compound HM-1" was used instead of "the compound HM-2" in (Formation of first organic layer) of Example D1.

Voltage was applied to the light emitting device CD1, to observe EL light emission. The CIE chromaticity coordinate (x, y) at 1000 cd/m² was (0.47, 0.45). The light emitting device was driven under constant current at a current value of 1 mA, and the time until the luminance reached 85% of the initial luminance was measured.

The results of Examples D1 to D4 and Comparative Example CD1 are shown in Table 4. The relative value of the time (luminance life) until the luminance of the light emitting devices D1 to D4 reached 85% of the initial luminance when the time (luminance life) until the luminance of the light emitting device CD1 reached 85% of the initial luminance was taken as 1.0 is shown.

**[Table 4]**

| | light emitting device | second organic layer | | first organic layer | | luminance life (relative value) |
|---|---|---|---|---|---|---|
| | | material | composition ratio (% by mass) | material | composition ratio (% by mass) | |
| Example D1 | D1 | HTL-2 | 100 | HM-2/B1/G1 | 74/25/1 | 2.5 |
| Example D2 | D2 | HTL-1/R1 | 65/35 | HM-2/B1/G1 | 74/25/1 | 1.8 |
| Example D3 | D3 | HTL-2 | 100 | HM-3/B1/G1 | 74/25/1 | 1.7 |
| Example D4 | D4 | HTL-2 | 100 | HM-8/B1/G1 | 74/25/1 | 1.7 |
| Comparative Example CD1 | CD1 | HTL-2 | 100 | HM-1/B1/G1 | 74/25/1 | 1.0 |

### <Example D5> Fabrication and evaluation of light emitting device D5

A light emitting device D5 was fabricated in the same manner as in Example D1, except that "the compound HM-2 and the phosphorescent compound B1(compound HM-2/phosphorescent compound B1 = 75% by mass/25% by mass)" were used instead of "the compound HM-2, the phosphorescent compound B1 and the phosphorescent compound G1 (compound HM-2/phosphorescent compound B1/phosphorescent compound G1 = 74% by mass/25% by mass/1% by mass)" in (Formation of first organic layer) of Example D1.

Voltage was applied to the light emitting device D5, to observe EL light emission. The CIE chromaticity coordinate (x, y) at 1000 cd/m² was (0.48, 0.41). The light emitting device was driven under constant current at a current value of 1 mA, and the time until the luminance reached 75% of the initial luminance was measured.

### <Example D6> Fabrication and evaluation of light emitting device D6

A light emitting device D6 was fabricated in the same manner as in Example D1, except that "the compound HM-2 and the phosphorescent compound B1 (compound HM-2/phosphorescent compound B1 = 75% by mass/25% by mass)" were used instead of "the compound HM-2, the phosphorescent compound B1 and the phosphorescent compound G1 (compound HM-2/phosphorescent compound B1/phosphorescent compound G1 = 74% by mass/25% by mass/1% by mass)" in (Formation of first organic layer) of Example D1, and further, (Formation of second organic layer) of Example D1 was changed to (Formation of second organic layer: -D2) of Example D2.

Voltage was applied to the light emitting device D6, to observe EL light emission. The CIE chromaticity coordinate (x, y) at 1000 cd/m² was (0.34, 0.42). The light emitting device was driven under constant current at a current value of 1 mA, and the time until the luminance reached 75% of the initial luminance was measured.

### <Example D7> Fabrication and evaluation of light emitting device D7

A light emitting device D7 was fabricated in the same manner as in Example D1, except that "the compound HM-3 and the phosphorescent compound B1 (compound HM-3/a phosphorescent compound B1 = 75% by mass/25% by mass)" were used instead of "the compound HM-2, the phosphorescent compound B1 and the phosphorescent compound G1 (compound HM-2/phosphorescent compound B1/phosphorescent compound G1 = 74% by mass/25% by mass/1% by mass)" in (Formation of first organic layer) of Example D1.

Voltage was applied to the light emitting device D7, to observe EL light emission. The CIE chromaticity coordinate (x, y) at 1000 cd/m² was (0.46, 0.41). The light emitting device was driven under constant current at a current value of 1 mA, and the time until the luminance reached 75% of the initial luminance was measured.

### <Comparative Example CD2> Fabrication and evaluation of light emitting device CD2

A light emitting device CD2 was fabricated in the same manner as in Example D1, except that "the compound HM-1 and the phosphorescent compound B1 (compound HM-1/phosphorescent compound B1 = 75% by mass/25% by mass)" were used instead of "the compound HM-2, the phosphorescent compound B1 and the phosphorescent compound G1 (compound HM-2/phosphorescent compound B1/phosphorescent compound G1 = 74% by mass/25% by mass/1% by mass)" in (Formation of first organic layer) of Example D1.

Voltage was applied to the light emitting device CD2, to observe EL light emission. The CIE chromaticity coordinate (x, y) at 1000 cd/m² was (0.45, 0.41). The light emitting device was driven under constant current at a current value of 1 mA, and the time until the luminance reached 75% of the initial luminance was measured.

The results of Examples D5 to D7 and Comparative Example CD2 are shown in Table 5. The relative value of the time (luminance life) until the luminance of the light emitting devices D5 to D7 reached 75% of the initial luminance when the time (luminance life) until the luminance of the light emitting device CD2 reached 75% of the initial luminance was taken as 1.0 is shown.

**[Table 5]**

| | light emitting device | second organic layer | | first organic layer | | luminance life (relative value) |
|---|---|---|---|---|---|---|
| | | material | composition ratio (% by mass) | material | composition ratio (% by mass) | |
| Example D5 | D5 | HTL-2 | 100 | HM-2/B1 | 75/25 | 2.2 |
| Example D6 | D6 | HTL-1/R1 | 65/35 | HM-2/B1 | 75/25 | 1.8 |
| Example D7 | D7 | HTL-2 | 100 | HM-3/B1 | 75/25 | 1.6 |
| Comparative Example CD2 | CD2 | HTL-2 | 100 | HM-1/B1 | 75/25 | 1.0 |

### <Example D8> Fabrication and evaluation of light emitting device D8

A light emitting device D8 was fabricated in the same manner as in Example D1, except that "the compound HM-3 and the phosphorescent compound B2 and the phosphorescent compound G1 (compound HM-3/a phosphorescent compound B2/phosphorescent compound G1 = 74% by mass/25% by mass/1% by mass)" were used instead of "the compound HM-2, the phosphorescent compound B1 and the phosphorescent compound G1(compound HM-2/phosphorescent compound B1/phosphorescent compound G1 = 74% by mass/25% by mass/1% by mass)" in (Formation of first organic layer) of Example D1.

Voltage was applied to the light emitting device D8, to observe EL light emission. The CIE chromaticity coordinate (x, y) at 1000 cd/m² was (0.45, 0.46). The light emitting device was driven under constant current at a current value of 1 mA, and the time until the luminance reached 75% of the initial luminance was measured.

### <Example D9> Fabrication and evaluation of light emitting device D9

A light emitting device D9 was fabricated in the same manner as in Example D8, except that "the compound HM-2" was used instead of "the compound HM-3" in (Formation of first organic layer) of Example D8.

Voltage was applied to the light emitting device D9, to observe EL light emission. The CIE chromaticity coordinate (x, y) at 1000 cd/m² was (0.47, 0.45). The light emitting device was driven under constant current at a current value of 1 mA, and the time until the luminance reached 75% of the initial luminance was measured.

### <Example D10> Fabrication and evaluation of light emitting device D10

A light emitting device D10 was fabricated in the same manner as in Example D8, except that "the compound HM-5" was used instead of "the compound HM-3" in (Formation of first organic layer) of Example D8.

Voltage was applied to the light emitting device D10, to observe EL light emission. The CIE chromaticity coordinate (x, y) at 1000 cd/m² was (0.48, 0.45). The light emitting device was driven under constant current at a current value of 1 mA, and the time until the luminance reached 75% of the initial luminance was measured.

### <Example D11> Fabrication and evaluation of light emitting device D11

A light emitting device D11 was fabricated in the same manner as in Example D8, except that "the compound HM-6" was used instead of "the compound HM-3" in (Formation of first organic layer) of Example D8.

Voltage was applied to the light emitting device D11, to observe EL light emission. The CIE chromaticity coordinate (x, y) at 1000 cd/m² was (0.47, 0.45). The light emitting device was driven under constant current at a current value of 1 mA, and the time until the luminance reached 75% of the initial luminance was measured.

### <Example D12> Fabrication and evaluation of light emitting device D12

A light emitting device D12 was fabricated in the same manner as in Example D8, except that "the compound HM-7" was used instead of "the compound HM-3" in (Formation of first organic layer) of Example D8.

Voltage was applied to the light emitting device D12, to observe EL light emission. The CIE chromaticity coordinate (x, y) at 1000 cd/m² was (0.45, 0.46). The light emitting device was driven under constant current at a current value of 1 mA, and the time until the luminance reached 75% of the initial luminance was measured.

### <Comparative Example CD3> Fabrication and evaluation of light emitting device CD3

A light emitting device CD3 was fabricated in the same manner as in Example D8, except that "the compound HM-1" was used instead of "the compound HM-3" in (Formation of first organic layer) of Example D8.

Voltage was applied to the light emitting device CD3, to observe EL light emission. The CIE chromaticity coordinate (x, y) at 1000 cd/m² was (0.49, 0.44). The light emitting device was driven under constant current at a current value of 1 mA, and the time until the luminance reached 75% of the initial luminance was measured.

The results of Examples D8 to D12 and Comparative Example CD3 are shown in Table 6. The relative value of the time (luminance life) until the luminance of the light emitting devices D8 to D12 reached 75% of the initial luminance when the time (luminance life) until the luminance of the light emitting device CD3 reached 75% of the initial luminance was taken as 1.0 is shown.

**[Table 6]**

| | light emitting device | second organic layer | | first organic layer | | luminance life (relative value) |
|---|---|---|---|---|---|---|
| | | material | composition ratio (% by mass) | material | composition ratio (% by mass) | |
| Example D8 | D8 | HTL-2 | 100 | HM-3/B2/G1 | 74/25/1 | 1.42 |
| Example D9 | D9 | HTL-2 | 100 | HM-2/B2/G1 | 74/25/1 | 1.92 |
| Example D10 | D10 | HTL-2 | 100 | HM-5/B2/G1 | 74/25/1 | 1.43 |
| Example D11 | D11 | HTL-2 | 100 | HM-6/B2/G1 | 74/25/1 | 1.20 |
| Example D12 | D12 | HTL-2 | 100 | HM-7/B2/G1 | 74/25/1 | 1.17 |
| Comparative Example CD3 | CD3 | HTL-2 | 100 | HM-1/B2/G1 | 74/25/1 | 1.00 |

### <Example D13> Fabrication and evaluation of light emitting device D13

A light emitting device D1 was fabricated in the same manner as in Example D1 (in the present example, referred to as "light emitting device D13").

Voltage was applied to the light emitting device D13, to observe EL light emission. The CIE chromaticity coordinate (x, y) at 1000 cd/m² was (0.48, 0.46). The light emitting device was driven under constant current at a current value of 1 mA, and the time until the luminance reached 95% of the initial luminance was measured.

### <Example D14> Fabrication and evaluation of light emitting device D14

A light emitting device D14 was fabricated in the same manner as in Example D1, except that "the phosphorescent compound B3" was used instead of "the phosphorescent compound B1" in (Formation of first light emitting layer) of Example D1.

Voltage was applied to the light emitting device D14, to observe EL light emission. The CIE chromaticity coordinate (x, y) at 1000 cd/m² was (0.48, 0.45). The light emitting device was driven under constant current at a current value of 1 mA, and the time until the luminance reached 95% of the initial luminance was measured.

### <Example D15> Fabrication and evaluation of light emitting device D15

A light emitting device D15 was fabricated in the same manner as in Example D1, except that "the compound HM-5" was used instead of "the compound HM-2" in (Formation of first light emitting layer) of Example D1.

Voltage was applied to the light emitting device D15, to observe EL light emission. The CIE chromaticity coordinate (x, y) at 1000 cd/m² was (0.47, 0.46). The light emitting device was driven under constant current at a current value of 1 mA, and the time until the luminance reached 95% of the initial luminance was measured.

### <Example D16> Fabrication and evaluation of light emitting device D16

A light emitting device D16 was fabricated in the same manner as in Example D1, except that "the compound HM-6" was used instead of "the compound HM-2" in (Formation of first light emitting layer) of Example D1.

Voltage was applied to the light emitting device D16, to observe EL light emission. The CIE chromaticity coordinate (x, y) at 1000 cd/m² was (0.48, 0.46). The light emitting device was driven under constant current at a current value of 1 mA, and the time until the luminance reached 95% of the initial luminance was measured.

### <Example D17> Fabrication and evaluation of light emitting device D17

A light emitting device D17 was fabricated in the same manner as in Example D1, except that "the compound HM-7" was used instead of "the compound HM-2" in (Formation of first light emitting layer) of Example D1.

Voltage was applied to the light emitting device D17, to observe EL light emission. The CIE chromaticity coordinate (x, y) at 1000 cd/m² was (0.45, 0.46). The light emitting device was driven under constant current at a current value of 1 mA, and the time until the luminance reached 95% of the initial luminance was measured.

The results of Examples D13 to D17 are shown in Table 7. The relative value of the time until the luminance of the light emitting devices D13 to D16 reached 95% of the initial luminance when the time until the luminance of the light emitting device D17 reached 95% of the initial luminance was taken as 1.0 is shown.

**[Table 7]**

| | light emitting device | second light emitting layer | first light emitting layer | | luminance life (relative value) |
|---|---|---|---|---|---|
| | | material | material | composition ratio (% by mass) | |
| Example D13 | D13 | HTL-2 | HM-2/B2/G3 | 74/25/1 | 1.3 |
| Example D14 | D14 | HTL-2 | HM-2/B3/G3 | 74/25/1 | 2.6 |
| Example D15 | D15 | HTL-2 | HM-5/B2/G3 | 74/25/1 | 1.4 |
| Example D16 | D16 | HTL-2 | HM-6/B2/G3 | 74/25/1 | 0.8 |
| Example D17 | D17 | HTL-2 | HM-7/B2/G3 | 74/25/1 | 1.0 |

### <Example D18> Fabrication and evaluation of light emitting device D18

A light emitting device D18 was fabricated in the same manner as in Example D1, except that (Formation of second organic layer) of Example D1 was changed to (Formation of second organic layer: -D18) described below, and further, (Formation of first organic layer) of Example D1 was changed to (Formation of first organic layer: -D18) described below.

### (Formation of second organic layer: -D18)

The polymer compound HTL-1 and the phosphorescent compound R1 (polymer compound HTL-1/phosphorescent compound R1 = 90% by mass/10% by mass) were dissolved at a concentration of 0.7% by mass in xylene. The resultant xylene solution was spin-coated on the hole injection layer to form a film with a thickness of 20 nm, and the film was heated on a hot plate at 180°C for 60 minutes under a nitrogen atmosphere, to form a second organic layer. By this heating, the polymer compound HTL-1 became a cross-linked body.

### (Formation of first organic layer: -D18)

The compound HM-2 and the phosphorescent compound R1 (compound HM-2/phosphorescent compound R1 = 90% by mass/10% by mass) were dissolved at a concentration of 2.0% by mass in toluene. The resultant toluene solution was spin-coated on the second organic layer to form a film with a thickness of 75 nm, and the film was heated at 130°C for 10 minutes under a nitrogen gas atmosphere, to form a first organic layer (first light emitting layer).

Voltage was applied to the light emitting device D18, to observe EL light emission. The CIE chromaticity coordinate (x, y) at 25 cd/m² was (0.62, 0.38). The light emitting device was driven under constant current at a current value of 1 mA, and the time until the luminance reached 75% of the initial luminance was measured.

### <Example D19> Fabrication and evaluation of light emitting device D19

A light emitting device D19 was fabricated in the same manner as in Example D18, except that "the compound HM-3" was used instead of "the compound HM-2" in (Formation of first organic layer: -D18) of Example D18.

Voltage was applied to the light emitting device D19, to observe EL light emission. The CIE chromaticity coordinate (x, y) at 25 cd/m² was (0.62,0.38). The light emitting device was driven under constant current at a current value of 1 mA, and the time until the luminance reached 75% of the initial luminance was measured.

### <Example D20> Fabrication and evaluation of light emitting device D20

A light emitting device D20 was fabricated in the same manner as in Example D18, except that "the compound HM-4" was used instead of "the compound HM-2" in (Formation of first organic layer: -D18) of Example D18.

Voltage was applied to the light emitting device D20, to observe EL light emission. The CIE chromaticity coordinate (x, y) at 25 cd/m² was (0.62, 0.38). The light emitting device was driven under constant current at a current value of 1 mA, and the time until the luminance reached 75% of the initial luminance was measured.

The results of Examples D18 to D20 are shown in Table 8. The relative value of the time (luminance life) until the luminance of the light emitting devices D18 and D19 reached 75% of the initial luminance when the time (luminance life) until the luminance of the light emitting device D20 reached 75% of the initial luminance was taken as 1.0 is shown.

**[Table 8]**

| | light emitting device | second organic layer | | first organic layer | | luminance life (relative value) |
|---|---|---|---|---|---|---|
| | | material | composition ratio (% by mass) | material | composition ratio (% by mass) | |
| Example D18 | D18 | HTL-1/R1 | 90/10 | HM-2/R1 | 90/10 | 68.2 |
| Example D19 | D19 | HTL-1/R1 | 90/10 | HM-3/R1 | 90/10 | 41.2 |
| Example D20 | D20 | HTL-1/R1 | 90/10 | HM-4/R1 | 90/10 | 1.0 |

### <Example D21> Fabrication and evaluation of light emitting device D21

A light emitting device D21 was fabricated in the same manner as in Example D1, except that (Formation of second organic layer) of Example D1 was changed to (Formation of second organic layer: -D21) described below, and further, (Formation of first organic layer) of Example D1 was changed to (Formation of first organic layer: -D21) described below.

### (Formation of second organic layer: -D21)

The polymer compound HTL-1 and the phosphorescent compound G1 (polymer compound HTL-1/phosphorescent compound G1 = 70% by mass/30% by mass) were dissolved in xylene at a concentration of 0.7% by mass. The resultant xylene solution was spin-coated to form a film with a thickness of 20 nm on the hole injection layer, and the film was heated on a hot plate at 180°C for 60 minutes under a nitrogen gas atmosphere, to form a second organic layer. By this heating, the polymer compound HTL-1 became a cross-linked body.

### (Formation of first organic layer: -D21)

The compound HM-2 and the phosphorescent compound G1 (compound HM-2/phosphorescent compound G1 = 70% by mass/30% by mass) were dissolved in toluene at a concentration of 2.0% by mass. The resultant toluene solution was spin-coated to form a film with a thickness of 75 nm on the second organic layer, and the film was heated at 130°C for 10 minutes under a nitrogen gas atmosphere, to form a first organic layer (first light emitting layer).

Voltage was applied to the light emitting device D21, to observe EL light emission. The CIE chromaticity coordinate (x, y) at 1000 cd/m² was (0.32, 0.63). The light emitting device was driven under constant current at a current value of 1 mA, and the time until the luminance reached 50% of the initial luminance was measured.

### <Comparative Example CD4> Fabrication and evaluation of light emitting device CD4

A light emitting device CD4 was fabricated in the same manner as in Example D21, except that "the polymer compound HTL-1 (polymer compound HTL-1 = 100% by mass)" was used instead of "the polymer compound HTL-1 and the phosphorescent compound G1 (polymer compound HTL-1/phosphorescent compound G1 = 70% by mass/30% by mass)" in (Formation of second organic layer: -D21) of Example D21.

Voltage was applied to the light emitting device CD4, to observe EL light emission. The CIE chromaticity coordinate (x, y) at 1000 cd/m² was (0.32, 0.63). The light emitting device was driven under constant current at a current value of 1 mA, and the time until the luminance reached 50% of the initial luminance was measured.

The results of Example D21 and Comparative Example CD4 are shown in Table 8. The relative value of the time (luminance life) until the luminance of the light emitting device D21 reached 50% of the initial luminance when the time (luminance life) until the luminance of the light emitting device CD4 reached 50% of the initial luminance was taken as 1.0 is shown.

**[Table 9]**

| | light emitting device | second organic layer | | first organic layer | | luminance life (relative value) |
|---|---|---|---|---|---|---|
| | | material | composition ratio (% by mass) | material | composition ratio (% by mass) | |
| Example D21 | D21 | HTL-1/G1 | 70/30 | HM-2/G1 | 70/30 | 1.15 |
| Comparative Example CD4 | CD4 | HTL-1 | 100 | HM-2/G1 | 70/30 | 1.00 |

### <Example D22> Fabrication and evaluation of light emitting device D22

A light emitting device D22 was fabricated in the same manner as in Example D1, except that "the polymer compound HTL-2 and the compound HM-2 (polymer compound HTL-2/compound HM-2 = 75% by mass/25% by mass)" were used instead of "the polymer compound HTL-2" in (Formation of second organic layer) of Example D1, and further, "the compound HM-2 and the phosphorescent compound B1 (compound HM-2/phosphorescent compound B1 = 75% by mass/25% by mass)" were used instead of "the compound HM-2, the phosphorescent compound B1 and the phosphorescent compound G1 (compound HM-2/phosphorescent compound B1/phosphorescent compound G1 = 74% by mass/25% by mass/1% by mass)" in (Formation of first organic layer) of Example D1.

Voltage was applied to the light emitting device D22, to observe EL light emission. The CIE chromaticity coordinate (x, y) at 1000 cd/m² was (0.47, 0.40). The light emitting device was driven under constant current at a current value of 1 mA, and the time until the luminance reached 70% of the initial luminance was measured.

### <Example D23> Fabrication and evaluation of light emitting device D23

A light emitting device D23 was fabricated in the same manner as in Example D22, except that "the compound HM-5" was used instead of "the compound HM-2" in (Formation of second organic layer) of Example D22, and further, "the compound HM-5" was used instead of "the compound HM-2" in (Formation of first organic layer) of Example D22.

Voltage was applied to the light emitting device D23, to observe EL light emission. The CIE chromaticity coordinate (x, y) at 1000 cd/m² was (0.47, 0.40). The light emitting device was driven under constant current at a current value of 1 mA, and the time until the luminance reached 70% of the initial luminance was measured.

### <Example D24> Fabrication and evaluation of light emitting device D24

A light emitting device D24 was fabricated in the same manner as in Example D22, except that "the compound HM-8" was used instead of "the compound HM-2" in (Formation of second organic layer) of Example D22, and further, "the compound HM-8" was used instead of "the compound HM-2" in (Formation of first organic layer) of Example D22.

Voltage was applied to the light emitting device D24, to observe EL light emission. The CIE chromaticity coordinate (x, y) at 1000 cd/m² was (0.48, 0.40). The light emitting device was driven under constant current at a current value of 1 mA, and the time until the luminance reached 70% of the initial luminance was measured.

### <Example D25> Fabrication and evaluation of light emitting device D25

A light emitting device D25 was fabricated in the same manner as in Example D22, except that "the compound HM-4" was used instead of "the compound HM-2" in (Formation of second organic layer) of Example D22, and further, "the compound HM-4" was used instead of "the compound HM-2" in (Formation of first organic layer) of Example D22.

Voltage was applied to the light emitting device D25, to observe EL light emission. The CIE chromaticity coordinate (x, y) at 1000 cd/m² was (0.32, 0.40). The light emitting device was driven under constant current at a current value of 1 mA, and the time until the luminance reached 70% of the initial luminance was measured.

### <Example D26> Fabrication and evaluation of light emitting device D26

A light emitting device D26 was fabricated in the same manner as in Example D1, except that "the compound HM-4 and the phosphorescent compound B1 (compound HM-4/phosphorescent compound B1 = 75% by mass/25% by mass)" were used instead of "the compound HM-2, the phosphorescent compound B1 and the phosphorescent compound G1 (compound HM-2/phosphorescent compound B1/phosphorescent compound G1 = 74% by mass/25% by mass/1% by mass)" in (Formation of first organic layer) of Example D1.

Voltage was applied to the light emitting device D26, to observe EL light emission. The CIE chromaticity coordinate (x, y) at 1000 cd/m² was (0.32, 0.40). The light emitting device was driven under constant current at a current value of 1 mA, and the time until the luminance reached 70% of the initial luminance was measured.

The results of Examples D22 to D26 are shown in Table 10. The relative value of the time (luminance life) until the luminance of the light emitting devices D22 to D25 reached 70% of the initial luminance when the time (luminance life) until the luminance of the light emitting device D26 reached 70% of the initial luminance was taken as 1.0 is shown.

**[Table 10]**

| | light emitting device | second organic layer | | first organic layer | | luminance life (relative value) |
|---|---|---|---|---|---|---|
| | | material | composition ratio (% by mass) | material | composition ratio (% by mass) | |
| Example D22 | D22 | HTL- 2/HM-2 | 75/25 | HM-2/B1 | 75/25 | 20.6 |
| Example D23 | D23 | HTL-2/HM-5 | 75/25 | HM-5/B1 | 75/25 | 12.5 |
| Example D24 | D24 | HTL-2/HM-8 | 75/25 | HM-8/B1 | 75/25 | 36.2 |
| Example D25 | D25 | HTL-2/HM-4 | 75/25 | HM-4/B1 | 75/25 | 1.5 |
| Example D26 | D26 | HTL-2 | 100 | HM-4/B1 | 75/25 | 1.0 |

### Industrial Applicability

According to the present invention, a light emitting device excellent in luminance life can be provided.

## Claims

1. A light emitting device having an anode, a cathode, a first organic layer disposed between the anode and the cathode and a second organic layer disposed between the anode and the cathode, wherein
the first organic layer is a layer containing a compound represented by the formula (C-1), and
the second organic layer is
Layer A containing at least one of a polymer compound containing a constitutional unit having a group obtained by removing from a phosphorescent compound represented by the formula (1) (wherein, M is an iridium atom) one or more hydrogen atoms and a cross-linked body of the polymer compound, or
Layer B containing a phosphorescent compound represented by the formula (1) and a cross-linked body of a crosslinking material: 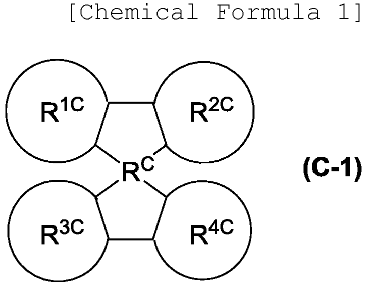 wherein,
Ring R^{1C}, Ring R^{2C}, Ring R^{3C} and Ring R^{4C} each independently represent an aromatic hydrocarbon ring or an aromatic hetero ring, and the foregoing rings optionally have a substituent, and when a plurality of the substituents are present, they may be combined together to form a ring together with the atoms to which they are attached,
R^{C} represents a carbon atom, a silicon atom, a germanium atom, a tin atom or a lead atom, 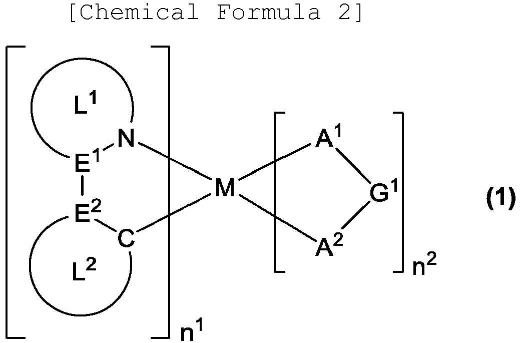
wherein,
M represents a ruthenium atom, a rhodium atom, a palladium atom, an iridium atom or a platinum atom,
n¹ represents an integer of 1 or more, and n² represents an integer of 0 or more, and, n¹+n² is 3 when M is a ruthenium atom, a rhodium atom or an iridium atom, while n¹+n² is 2 when M is a palladium atom or a platinum atom,
E¹ and E² each independently represent a carbon atom or a nitrogen atom and at least one of E¹ and E² is a carbon atom, and when a plurality of E¹ and E² are present, they may be the same or different at each occurrence,
Ring L¹ represents an aromatic hetero ring and the aromatic hetero ring optionally has a substituent, and when a plurality of the substituents are present, they may be combined together to form a ring together with the atoms to which they are attached, and when a plurality of Ring L¹ are present, they may be the same or different,
Ring L² represents an aromatic hydrocarbon ring or an aromatic hetero ring, and the foregoing rings optionally have a substituent, and when a plurality of the substituents are present, they may be combined together to form a ring together with the atoms to which they are attached, and when a plurality of Ring L² are present, they may be the same or different,
the substituent which Ring L¹ optionally has and the substituent which Ring L² optionally has may be combined together to form a ring together with the atoms to which they are attached,
A¹-G¹-A² represents an anionic bidentate ligand, A¹ and A² each independently represent a carbon atom, an oxygen atom or a nitrogen atom, and these atoms may be a ring constituent atom, and G¹ represents a single bond or an atomic group constituting a bidentate ligand together with A¹ and A², and when a plurality of A¹-G¹-A² are present, they may be the same or different.

2. The light emitting device according to Claim 1, wherein at least one of said Ring R^{1C}, said Ring R^{2C}, said Ring R^{3C} and said Ring R^{4C} has a group represented by the formula (D-1): 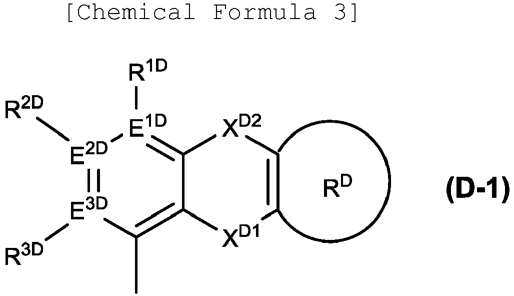 wherein,
Ring R^{D} represents an aromatic hydrocarbon ring or an aromatic hetero ring, and the foregoing rings optionally have a substituent, and when a plurality of the substituents are present, they may be combined together to form a ring together with the atoms to which they are attached,
X^{D1} and X^{D2} each independently represent a single bond, an oxygen atom, a sulfur atom, a group represented by -N(R^{XD1}) - or a group represented by -C(R^{XD2})₂-, R^{XD1} and R^{XD2} each independently represent a hydrogen atom, an alkyl group, a cycloalkyl group, an alkoxy group, a cycloalkoxy group, an aryl group, an aryloxy group, a monovalent heterocyclic group, a substituted amino group or a halogen atom, and the foregoing groups optionally have a substituent, and a plurality of R^{XD2} may be the same or different and may be combined together to form a ring together with the carbon atoms to which they are attached,
E^{1D}, E^{2D} and E^{3D} each independently represent a nitrogen atom or a carbon atom,
R^{1D}, R^{2D} and R^{3D} each independently represent a hydrogen atom, an alkyl group, a cycloalkyl group, an alkoxy group, a cycloalkoxy group, an aryl group, an aryloxy group, a monovalent heterocyclic group, a substituted amino group or a halogen atom, and the foregoing groups optionally have a substituent,
when E^{1D} is a nitrogen atom, R^{1D} is absent, when E^{2D} is a nitrogen atom, R^{2D} is absent, and when E^{3D} is a nitrogen atom, R^{3D} is absent,
R^{1D} and R^{2D} may be combined together to form a ring together with the carbon atoms to which they are attached, R^{2D} and R^{3D} may be combined together to form a ring together with the carbon atoms to which they are attached, R^{1D} and R^{XD1} may be combined together to form a ring together with the atoms to which they are attached, R^{1D} and R^{XD2} may be combined together to form a ring together with the carbon atoms to which they are attached, the substituent which Ring R^{D} optionally has and R^{XD1} may be combined together to form a ring together with the atoms to which they are attached, and the substituent which Ring R^{D} optionally has and R^{XD2} may be combined together to form a ring together with the carbon atoms to which they are attached.

3. The light emitting device according to Claim 1 or 2, wherein said compound represented by the formula (C-1) is a compound represented by the formula (C-2): 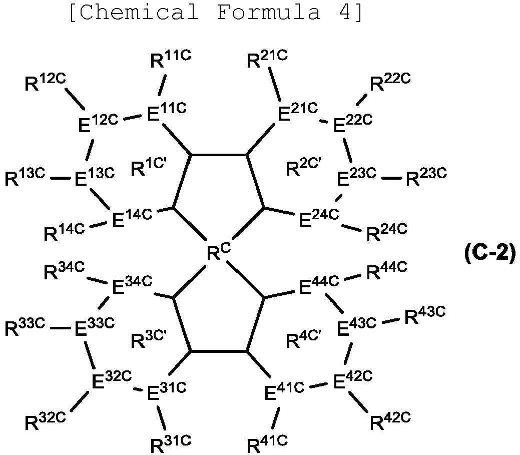 wherein,
R^{C} represents the same meaning as described above,
E^{11C}, E^{12C}, E^{13C}, E^{14C}, E^{21C}, E^{22C}, E^{23C}, E^{24C}, E^{31C}, E^{32C}, E^{33C}, E^{34C}, E^{41C}, E^{42C}, E^{43C} and E^{44C} each independently represent a nitrogen atom or a carbon atom,
Ring R^{1C'}, Ring R^{2C'}, Ring R^{3c'} and Ring R^{4C'} each independently represent a benzene ring, a pyridine ring or a diazabenzene ring,
R^{11C}, R^{12C}, R^{13C}, R^{14C}, R^{21C}, R^{22C}, R^{23C}, R^{24C}, R^{31C}, R^{32C}, R^{33C}, R^{34C}, R^{41C}, R^{42C}, R^{43C} and R^{44C} each independently represent a hydrogen atom, an alkyl group, a cycloalkyl group, an alkoxy group, a cycloalkoxy group, an aryl group, an aryloxy group, an alkenyl group, a monovalent heterocyclic group, a substituted amino group or a halogen atom, and the foregoing groups optionally have a substituent,
when E^{11C} is a nitrogen atom, R^{11C} is absent, when E^{12C} is a nitrogen atom, R^{12C} is absent, when E^{13C} is a nitrogen atom, R^{13C} is absent, when E^{14C} is a nitrogen atom, R^{14C} is absent, when E^{21C} is a nitrogen atom, R^{21C} is absent, when E^{22C} is a nitrogen atom, R^{22C} is absent, when E^{23C} is a nitrogen atom, R^{23C} is absent, when E^{24C} is a nitrogen atom, R^{24C} is absent, when E^{31C} is a nitrogen atom, R^{31C} is absent, when E^{32C} is a nitrogen atom, R^{32C} is absent, when E^{33C} is a nitrogen atom, R^{33C} is absent, when E^{34C} is a nitrogen atom, R^{34C} is absent, when E^{41C} is a nitrogen atom, R^{41C} is absent, when E^{42C} is a nitrogen atom, R^{42C} is absent, when E^{43C} is a nitrogen atom, R^{43C} is absent and when E^{44C} is a nitrogen atom, R^{44C} is absent,
R^{11C} and R^{12C}, R^{12C} and R^{13C}, R^{13C} and R^{14C}, R^{14C} and R^{34C}, R^{34C} and R^{33C}, R^{33C} and R^{32C}, R^{32C} and R^{31C}, R^{31C} and R^{41C}, R^{41C} and R^{42C}, R^{42C} and R^{43C}, R^{43C} and R^{44C}, R^{44C} and R^{24C}, R^{24C} and R^{23C}, R^{23C} and R^{22C}, R^{22C} and R^{21C}, and R^{21C} and R^{11C} may each be combined together to form a ring together with the carbon atoms to which they are attached.

4. The light emitting device according to Claim 3, wherein said compound represented by the formula (C-2) is a compound represented by the formula (C-3): 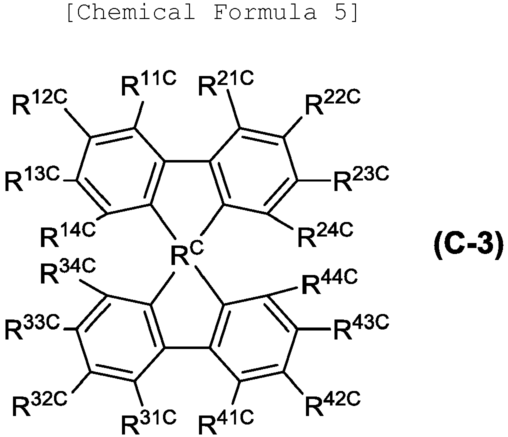 wherein, R^{C}, R^{11C}, R^{12C}, R^{13C}, R^{14C}, R^{21C}, R^{22C}, R^{23C}, R^{24C}, R^{31C}, R^{32C}, R^{33C}, R^{34C}, R^{41C}, R^{42C}, R^{43C} and R^{44C} represent the same meaning as described above.

5. The light emitting device according to Claim 3 or 4, wherein at least one of said R^{11C}, said R^{12C}, said R^{14C}, said R^{21C}, said R^{22C}, said R^{24C}, said R^{31C}, said R^{32C}, said R^{34C}, said R^{41C}, said R^{42C} and said R^{44C} is said group represented by the formula (D-1).

6. The light emitting device according to any one of Claims 1 to 5, wherein said second organic layer is said Layer A, and said polymer compound containing a constitutional unit having a group obtained by removing from a phosphorescent compound represented by the formula (1) (wherein, M is an iridium atom) one or more hydrogen atoms is a polymer compound containing a constitutional unit represented by the formula (1-1B), a constitutional unit represented by the formula (1-2B), a constitutional unit represented by the formula (1-3B) or a constitutional unit represented by the formula (1-4B): 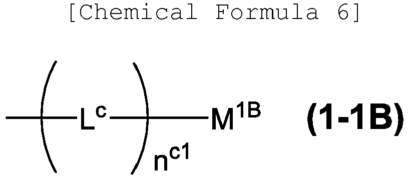 wherein,
M^{1B} represents a group obtained by removing from a phosphorescent compound represented by the formula (1) (wherein, M is an iridium atom) one hydrogen atom,
L^{C} represents an oxygen atom, a sulfur atom, -N(R^{A})-, -C(R^{B})₂-, -C(R^{B}) = C(R^{B})-, -C≡C-, an arylene group or a divalent heterocyclic group, and the foregoing groups optionally have a substituent, R^{A} represents a hydrogen atom, an alkyl group, a cycloalkyl group, an aryl group or a monovalent heterocyclic group, and the foregoing groups optionally have a substituent, R^{B} represents a hydrogen atom, an alkyl group, a cycloalkyl group, an alkoxy group, a cycloalkoxy group, an aryl group or a monovalent heterocyclic group, and the foregoing groups optionally have a substituent, a plurality of R^{B} may be the same or different and may be combined together to form a ring together with the carbon atoms to which they are attached, and when a plurality of L^{C} are present, they may be the same or different,
n^{c1} represents an integer of 0 or more, 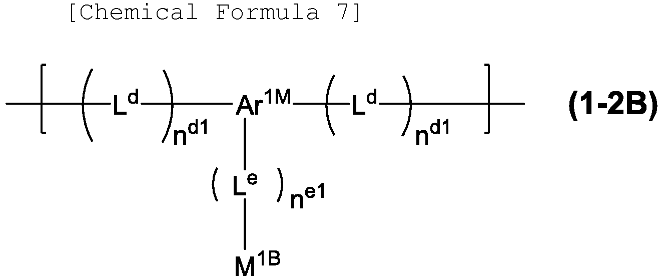
wherein,
M^{1B} represents the same meaning as described above,
L^{d} and L^{e} each independently represent an oxygen atom, a sulfur atom, -N(R^{A})-, -C(R^{B})₂-, -C(R^{B}) = C(R^{B})-, -C≡C-, an arylene group or a divalent heterocyclic group, and the foregoing groups optionally have a substituent, R^{A} and R^{B} represent the same meaning as described above, and when a plurality of L^{d} and L^{e} are present, they may be the same or different at each occurrence,
n^{d1} and n^{e1} each independently represent an integer of 0 or more, a plurality of n^{d1} may be the same or different,
Ar^{1M} represents an aromatic hydrocarbon group or a heterocyclic group, and the foregoing groups optionally have a substituent, 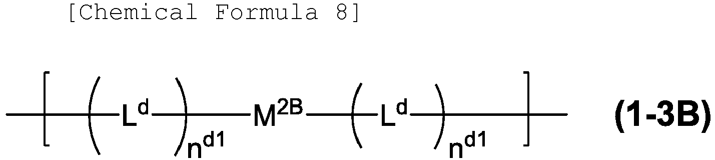
wherein,
L^{d} and n^{d1} represent the same meaning as described above,
M^{2B} represents a group obtained by removing from a phosphorescent compound represented by the formula (1) (wherein, M is an iridium atom) two hydrogen atoms, 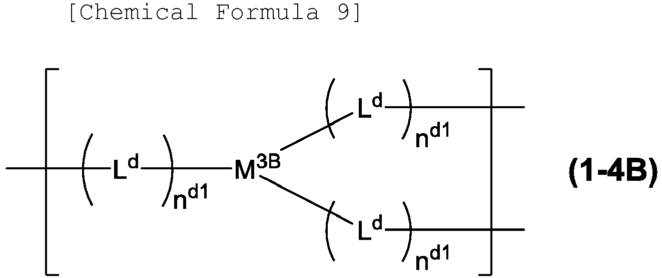
wherein,
L^{d} and n^{d1} represent the same meaning as described above,
M^{3B} represents a group obtained by removing from a phosphorescent compound represented by the formula (1) (wherein, M is an iridium atom) three hydrogen atoms.

7. The light emitting device according to any one of Claims 1 to 6, wherein said second organic layer is said Layer A, and said polymer compound containing a constitutional unit having a group obtained by removing from a phosphorescent compound represented by the formula (1) (wherein, M is an iridium atom) one or more hydrogen atoms further contains a constitutional unit having a crosslinking group.

8. The light emitting device according to any one of Claims 1 to 5, wherein said second organic layer is said Layer B, and said crosslinking material is a polymer compound containing a constitutional unit having a crosslinking group.

9. The light emitting device according to Claim 7 or 8, wherein said crosslinking group is a crosslinking group selected from Group A of crosslinking group:
(Group A of crosslinking group) 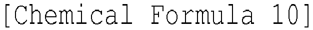 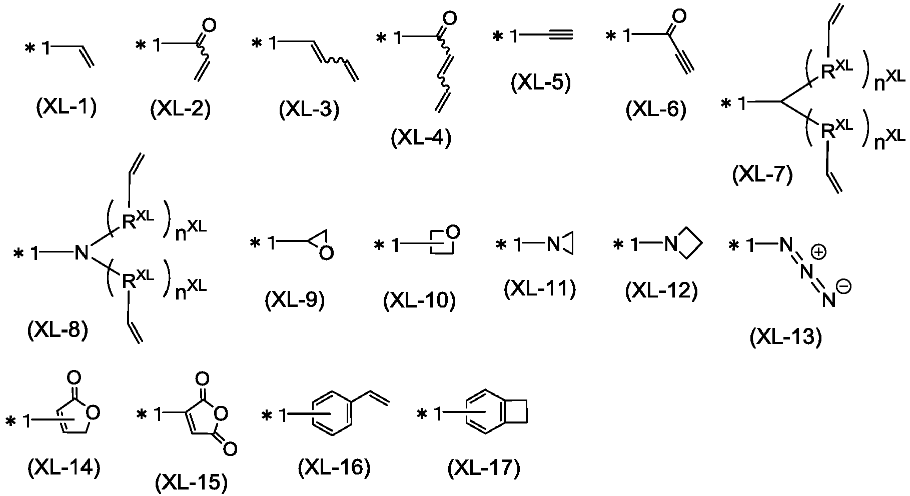 wherein, R^{XL} represents a methylene group, an oxygen atom or a sulfur atom, n^{XL} represents an integer of 0 to 5, and when a plurality of R^{XL} are present, they may be the same or different, a plurality of n^{XL} may be the same or different, *1 represents a binding position, and the foregoing crosslinking groups optionally have a substituent.

10. The light emitting device according to Claim 9, wherein said constitutional unit having a crosslinking group is a constitutional unit represented by the formula (2) or a constitutional unit represented by the formula (2') : 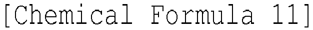 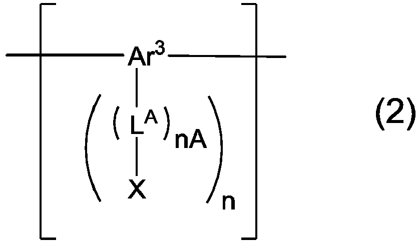 wherein,
nA represents an integer of 0 to 5, and n represents 1 or 2, and when a plurality of nA are present, they may be the same or different,
Ar³ represents an aromatic hydrocarbon group or a heterocyclic group, and the foregoing groups optionally have a substituent,
L^{A} represents an alkylene group, a cycloalkylene group, an arylene group, a divalent heterocyclic group, a group represented by -NR'-, an oxygen atom or a sulfur atom, and the foregoing groups optionally have a substituent, R' represents a hydrogen atom, an alkyl group, a cycloalkyl group, an aryl group or a monovalent heterocyclic group, and the foregoing groups optionally have a substituent, and when a plurality of L^{A} are present, they may be the same or different,
X represents a crosslinking group selected from Group A of crosslinking group, and when a plurality of X are present, they may be the same or different, 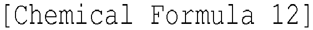 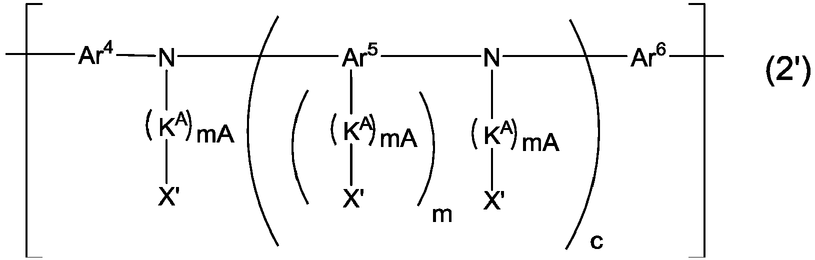
wherein,
mA represents an integer of 0 to 5, m represents an integer of 1 to 4, and c represents 0 or 1, and when a plurality of mA are present, they may be the same or different,
Ar⁵ represents an aromatic hydrocarbon group, a heterocyclic group or a group in which at least one aromatic hydrocarbon ring and at least one hetero ring are bonded directly, and the foregoing groups optionally have a substituent,
Ar⁴ and Ar⁶ each independently represent an arylene group or a divalent heterocyclic group, and the foregoing groups optionally have a substituent,
Ar⁴, Ar⁵ and Ar⁶ may each be bonded directly or via an oxygen atom or a sulfur atom to a group other than the group bonding to the nitrogen atom to which the group is attached, to form a ring,
K^{A} represents an alkylene group, a cycloalkylene group, an arylene group, a divalent heterocyclic group, a group represented by -NR'-, an oxygen atom or a sulfur atom, and the foregoing groups optionally have a substituent, R' represents a hydrogen atom, an alkyl group, a cycloalkyl group, an aryl group or a monovalent heterocyclic group, and the foregoing groups optionally have a substituent, and when a plurality of K^{A} are present, they may be the same or different,
X' represents a crosslinking group selected from Group A of crosslinking group, a hydrogen atom, an alkyl group, a cycloalkyl group, an aryl group or a monovalent heterocyclic group, and the foregoing groups optionally have a substituent, and when a plurality of X' are present, they may be the same or different, and at least one X' is a crosslinking group selected from Group A of crosslinking group.

11. The light emitting device according to any one of Claims 1 to 10, wherein said phosphorescent compound represented by the formula (1) is a phosphorescent compound represented by the formula (1-B): 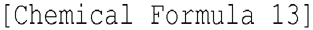 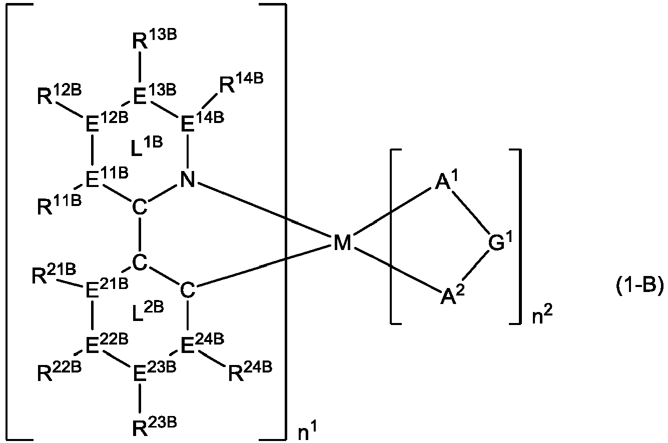 wherein,
M, n¹, n² and A¹-G¹-A² represent the same meaning as described above,
E^{11B}, E^{12B}, E^{13B}, E^{14B}, E^{21B}, E^{22B}, E^{23B} and E^{24B} each independently represent a nitrogen atom or a carbon atom, and when a plurality of E^{11B}, E^{12B}, E^{13B}, E^{14B}, E^{21B}, E^{22B}, E^{23B} and E^{24B} are present, they may be the same or different at each occurrence, and when E^{11B} is a nitrogen atom, R^{11B} is absent, when E^{12B} is a nitrogen atom, R^{12B} is absent, when E^{13B} is a nitrogen atom, R^{13B} is absent, when E^{14B} is a nitrogen atom, R^{14B} is absent, when E^{21B} is a nitrogen atom, R^{21B} is absent, when E^{22B} is a nitrogen atom, R^{22B} is absent, when E^{23B} is a nitrogen atom, R^{23B} is absent, and when E^{24B} is a nitrogen atom, R^{24B} is absent,
R^{11B}, R^{12B}, R^{13B}, R^{14B}, R^{21B}, R^{22B}, R^{23B} and R^{24B} each independently represent a hydrogen atom, an alkyl group, a cycloalkyl group, an alkoxy group, a cycloalkoxy group, an aryl group, an aryloxy group, an alkenyl group, a monovalent heterocyclic group, a substituted amino group or a halogen atom, and the foregoing groups optionally have a substituent, and when a plurality of R^{11B}, R^{12B}, R^{13B}, R^{14B}, R^{21B}, R^{22B}, R^{23B} and R^{24B} are present, they may be the same or different at each occurrence, and, R^{11B} and R^{12B}, R^{12B} and R^{13B}, R^{13B} and R^{14B}, R^{11B} and R^{21B}, R^{21B} and R^{22B}, R^{22B} and R^{23B}, and R^{23B} and R^{24B} may each be combined together to form a ring together with the carbon atoms to which they are attached,
Ring L^{1B} represents a pyridine ring or a diazabenzene ring, and
Ring L^{2B} represents a benzene ring, a pyridine ring or a diazabenzene ring.

12. The light emitting device according to Claim 11, wherein said phosphorescent compound represented by the formula (1-B) is a phosphorescent compound represented by the formula (1-B1), a phosphorescent compound represented by the formula (1-B2), a phosphorescent compound represented by the formula (1-B3), a phosphorescent compound represented by the formula (1-B4) or a phosphorescent compound represented by the formula (1-B5): 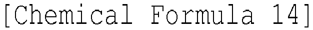 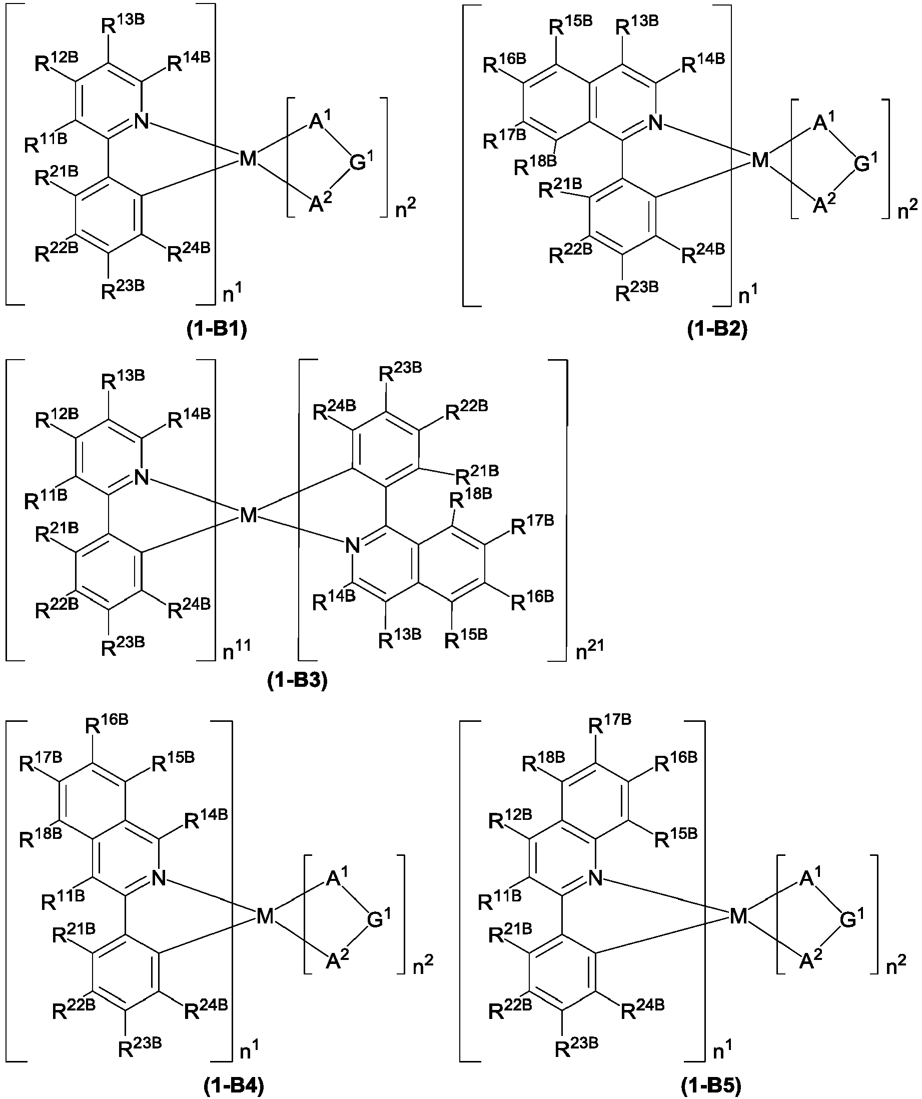 wherein,
M, n¹, n², A¹-G¹-A², R^{11B}, R^{12B}, R^{13B}, R^{14B}, R^{21B}, R^{22B}, R^{23B} and R^{24B} represent the same meaning as described above,
n¹¹ and n²¹ each independently represent an integer of 1 or more, and, n¹¹+n²¹ is 3 when M is a ruthenium atom, a rhodium atom or an iridium atom, while n¹¹+n²¹ is 2 when M is a palladium atom or a platinum atom,
R^{15B}, R^{16B}, R^{17B} and R^{18B} each independently represent a hydrogen atom, an alkyl group, a cycloalkyl group, an alkoxy group, a cycloalkoxy group, an aryl group, an aryloxy group, an alkenyl group, a monovalent heterocyclic group, a substituted amino group or a halogen atom, and the foregoing groups optionally have a substituent, and when a plurality of R^{15B}, R^{16B}, R^{17B} and R^{18B} are present, they may be the same or different at each occurrence, and, R^{13B} and R^{15B}, R^{15B} and R^{16B}, R^{16B} and R^{17B}, R^{17B} and R^{18B}, and R^{18B} and R^{21B} may each be combined together to form a ring together with the atoms to which they are attached.

13. The light emitting device according to any one of Claims 1 to 12, wherein said first organic layer is a layer containing said compound represented by the formula (C-1) and a phosphorescent compound.

14. The light emitting device according to any one of Claims 1 to 13, wherein said first organic layer further contains at least one material selected from the group consisting of a hole transporting material, a hole injection material, an electron transporting material, an electron injection material and a light emitting material.

15. The light emitting device according to any one of Claims 1 to 14, wherein said first organic layer and said second organic layer are adjacent.

16. The light emitting device according to any one of Claims 1 to 15, wherein said second organic layer is a layer disposed between said anode and said first organic layer.
